# EUROPEAN PATENT SPECIFICATION

(11) **EP 2 702 086 B1**
(45) Date of publication and mention of the grant of the patent: **18.03.2015**
(21) Application number: 12716040.6
(22) Date of filing: 24.04.2012
(51) Int. Cl.: C08G 61/12

(54) **SEMICONDUCTOR MATERIALS BASED ON DIKETOPIPERIDINOPIPERIDINE COPOLYMERS**
HALBLEITERMATERIALIEN BASIEREND AUF DIKETOPIPERIDIN-COPOLYMEREN
MATÉRIAUX SEMI-CONDUCTEURS BASÉS SUR DES COPOLYMÈRES DE DICÉTOPIPÉRIDINOPIPÉRIDINE

(30) Priority: 28.04.2011 US 201161479872 P; 28.04.2011 EP 11164088
(43) Date of publication of application: 05.03.2014
(73) Proprietor: BASF SE, 67056 Ludwigshafen (DE)
(72) Inventor: MISHRA, Ashok Kumar, Singapore 140161 (SG); VAIDYANATHAN, Subramanian, CH-4057 Basel (CH); NOGUCHI, Hiroyoshi, Singapore 098830 (SG); DÖTZ, Florian, Singapore 098627 (SG); GUAN, Yucui, Singapore 272003 (SG)
(74) Representative: Bernhardt, Wolfgang Willy-Hans
(86) International application number: PCT/EP2012/057438
(87) International publication number: WO 2012/146574

(56) References cited:
- EP-A2- 2 034 537
- WO-A1-2009/105042
- WO-A1-2009/123695
- WO-A1-2010/108873
- US-A1- 2005 090 640

## Description

Organic semiconducting materials can be used in electronic devices such as organic photovoltaic devices (OPVs), organic field-effect transistors (OFETs), organic light emitting diodes (OLEDs), and organic electrochromic devices (ECDs).

For efficient and long lasting performance, it is desirable that the organic semiconducting material-based devices show high charge carrier mobility as well as high stability, in particular towards oxidation by air, under ambient environmental conditions.

Furthermore, it is desirable that the organic semiconducting materials are compatible with liquid processing techniques such as spin coating as liquid processing techniques are convenient from the point of processability, and thus allow the production of low cost organic semiconducting material-based electronic devices. In addition, liquid processing techniques are also compatible with plastic substrates, and thus allow the production of light weight and mechanically flexible organic semiconducting material-based electronic devices.

The use of organic semiconducting materials is known in the art.

Bao, Z.; Dobadalapur, A.; Lovinger, A. J. Appl. Phys. Lett. 1996, 69, 4108-4110 describes the use of regioregular poly(3-hexylthiophene) in field-effect transistors.

Ong, B. S.; Wu,Y.; Liu, P.; Gardner, S. J. Am. Chem. Soc. 2004, 126, 3378-3379 describes polymers of formula 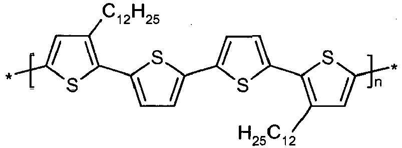 for use in organic field effect transistors (OFETs).

Zhang, M.; Tsao, H. N.; Pisula, W.; Yang, C.; Mishra, A. K.; Müllen, K. J. Am. Chem. Soc. 2007, 129, 3472-3473 describes polymers of formula 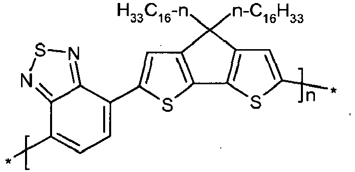 for use in organic field effect transistors (OFETs).

Zou, Y.; Najari, A.; Berrouard, P.; Beaupré, S.; Badrou, R. A.; Tao, Y.; Leclerc, M. J. Am. Chem. Soc. 2010, 132, 5330-5331 describes polymers of formula 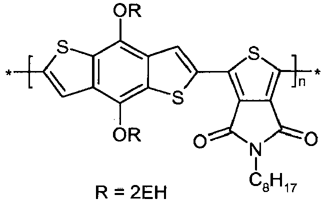 as donor materials for use in photovoltaic devices.

L. Bürgi, M. Turbiez, R. Pfeiffer, F. Bienewald, H.-J. Kirner, C. Winnewisser, Adv. Mater. 2008, 20, 2217-2224 describes polymers of formula 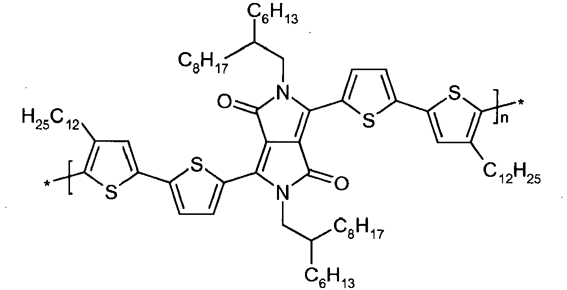 for use in organic field effect transistors (OFETs).

J. C. Bijleveld, A. P. Zoombelt, S. G. J. Mathijssen, M. M. Wienk, M. Turbiez, D. M. de Leeuw, R. A. J. Janssen, J. Am. Chem. Soc. 2009, 131, 16616-16617 describes polymers of formula 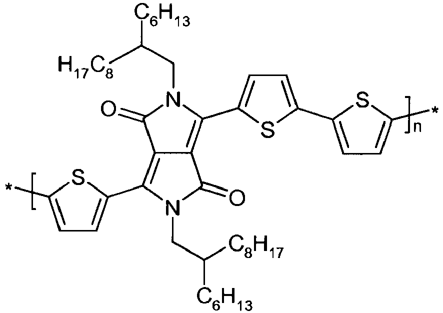 for use in organic field effect transistors (OFETs) and organic photovoltaic devices (OPVs).

N. Saito, T. Yamamoto Macromolecules 1995, 28, 4260-4267 describes polymers of formula 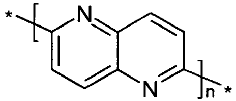 as an electrical conductor.

Diketopiperidinopiperidine derivatives are also known in the art.

E. Bisagni, C. Landras, S. Thirot, C. Huel. Tetrahedron, 1996, 52 (31), 10427-10440 describes the synthesis of compound of formula 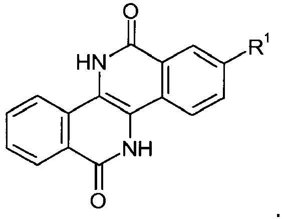 H. Irikawa, N. Adachi Heterocycles 2000, 53 (1), 135-142 describes the synthesis of compound of formula 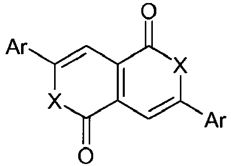
X = NMe, O
Ar = C₆H₅, 2-MeC₆H₄, 2,4,6-Me₃C₆H₂

It was the object of the present invention to provide new organic semiconducting materials.

This object is solved by the polymer of claim 1 and the electronic device of claim 17.

The semiconducting material of the present invention is a polymer comprising a unit of formula 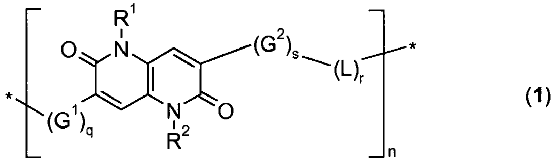 wherein
R¹ and R² are independently from each other H, C₁₋₃₀-alkyl optionally substituted with 1 to 6 substituents R^{c}, C₂₋₃₀-alkenyl optionally substituted with 1 to 6 substituents R^{c}, C₂₋₃₀-alkynyl optionally substituted with 1 to 6 substituents R^{c}, C₃₋₁₀-cycloalkyl optionally substituted with 1 to 6 substituents R^{d}, C₅₋₁₀-cycloalkenyl optionally substituted with 1 to 6 substituents R^{d}, monovalent 3 to 14 membered aliphatic heterocyclic residue optionally substituted with 1 to 6 substituents R^{d}, C₆₋₁₄-aryl optionally substituted with 1 to 6 substituents R^{e} or monovalent 5 to14 membered aromatic heterocyclic residue optionally substituted with 1 to 6 substituents R^{e},
   wherein
   R^{c} at each occurrence are independently from each other selected from the group consisting of =O, =C(CN)₂, -O-C₂₋₆-alkylene-O-, halogen, -CN, -NO₂, -OH, C₁₋₁₀-alkoxy, -O-CH₂CH₂O-C₁₋₁₀-alkyl, -O-COR³, -S-C₁₋₁₀-alkyl, -NH₂, -NHR³, -NR³R⁴, -NH-COR³, -COOH, -COOR³,-CONH₂, -CONHR³, -CONR³R⁴, -CO-H, -COR³, C₃₋₁₀-cycloalkyl, monovalent 3 to 14 membered aliphatic heterocyclic residue, C₆₋₁₄-aryl and monovalent 5 to 14 membered aromatic heterocyclic residue;
   R^{d} at each occurrence are independently from each other selected from the group consisting of =O, =C(CN)₂, -O-C₂₋₆-alkylene-O-, halogen, -CN, -NO₂, -OH, C₁₋₁₀-alkoxy, -O-CH₂CH₂O-C₁₋₁₀-alkyl, -O-COR³, -S-C₁₋₁₀-alkyl, -NH₂, -NHR³, -NR³R⁴, -NH-COR³, -COOH, -COOR³, -CONH₂, -CONHR³, -CONR³R⁴, -CO-H, -COR³, C₁₋₁₀-alkyl, C₂₋₁₀-alkenyl, C₂₋₁₀-alkynyl, C₆₋₁₄-aryl and monovalent 5 to 14 membered aromatic heterocyclic residue;
   R^{e} at each occurrence are independently from each other selected from the group consisting of =O, =C(CN)₂, -O-C₂₋₆-alkylene-O-, halogen, -CN, -NO₂, -OH, C₁₋₁₀-alkoxy, -O-CH₂CH₂O-C₁₋₁₀-alkyl, -O-COR³, -S-C₁₋₁₀-alkyl, -NH₂, -NHR³, -NR³R⁴, -NH-COR³, -COOH, -COOR³,-CONH₂, -CONHR³, -CONR³R⁴, -CO-H, -COR³, C₁₋₁₀-alkyl, C₂₋₁₀-alkenyl, C₂₋₁₀alkynyl, C₃₋₁₀-cycloalkyl, C₅₋₁₀cycloalkenyl and monovalent 3 to 14 membered aliphatic heterocyclic residue,
   wherein R³ and R⁴ at each occurrence are independently from each other selected from the group consisting of C₁₋₁₀-alkyl, C₂₋₁₀-alkenyl, C₂₋₁₀-alkynyl, C₃₋₁₀-cycloalkyl, C₅₋₁₀-cyclo-alkenyl, monovalent 3 to 14 membered aliphatic heterocyclic residue, C₆₋₁₄-aryl and monovalent 5 to 14 membered aromatic heterocyclic residue,
G¹ and G² are independently from each other C₆₋₁₄-arylene optionally substituted with 1 to 6 substituents R^{a} or bivalent 5 to 14 membered aromatic heterocyclic residue optionally substituted with 1 to 6 substituents R^{a},
   wherein
   R^{a} at each occurrence are independently from each other selected from the group consisting of =O, =C(CN)₂, -O-C₂₋₆-alkylene-O-, halogen, -CN, -NO₂, -OH, C₁₋₃₀-alkoxy, -O-CH₂CH₂O-C₁₋₃₀-alkyl, -O-COR⁸, -S-C₁₋₃₀-alkyl, -NH₂, -NHR⁸, -NR⁸R⁹, -NH-COR⁸, -COOH, -COOR⁸, -CONH₂, -CONHR⁸, -CONR⁸R⁹, -CO-H, -COR⁸, C₁₋₃₀-alkyl optionally substituted with 1 to 6 substituents R^{f}, C₂₋₃₀-alkenyl optionally substituted with 1 to 6 substituents R^{f}, C₂₋₃₀-alkynyl optionally substituted with 1 to 6 substituents R^{f}, C₃₋₁₀-cycloalkyl optionally substituted with 1 to 6 substituents R^{g}, C₅₋₁₀-cycloalkenyl optionally substituted with 1 to 6 substituents R^{g} and monovalent 3 to 14 membered aliphatic heterocyclic residue optionally substituted with 1 to 6 substituents R^{g},
   wherein
   R⁸ and R⁹ at each occurrence are independently from each other selected from the group consisting of C₁₋₃₀-alkyl, C₂₋₃₀-alkenyl, C₂₋₃₀-alkynyl, C₃₋₁₀-cycloalkyl, C₅₋₁₀-cycloalkenyl, monovalent 3 to 14 membered aliphatic heterocyclic residue, C₆₋₁₄-aryl and monovalent 5 to14 membered aromatic heterocyclic residue,
   R^{f} at each occurrence are independently from each other selected from the group consisting of =O, =C(CN)₂, -O-C₂₋₆-alkylene-O-, halogen, -CN, -NO₂, -OH, C₁₋₁₀-alkoxy, -O-CH₂CH₂O-C₁₋₁₀-alkyl, -O-COR¹⁰, -S-C₁₋₁₀-alkyl, -NH₂, -NHR¹⁰, -NR¹⁰R¹¹, -NH-COR¹⁰, -COOH, -COOR¹⁰, -CONH₂, -CONHR¹⁰, -CONR¹⁰R¹¹, -CO-H, -COR¹⁰, C₃₋₁₀-cycloalkyl, monovalent 3 to 14 membered aliphatic heterocyclic residue, C₆₋₁₄-aryl and monovalent 5 to 14 membered aromatic heterocyclic residue;
   R^{g} at each occurrence are independently from each other selected from the group consisting of =O, =C(CN)₂, -O-C₂₋₆-alkylene-O-, halogen, -CN, -NO₂, -OH, C₁₋₁₀-alkoxy, -O-CH₂CH₂O-C₁₋₁₀-alkyl, -O-COR¹⁰, -S-C₁₋₁₀-alkyl, -NH₂, -NHR¹⁰, -NR¹⁰R¹¹, -NH-COR¹⁰, -COOH, -COOR¹⁰, -CONH₂, -CONHR¹⁰, -CONR¹⁰R¹¹, -CO-H, -COR¹⁰, C₁₋₁₀-alkyl, C₂₋₁₀-alkenyl, C₂₋₁₀-alkynyl, C₆₋₁₄-aryl and monovalent 5 to 14 membered aromatic heterocyclic residue;
   wherein R¹⁰ and R¹¹ at each occurrence are independently from each other selected from the group consisting of C₁₋₁₀-alkyl, C₂₋₁₀-alkenyl, C₂₋₁₀-alkynyl, C₃₋₁₀-cycloalkyl, C₅₋₁₀-cycloalkenyl, monovalent 3 to 14 membered aliphatic heterocyclic residue, C₆₋₁₄-aryl and monovalent 5 to14 membered aromatic heterocyclic residue,
   or
G¹ and G² are independently from each other 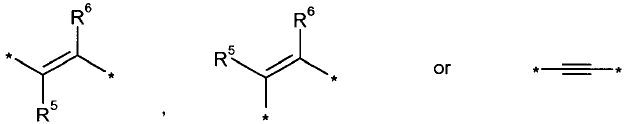 wherein
   R⁵ and R⁶ are independently from each other H or C₁₋₃₀-alkyl,
L is C₆₋₂₄-arylene optionally substituted with 1 to 6 substituents R^{b} or bivalent 5 to 24 membered aromatic heterocyclic residue optionally substituted with 1 to 6 substituents R^{b},
   wherein
   R^{b} at each occurrence are independently from each other selected from the group consisting of =O, =C(CN)₂, -O-C₂₋₆-alkylene-O-, halogen, -CN, -NO₂, -OH, C₁₋₃₀-alkoxy, -O-CH₂CH₂O-C₁₋₃₀-alkyl, -O-COR¹², -S-C₁₋₃₀-alkyl, -NH₂, -NHR¹², -NR¹²R¹³, -NH-COR¹², -COOH, -COOR¹², -CONH₂, -CONHR¹², -CONR¹²R¹³, -CO-H, -COR¹², C₁₋₃₀-alkyl optionally substituted with 1 to 6 substituents R^{h}, C₂₋₃₀-alkenyl optionally substituted with 1 to 6 substituents R^{h}, C₂₋₃₀-alkynyl optionally substituted with 1 to 6 substituents R^{h}, C₃₋₁₀-cycloalkyl optionally substituted with 1 to 6 substituents Rⁱ, C₅₋₁₀-cycloalkenyl optionally substituted with 1 to 6 substituents Rⁱ and monovalent 3 to 14 membered aliphatic heterocyclic residue optionally substituted with 1 to 6 substituents Rⁱ,
   wherein
   R¹² and R¹³ at each occurrence are independently from each other selected from the group consisting of C₁₋₃₀-alkyl, C₂₋₃₀-alkenyl, C₂₋₃₀-alkynyl, C₃₋₁₀-cycloalkyl, C₅₋₁₀-cycloalkenyl, monovalent 3 to 14 membered aliphatic heterocyclic residue, C₆₋₁₄-aryl and monovalent 5 to14 membered aromatic heterocyclic residue,
   R^{h} at each occurrence are independently from each other selected from the group consisting of =O, =C(CN)₂, -O-C₂₋₆-alkylene-O-, halogen, -CN, -NO₂, -OH, C₁₋₁₀-alkoxy, -O-CH₂CH₂O-C₁₋₁₀-alkyl, -O-COR¹⁴, -S-C₁₋₁₀-alkyl, -NH₂, -NHR¹⁴, -NR¹⁴R¹⁵, -NH-COR¹⁴, -COOH, -COOR¹⁴, -CONH₂, -CONHR¹⁴, -CONR¹⁴R¹⁵, -CO-H, -COR¹⁴, C₃₋₁₀-cycloalkyl, monovalent 3 to 14 membered aliphatic heterocyclic residue, C₆₋₁₄-aryl and monovalent 5 to 14 membered aromatic heterocyclic residue;
   Rⁱ at each occurrence are independently from each other selected from the group consisting of =O, =C(CN)₂, -O-C₂₋₆-alkylene-O-, halogen, -CN, -NO₂, -OH, C₁₋₁₀-alkoxy, -O-CH₂CH₂O-C₁₋₁₀-alkyl, -O-COR¹⁴, -S-C₁₋₁₀-alkyl, -NH₂, -NHR¹⁴, -NR¹⁴R¹⁵, -NH-COR¹⁴, -COOH, -COOR¹⁴, -CONH₂, -CONHR¹⁴, -CONR¹⁴R¹⁵, -CO-H, -COR¹⁴, C₁₋₁₀-alkyl, C₂₋₁₀-alkenyl, C₂₋₁₀-alkynyl, C₆₋₁₄-aryl and monovalent 5 to 14 membered aromatic heterocyclic residue;
   wherein R¹⁴ and R¹⁵ at each occurrence are independently from each other selected from the group consisting of C₁₋₁₀-alkyl, C₂₋₁₀-alkenyl, C₂₋₁₀-alkynyl, C₃₋₁₀-cycloalkyl, C₅₋₁₀-cycloalkenyl, monovalent 3 to 14 membered aliphatic heterocyclic residue, C₆₋₁₄-aryl and monovalent 5 to14 membered aromatic heterocyclic residue,
   or
L is 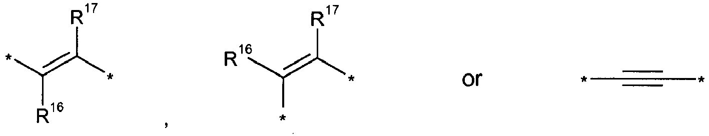 wherein
   R¹⁶ and R¹⁷ are independently from each other H, C₁₋₃₀-alkyl, -CN or halogen,
q and s are independently from each other 0, 1, 2, 3, 4 or 5,
r is 0, 1 or 2,
   and
n is an integer from 2 to 10'000.

Preferably, the semiconducting material of the present invention is a polymer consisting essentially of a unit of formula 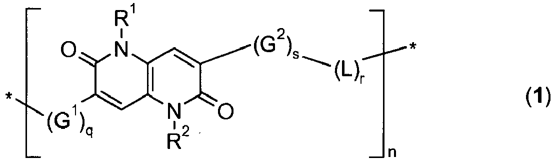 wherein
R¹ and R² are independently from each other H, C₁₋₃₀-alkyl optionally substituted with 1 to 6 substituents R^{c}, C₂₋₃₀-alkenyl optionally substituted with 1 to 6 substituents R^{c}, C₂₋₃₀-alkynyl optionally substituted with 1 to 6 substituents R^{c}, C₃₋₁₀-cycloalkyloptionally substituted with 1 to 6 substituents R^{d}, C₅₋₁₀-cycloalkenyl optionally substituted with 1 to 6 substituents R^{d}, monovalent 3 to 14 membered aliphatic heterocyclic residue optionally substituted with 1 to 6 substituents R^{d}, C₆₋₁₄-aryl optionally substituted with 1 to 6 substituents R^{e} or monovalent 5 to14 membered aromatic heterocyclic residue optionally substituted with 1 to 6 substituents R^{e},
   wherein
   R^{c} at each occurrence are independently from each other selected from the group consisting of =O, =C(CN)₂, -O-C₂₋₆-alkylene-O-, halogen, -CN, -NO₂, -OH, C₁₋₁₀-alkoxy, -O-CH₂CH₂O-C₁₋₁₀-alkyl, -O-COR³, -S-C₁₋₁₀-alkyl, -NH₂, -NHR³, -NR³R⁴, -NH-COR³, -COOH, -COOR³,-CONH₂, -CONHR³, -CONR³R⁴, -CO-H, -COR³, C₃₋₁₀-cycloalkyl, monovalent 3 to 14 membered aliphatic heterocyclic residue, C₆₋₁₄-aryl and monovalent 5 to 14 membered aromatic heterocyclic residue;
   R^{d} at each occurrence are independently from each other selected from the group consisting of =O, =C(CN)₂, -O-C₂₋₆-alkylene-O-, halogen, -CN, -NO₂, -OH, C₁₋₁₀-alkoxy, -O-CH₂CH₂O-C₁₋₁₀-alkyl, -O-COR³, -S-C₁₋₁₀-alkyl, -NH₂, -NHR³, -NR³R⁴, -NH-COR³, -COOH, -COOR³, -CONH₂, -CONHR³, -CONR³R⁴, -CO-H, -COR³, C₁₋₁₀-alkyl, C₂₋₁₀-alkenyl, C₂₋₁₀-alkynyl, C₆₋₁₄-aryl and monovalent 5 to 14 membered aromatic heterocyclic residue;
   Re at each occurrence are independently from each other selected from the group consisting of =O, =C(CN)₂, -O-C₂₋₆-alkylene-O-, halogen, -CN, -NO₂, -OH, C₁₋₁₀-alkoxy, -O-CH₂CH₂O-C₁₋₁₀-alkyl, -O-COR³, -S-C₁₋₁₀-alkyl, -NH₂, -NHR³, -NR³R⁴, -NH-COR³, -COOH, -COOR³,-CONH₂, -CONHR³, -CONR³R⁴, -CO-H, -COR³, C₁₋₁₀-alkyl, C₂₋₁₀-alkenyl, C₂₋₁₀-alkynyl, C₃₋₁₀-cycloalkyl, C₅₋₁₀-cycloalkenyl and monovalent 3 to 14 membered aliphatic heterocyclic residue,
   wherein R³ and R⁴ at each occurrence are independently from each other selected from the group consisting of C₁₋₁₀-alkyl, C₂₋₁₀-alkenyl, C₂₋₁₀-alkynyl, C₃₋₁₀-cycloalkyl, C₅₋₁₀-cycloalkenyl, monovalent 3 to 14 membered aliphatic heterocyclic residue, C₆₋₁₄-aryl and monovalent 5 to 14 membered aromatic heterocyclic residue,
G¹ and G² are independently from each other C₆₋₁₄-arylene optionally substituted with 1 to 6 substituents R^{a} or bivalent 5 to 14 membered aromatic heterocyclic residue optionally substituted with 1 to 6 substituents R^{a},
   wherein
   R^{a} at each occurrence are independently from each other selected from the group consisting of =O, =C(CN)₂, -O-C₂₋₆-alkylene-O-, halogen, -CN, -NO₂, -OH, C₁₋₃₀-alkoxy, -O-CH₂CH₂O-C₁₋₃₀-alkyl, -O-COR⁸, -S-C₁₋₃₀-alkyl, -NH₂, -NHR⁸, -NR⁸R⁹, -NH-COR⁸, -COOH, -COOR⁸, -CONH₂, -CONHR⁸, -CONR⁸R⁹, -CO-H, -COR⁸, C₁₋₃₀-alkyl optionally substituted with 1 to 6 substituents R^{f}, C₂₋₃₀-alkenyl optionally substituted with 1 to 6 substituents R^{f}, C₂₋₃₀-alkynyl optionally substituted with 1 to 6 substituents R^{f}, C₃₋₁₀-cycloalkyl optionally substituted with 1 to 6 substituents R^{g}, C₅₋₁₀-cycloalkenyl optionally substituted with 1 to 6 substituents R^{g} and monovalent 3 to 14 membered aliphatic heterocyclic residue optionally substituted with 1 to 6 substituents R^{g},
   wherein
   R⁸ and R⁹ at each occurrence are independently from each other selected from the group consisting of C₁₋₃₀-alkyl, C₂₋₃₀-alkenyl, C₂₋₃₀-alkynyl, C₃₋₁₀-cycloalkyl, C₅₋₁₀-cycloalkenyl, monovalent 3 to 14 membered aliphatic heterocyclic residue, C₆₋₁₄-aryl and monovalent 5 to14 membered aromatic heterocyclic residue,
   R^{f} at each occurrence are independently from each other selected from the group consisting of =O, =C(CN)₂, -O-C₂₋₆-alkylene-O-, halogen, -CN, -NO₂, -OH, C₁₋₁₀-alkoxy, -O-CH₂CH₂O-C₁₋₁₀-alkyl, -O-COR¹⁰, -S-C₁₋₁₀-alkyl, -NH₂, -NHR¹⁰, -NR¹⁰R¹¹, -NH-COR¹⁰, -COOH, -COOR¹⁰, -CONH₂, -CONHR¹⁰, -CONR¹⁰R¹¹, -CO-H, -COR¹⁰, C₃₋₁₀-cycloalkyl, monovalent 3 to 14 membered aliphatic heterocyclic residue, C₆₋₁₄-aryl and monovalent 5 to 14 membered aromatic heterocyclic residue;
   R^{g} at each occurrence are independently from each other selected from the group consisting of =O, =C(CN)₂, -O-C₂₋₆-alkylene-O-, halogen, -CN, -NO₂, -OH, C₁₋₁₀-alkoxy, -O-CH₂CH₂O-C₁₋₁₀-alkyl, -O-COR¹⁰, -S-C₁₋₁₀-alkyl, -NH₂, -NHR¹⁰, -NR¹⁰R¹¹, -NH-COR¹⁰, -COOH, -COOR¹⁰, -CONH₂, -CONHR¹⁰, -CONR¹⁰R¹¹, -CO-H, -COR¹², C₁₋₁₀-alkyl, C₂₋₁₀-alkenyl, C₂₋₁₀-alkynyl, C₆₋₁₄-aryl and monovalent 5 to 14 membered aromatic heterocyclic residue;
   wherein R¹⁰ and R¹¹ at each occurrence are independently from each other selected from the group consisting of C₁₋₁₀-alkyl, C₂₋₁₀-alkenyl, C₂₋₁₀-alkynyl, C₃₋₁₀-cycloalkyl, C₅₋₁₀-cycloalkenyl, monovalent 3 to 14 membered aliphatic heterocyclic residue, C₆₋₁₄-aryl and monovalent 5 to14 membered aromatic heterocyclic residue,
   or
G¹ and G² are independently from each other 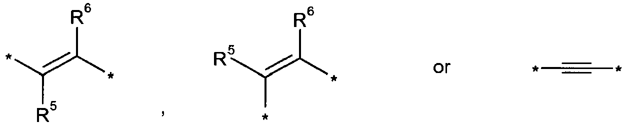 wherein
   R⁵ and R⁶ are independently from each other H or C₁₋₃₀-alkyl,
L is C₆₋₂₄-arylene optionally substituted with 1 to 6 substituents R^{b} or bivalent 5 to 24 membered aromatic heterocyclic residue optionally substituted with 1 to 6 substituents R^{b},
   wherein
   R^{b} at each occurrence are independently from each other selected from the group consisting of =O, =C(CN)₂, -O-C₂₋₆-alkylene-O-, halogen, -CN, -NO₂, -OH, C₁₋₃₀-alkoxy, -O-CH₂CH₂O-C₁₋₃₀-alkyl, -O-COR¹², -S-C₁₋₃₀-alkyl, -NH₂, -NHR¹², -NR¹²R¹³, -NH-COR¹², -COOH, -COOR¹², -CONH₂, -CONHR¹², -CONR¹²R¹³, -CO-H, -COR¹², C₁₋₃₀-alkyl optionally substituted with 1 to 6 substituents R^{h}, C₂₋₃₀-alkenyl optionally substituted with 1 to 6 substituents R^{h}, C₂₋₃₀-alkynyl optionally substituted with 1 to 6 substituents R^{h}, C₃₋₁₀-cycloalkyl optionally substituted with 1 to 6 substituents Rⁱ, C₅₋₁₀-cycloalkenyl optionally substituted with 1 to 6 substituents Rⁱ and monovalent 3 to 14 membered aliphatic heterocyclic residue optionally substituted with 1 to 6 substituents Rⁱ,
   wherein
   R¹² and R¹³ at each occurrence are independently from each other selected from the group consisting of C₁₋₃₀-alkyl, C₂₋₃₀-alkenyl, C₂₋₃₀-alkynyl, C₃₋₁₀-cycloalkyl, C₅₋₁₀-cycloalkenyl, monovalent 3 to 14 membered aliphatic heterocyclic residue, C₆₋₁₄-aryl and monovalent 5 to14 membered aromatic heterocyclic residue,
   R^{h} at each occurrence are independently from each other selected from the group consisting of =O, =C(CN)₂, -O-C₂₋₆-alkylene-O-, halogen, -CN, -NO₂, -OH, C₁₋₁₀-alkoxy, -O-CH₂CH₂O-C₁₋₁₀-alkyl, -O-COR¹⁴, -S-C₁₋₁₀-alkyl, -NH₂, -NHR¹⁴, -NR¹⁴R¹⁵, -NH-COR¹⁴, -COOH, -COOR¹⁴, -CONH₂, -CONHR¹⁴, -CONR¹⁴R¹⁵, -CO-H, -COR¹⁴, C₃₋₁₀-cycloalkyl, monovalent 3 to 14 membered aliphatic heterocyclic residue, C₆₋₁₄-aryl and monovalent 5 to 14 membered aromatic heterocyclic residue;
   Rⁱ at each occurrence are independently from each other selected from the group consisting of =O, =C(CN)₂, -O-C₂₋₆-alkylene-O-, halogen, -CN, -NO₂, -OH, C₁₋₁₀-alkoxy, -O-CH₂CH₂O-C₁₋₁₀-alkyl, -O-COR¹⁴, -S-C₁₋₁₀-alkyl, -NH₂, -NHR¹⁴, -NR¹⁴R¹⁵, -NH-COR¹⁴, -COOH, -COOR¹⁴, -CONH₂, -CONHR¹⁴, -CONR¹⁴R¹⁵, -CO-H, -COR¹⁴, C₁₋₁₀-alkyl, C₂₋₁₀-alkenyl, C₂₋₁₀-alkynyl, C₆₋₁₄-aryl and monovalent 5 to 14 membered aromatic heterocyclic residue;
   wherein R¹⁴ and R¹⁵ at each occurrence are independently from each other selected from the group consisting of C₁₋₁₀-alkyl, C₂₋₁₀-alkenyl, C₂₋₁₀-alkynyl, C₃₋₁₀-cycloalkyl, C₅₋₁₀-cycloalkenyl, monovalent 3 to 14 membered aliphatic heterocyclic residue, C₆₋₁₄-aryl and monovalent 5 to14 membered aromatic heterocyclic residue,
   or
L is 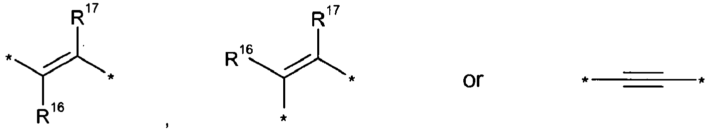 wherein
   R¹⁶ and R¹⁷ are independently from each other H, C₁₋₃₀-alkyl, -CN or halogen,
q and s are independently from each other 0, 1, 2, 3, 4 or 5,
r is 0, 1 or 2,
   and
n is an integer from 2 to 10'000.

The term "consisting essentially of" means that at least 80% by weight. Preferably at least 90% by weight, of the polymer consists of a unit of formula (1) based on the weight of the polymer.

More preferably, the semiconducting material of the present invention is a polymer of formula 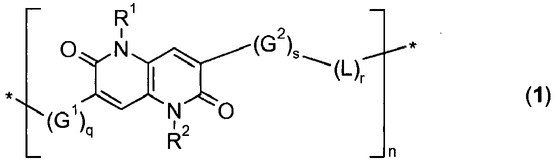 wherein
R¹ and R² are independently from each other H, C₁₋₃₀-alkyl optionally substituted with 1 to 6 substituents R^{c}, C₂₋₃₀-alkenyl optionally substituted with 1 to 6 substituents R^{c}, C₂₋₃₀-alkynyl optionally substituted with 1 to 6 substituents R^{c}, C₃₋₁₀-cycloalkyloptionally substituted with 1 to 6 substituents R^{d}, C₅₋₁₀-cycloalkenyl optionally substituted with 1 to 6 substituents R^{d}, monovalent 3 to 14 membered aliphatic heterocyclic residue optionally substituted with 1 to 6 substituents R^{d}, C₆₋₁₄-aryl optionally substituted with 1 to 6 substituents R^{e} or monovalent 5 to14 membered aromatic heterocyclic residue optionally substituted with 1 to 6 substituents R^{e},
   wherein
   R^{c} at each occurrence are independently from each other selected from the group consisting of =O, =C(CN)₂, -O-C₂₋₆-alkylene-O-, halogen, -CN, -NO₂, -OH, C₁₋₁₀-alkoxy, -O-CH₂CH₂O-C₁₋₁₀-alkyl, -O-COR³, -S-C₁₋₁₀-alkyl, -NH₂, -NHR³, -NR³R⁴, -NH-COR³, -COOH, -COOR³,-CONH₂, -CONHR³, -CONR³R⁴, -CO-H, -COR³, C₃₋₁₀-cycloalkyl, monovalent 3 to 14 membered aliphatic heterocyclic residue, C₆₋₁₄-aryl and monovalent 5 to 14 membered aromatic heterocyclic residue;
   R^{d} at each occurrence are independently from each other selected from the group consisting of =O, =C(CN)₂, -O-C₂₋₆-alkylene-O-, halogen, -CN, -NO₂, -OH, C₁₋₁₀-alkoxy, -O-CH₂CH₂O-C₁₋₁₀-alkyl, -O-COR³, -S-C₁₋₁₀-alkyl, -NH₂, -NHR³, -NR³R⁴, -NH-COR³, -COOH, -COOR³, -CONH₂, -CONHR³, -CONR³R⁴, -CO-H, -COR³, C₁₋₁₀-alkyl, C₂₋₁₀-alkenyl, C₂₋₁₀-alkynyl, C₆₋₁₄-aryl and monovalent 5 to 14 membered aromatic heterocyclic residue;
   R^{e} at each occurrence are independently from each other selected from the group consisting of =O, =C(CN)₂, -O-C₂₋₆-alkylene-O-, halogen, -CN, -NO₂, -OH, C₁₋₁₀-alkoxy, -O-CH₂CH₂O-C₁₋₁₀-alkyl, -O-COR³, -S-C₁₋₁₀-alkyl, -NH₂, -NHR³, -NR³R⁴, -NH-COR³, -COOH, -COOR³,-CONH₂, -CONHR³, -CONR³R⁴, -CO-H, -COR³, C₁₋₁₀-alkyl, C₂₋₁₀-alkenyl, C₂₋₁₀-alkynyl, C₃₋₁₀-cycloalkyl, C₅₋₁₀-cycloalkenyl and monovalent 3 to 14 membered aliphatic heterocyclic residue,
   wherein R³ and R⁴ at each occurrence are independently from each other selected from the group consisting of C₁₋₁₀-alkyl, C₂₋₁₀-alkenyl, C₂₋₁₀-alkynyl, C₃₋₁₀-cycloalkyl, C₅₋₁₀-cycloalkenyl, monovalent 3 to 14 membered aliphatic heterocyclic residue, C₆₋₁₄-aryl and monovalent 5 to 14 membered aromatic heterocyclic residue,
G¹ and G² are independently from each other C₆₋₁₄-arylene optionally substituted with 1 to 6 substituents R^{a} or bivalent 5 to 14 membered aromatic heterocyclic residue optionally substituted with 1 to 6 substituents R^{a},
   wherein
   R^{a} at each occurrence are independently from each other selected from the group consisting of =O, =C(CN)₂, -O-C₂₋₆-alkylene-O-, halogen, -CN, -NO₂, -OH, C₁₋₃₀-alkoxy, -O-CH₂CH₂O-C₁₋₃₀-alkyl, -O-COR⁸, -S-C₁₋₃₀-alkyl, -NH₂, -NHR⁸, -NR⁸R⁹, -NH-COR⁸, -COOH, -COOR⁸, -CONH₂, -CONHR⁸, -CONR⁸R⁹, -CO-H, -COR⁸, C₁₋₃₀-alkyl optionally substituted with 1 to 6 substituents R^{f}, C₂₋₃₀-alkenyl optionally substituted with 1 to 6 substituents R^{f}, C₂₋₃₀-alkynyl optionally substituted with 1 to 6 substituents R^{f}, C₃₋₁₀-cycloalkyl optionally substituted with 1 to 6 substituents R^{g}, C₅₋₁₀-cycloalkenyl optionally substituted with 1 to 6 substituents R^{g} and monovalent 3 to 14 membered aliphatic heterocyclic residue optionally substituted with 1 to 6 substituents R^{g},
   wherein
   R⁸ and R⁹ at each occurrence are independently from each other selected from the group consisting of C₁₋₃₀-alkyl, C₂₋₃₀-alkenyl, C₂₋₃₀-alkynyl, C₃₋₁₀-cycloalkyl, C₅₋₁₀-cycloalkenyl, monovalent 3 to 14 membered aliphatic heterocyclic residue, C₆₋₁₄-aryl and monovalent 5 to14 membered aromatic heterocyclic residue,
   R^{f} at each occurrence are independently from each other selected from the group consisting of =O, =C(CN)₂, -O-C₂₋₆-alkylene-O-, halogen, -CN, -NO₂, -OH, C₁₋₁₀-alkoxy, -O-CH₂CH₂O-C₁₋₁₀-alkyl, -O-COR¹⁰, -S-C₁₋₁₀-alkyl, -NH₂, -NHR¹⁰, -NR¹⁰R¹¹, -NH-COR¹⁰, -COOH, -COOR¹⁰, -CONH₂, -CONHR¹⁰, -CONR¹⁰R¹¹, -CO-H, -COR¹⁰, C₃₋₁₀-cycloalkyl, monovalent 3 to 14 membered aliphatic heterocyclic residue, C₆₋₁₄-aryl and monovalent 5 to 14 membered aromatic heterocyclic residue;
   R^{g} at each occurrence are independently from each other selected from the group consisting of =O, =C(CN)₂, -O-C₂₋₆-alkylene-O-, halogen, -CN, -NO₂, -OH, C₁₋₁₀-alkoxy, -O-CH₂CH₂O-C₁₋₁₀-alkyl, -O-COR¹⁰, -S-C₁₋₁₀-alkyl, -NH₂, -NHR¹⁰, -NR¹⁰R¹¹, -NH-COR¹⁰, -COOH, -COOR¹⁰, -CONH₂, -CONHR¹⁰, -CONR¹⁰R¹¹, -CO-H, -COR¹², C₁₋₁₀-alkyl, C₂₋₁₀-alkenyl, C₂₋₁₀-alkynyl, C₆₋₁₄-aryl and monovalent 5 to 14 membered aromatic heterocyclic residue;
   wherein R¹⁰ and R¹¹ at each occurrence are independently from each other selected from the group consisting of C₁₋₁₀-alkyl, C₂₋₁₀-alkenyl, C₂₋₁₀-alkynyl, C₃₋₁₀-cycloalkyl, C₅₋₁₀-cycloalkenyl, monovalent 3 to 14 membered aliphatic heterocyclic residue, C₆₋₁₄-aryl and monovalent 5 to14 membered aromatic heterocyclic residue,
   or
G¹ and G² are independently from each other 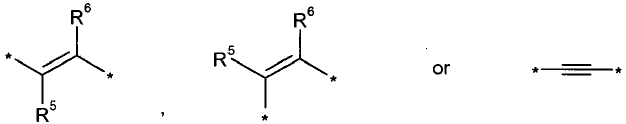 wherein
   R⁵ and R⁶ are independently from each other H or C₁₋₃₀-alkyl,
L is C₆₋₂₄-arylene optionally substituted with 1 to 6 substituents R^{b} or bivalent 5 to 24 membered aromatic heterocyclic residue optionally substituted with 1 to 6 substituents R^{b},
   wherein
   R^{b} at each occurrence are independently from each other selected from the group consisting of =O, =C(CN)₂, -O-C₂₋₆-alkylene-O-, halogen, -CN, -NO₂, -OH, C₁₋₃₀-alkoxy, -O-CH₂CH₂O-C₁₋₃₀-alkyl, -O-COR¹², -S-C₁₋₃₀-alkyl, -NH₂, -NHR¹², -NR¹²R¹³, -NH-COR¹², -COOH, -COOR¹², -CONH₂, -CONHR¹², -CONR¹²R¹³, -CO-H, -COR¹², C₁₋₃₀-alkyl optionally substituted with 1 to 6 substituents R^{h}, C₂₋₃₀-alkenyl optionally substituted with 1 to 6 substituents R^{h}, C₂₋₃₀-alkynyl optionally substituted with 1 to 6 substituents R^{h}, C₃₋₁₀-cycloalkyl optionally substituted with 1 to 6 substituents Rⁱ, C₅₋₁₀-cycloalkenyl optionally substituted with 1 to 6 substituents Rⁱ and monovalent 3 to 14 membered aliphatic heterocyclic residue optionally substituted with 1 to 6 substituents Rⁱ,
   wherein
   R¹² and R¹³ at each occurrence are independently from each other selected from the group consisting of C₁₋₃₀-alkyl, C₂₋₃₀-alkenyl, C₂₋₃₀-alkynyl, C₃₋₁₀-cycloalkyl, C₅₋₁₀-cyclo-alkenyl, monovalent 3 to 14 membered aliphatic heterocyclic residue, C₆₋₁₄-aryl and monovalent 5 to14 membered aromatic heterocyclic residue,
   R^{h} at each occurrence are independently from each other selected from the group consisting of =O, =C(CN)₂, -O-C₂₋₆-alkylene-O-, halogen, -CN, -NO₂, -OH, C₁₋₁₀-alkoxy, -O-CH₂CH₂O-C₁₋₁₀-alkyl, -O-COR¹⁴, -S-C₁₋₁₀-alkyl, -NH₂, -NHR¹⁴, -NR¹⁴R¹⁵, -NH-COR¹⁴, -COOH, -COOR¹⁴, -CONH₂, -CONHR¹⁴, -CONR¹⁴R¹⁵, -CO-H, -COR¹⁴, C₃₋₁₀-cycloalkyl, monovalent 3 to 14 membered aliphatic heterocyclic residue, C₆₋₁₄-aryl and monovalent 5 to 14 membered aromatic heterocyclic residue;
   Rⁱ at each occurrence are independently from each other selected from the group consisting of =O, =C(CN)₂, -O-C₂₋₆-alkylene-O-, halogen, -CN, -NO₂, -OH, C₁₋₁₀-alkoxy, -O-CH₂CH₂O-C₁₋₁₀-alkyl, -O-COR¹⁴, -S-C₁₋₁₀-alkyl, -NH₂, -NHR¹⁴, -NR¹⁴R¹⁵, -NH-COR¹⁴, -COOH, -COOR¹⁴, -CONH₂, -CONHR¹⁴, -CONR¹⁴R¹⁵, -CO-H, -COR¹⁴, C₁₋₁₀-alkyl, C₂₋₁₀-alkenyl, C₂₋₁₀-alkynyl, C₆₋₁₄-aryl and monovalent 5 to 14 membered aromatic heterocyclic residue;
   wherein R¹⁴ and R¹⁵ at each occurrence are independently from each other selected from the group consisting of C₁₋₁₀-alkyl, C₂₋₁₀-alkenyl, C₂₋₁₀-alkynyl, C₃₋₁₀-cycloalkyl, C₅₋₁₀-cycloalkenyl, monovalent 3 to 14 membered aliphatic heterocyclic residue, C₆₋₁₄-aryl and monovalent 5 to14 membered aromatic heterocyclic residue,
   or
L is 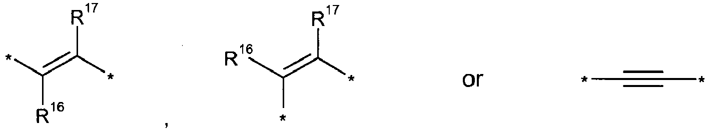 wherein
   R¹⁶ and R¹⁷ are independently from each other H, C₁₋₃₀-alkyl, -CN or halogen,
q and s are independently from each other 0, 1, 2, 3, 4 or 5,
r is 0, 1 or 2,
   and
n is an integer from 2 to 10'000.

C₁₋₁₂-alkyl, C₁₋₁₆-alkyl, C₆₋₂₀-alkyl and C₁₋₃₀-alkyl can be branched or unbranched. Examples of C₁₋₁₂-alkyl are C₁₋₁₀-alkyl and *n*-undecyl and *n*-dodecyl. Examples of C₁₋₁₆-alkyl are C₁₋₁₂-alkyl and n-tridecyl, *n*-tetradecyl, *n*-pentadecyl and *n*-hexadecyl. Examples of C₁₋₃₀-alkyl are C₁₋₁₀-alkyl, and *n*-undecyl, *n*-dodecyl, *n*-tridecyl, n-tetradecyl, n-pentadecyl, *n*-hexadecyl, n-heptadecyl, *n*-octadecyl, *n*-nonadecyl and *n*-icosyl (C₂₀), *n*-docosyl (C₂₂), *n*-tetracosyl (C₂₄), *n*-hexacosyl (C₂₆), *n*-octacosyl (C₂₈) and n-triacontyl (C₃₀). Examples of C₆₋₂₀-alkyl are n-hexyl, n-heptyl, *n*-octyl, *n*-(2-ethyl)hexyl, n-nonyl, *n*-decyl, *n*-undecyl, *n*-dodecyl, *n*-undecyl, *n*-dodecyl, n-tridecyl, n-tetradecyl, *n*-pentadecyl, *n*-hexadecyl, n-heptadecyl, *n*-octadecyl, *n*-nonadecyl and *n*-icosyl (C₂₀)

C₂₋₁₀-alkenyl and C₂₋₃₀-alkenyl can be branched or unbranched. Examples of C₂₋₁₀-alkenyl are vinyl, propenyl, *cis*-2-butenyl, trans-2-butenyl, 3-butenyl, *cis*-2-pentenyl, *trans*-2-pentenyl, *cis*-3-pentenyl, *trans*-3-pentenyl, 4-pentenyl, 2-methyl-3-butenyl, hexenyl, heptenyl, octenyl, nonenyl and docenyl. Examples of C₂₋₃₀-alkenyl are C₂₋₁₀-alkenyl, and linoleyl (C₁₈), linolenyl (C₁₈), oleyl (C₁₈), arachidonyl (C₂₀), and erucyl (C₂₂).

C₂₋₁₀-alkynyl and C₂₋₃₀-alkynyl can be branched or unbranched. Examples of C₂₋₁₀-alkynyl are ethynyl, 2-propynyl, 2-butynyl, 3-butynyl, pentynyl, hexynyl, heptynyl, octynyl, nonynyl and decynyl. Examples of C₂₋₃₀-alkynyl are C₂₋₁₀-alkynyl, and undecynyl, dodecynyl, undecynyl, dodecynyl, tridecynyl, tetradecynyl, pentadecynyl, hexadecynyl, heptadecynyl, octadecynyl, nonadecynyl and icosynyl (C₂₀).

Examples of C₃₋₁₀-cycloalkyl are preferably monocyclic C₃₋₁₀-cycloalkyls such as cyclopropyl, cyclobutyl, cyclopentyl, cyclohexyl, cycloheptyl and cyclooctyl, but include also polycyclic C₃₋₁₀-cycloalkyls such as decalinyl, norbornyl and adamantyl.

Examples of C₅₋₁₀-cycloalkenyl are preferably monocyclic C₅₋₁₀-cycloalkenyls such as cyclopentenyl, cyclohexenyl, cyclohexadienyl and cycloheptatrienyl, but include also polycyclic C₅₋₁₀-cycloalkenyls.

Examples of monovalent 3 to 14 membered aliphatic heterocyclic residues are monocyclic monovalent 3 to 8 membered aliphatic cyclic residues and polycyclic, for example bicyclic monovalent 7 to 12 membered aliphatic heterocyclic residues.

Examples of monocyclic monovalent 3 to 8 membered aliphatic heterocyclic residues are mon-ocyclic monovalent 5 membered aliphatic heterocyclic residues containing one heteroatom such as pyrrolidinyl, 1-pyrrolinyl, 2-pyrrolinyl, 3-pyrrolinyl, tetrahydrofuryl, 2,3-dihydrofuryl, tetrahydrothiophenyl and 2,3-dihydrothiophenyl, monocyclic monovalent 5 membered aliphatic heterocyclic residues containing two heteroatoms such as imidazolidinyl, imidazolinyl, pyrazolidinyl, pyrazolinyl, oxazolidinyl, oxazolinyl, isoxazolidinyl, isoxazolinyl, thiazolidinyl, thiazolinyl, isothiazolidinyl and isothiazolinyl, monocyclic monovalent 5 membered aliphatic heterocyclic residues containing three heteroatoms such as 1,2,3-triazolyl, 1,2,4-triazolyl and 1,4,2-dithiazolyl, monocyclic monovalent 6 membered aliphatic heterocyclic residues containing one heteroatom such as piperidyl, piperidino, tetrahydropyranyl, pyranyl, thianyl and thiopyranyl, monocyclic monovalent 6 membered aliphatic heterocyclic residues containing two heteroatoms such as piperazinyl, morpholinyl and morpholino and thiazinyl, monocyclic monovalent 7 membered aliphatic heterocyclic residues containing one hereoatom such as azepanyl, azepinyl, oxepanyl, thiepanyl, thiapanyl, thiepinyl, and monocyclic monovalent 7 membered aliphatic heterocyclic residues containing two hereoatom such as 1,2-diazepinyl and 1,3-thiazepinyl.

An example of a bicyclic monovalent 7-12 membered aliphatic heterocyclic residue is decahydronaphthyl.

C₆₋₁₄-aryl can be monocyclic or polycyclic. Examples of C₆₋₁₄-aryl are monocyclic C₆-aryl such as phenyl, bicyclic C₉₋₁₀-aryl such as 1-naphthyl, 2-naphthyl, indenyl, indanyl and tetrahydronaphthyl, and tricyclic C₁₂₋₁₄-aryl such as anthryl, phenanthryl, fluorenyl and *s*-indacenyl.

The monovalent 5 to 14 membered aromatic heterocyclic residues can be monocyclic monovalent 5 to 8 membered aromatic heterocyclic residues, or polycyclic, for example bicyclic monovalent 7 to 12 membered, tricyclic monovalent 9 to 14 membered aromatic heterocyclic residue, or tetracyclic monovalent 9 to 14 membered aromatic heterocyclic residues.

Examples of monocyclic monovalent 5 to 8 membered aromatic heterocyclic residues are monocyclic monovalent 5 membered aromatic heterocyclic residues containing one heteroatom such as pyrrolyl, furyl and thiophenyl, monocyclic monovalent 5 membered aromatic heterocyclic residues containing two heteroatoms such as imidazolyl, pyrazolyl, oxazolyl, isoxazolyl, thiazolyl, isothiazolyl, monocyclic monovalent 5 membered aromatic heterocyclic residues containing three heteroatoms such as 1,2,3-triazolyl, 1,2,4-triazolyl and oxadiazolyl, monocyclic monovalent 5 membered aromatic heterocyclic residues containing four heteroatoms such as tetrazolyl, monocyclic monovalent 6 membered aromatic heterocyclic residues containing one heteroatom such as pyridyl, monocyclic monovalent 6 membered aromatic heterocyclic residues containing two heteroatoms such as pyrazinyl, pyrimidinyl and pyridazinyl, monocyclic monovalent 6 membered aromatic heterocyclic residues containing three heteroatoms such as 1,2,3-triazinyl, 1,2,4-triazinyl and 1,3,5-triazinyl, monocyclic monovalent 7 membered aromatic heterocyclic residues containing one heteroatom such as azepinyl, and monocyclic monovalent 7 membered aromatic heterocyclic residues containing two heteroatoms such as 1,2-diazepinyl,

Examples of bicyclic monovalent 7 to 12 membered aromatic heterocyclic residues are bicyclic monovalent 8 membered aromatic heterocyclic residues containing two heteroatoms such as thieno[3,2-b]thiophenyl, bicyclic 9 membered aromatic heterocyclic residues containing one heteroatom such as indolyl, isoindolyl, indolizinyl, indolinyl, benzofuryl, isobenzofuryl, benzothiophenyl and isobenzothiophenyl, bicyclic monovalent 9 membered aromatic heterocyclic residues containing two heteroatoms such as indazolyl, benzimidazolyl, benzimidazolinyl, benzoxazolyl, benzisooxazolyl, benzthiazolyl, benzisothiazolyl, furopyridyl and thienopyridyl, bicyclic monovalent 9 membered aromatic heterocyclic residues containing three heteroatoms such as benzotriazolyl, benzoxadiazolyl, oxazolopyridyl, isooxazolopyridyl, thiazolopyridyl, isothiazolopyridyl and imidazopyridyl, bicyclic monovalent 9 membered aromatic heterocyclic residues containing four heteroatoms such as purinyl, bicyclic monovalent 10 membered aromatic heterocyclic residues containing one heteroatom such as quinolyl, isoquinolyl, chromenyl and chromanyl, bicyclic monovalent 10 membered aromatic heterocyclic residues containing two heteroatoms such as quinoxalinyl, quinazolinyl, cinnolinyl, phthalazinyl, 1,5-naphthyridinyl and 1,8-naphthyridinyl, bicyclic monovalent 10 membered aromatic heterocyclic residues containing three heteroatoms such as pyridopyrazinyl, pyridopyrimidinyl and pyridopyridazinyl, and bicyclic monovalent 10 membered aromatic heterocyclic residues containing four heteroatoms such as pteridinyl.

Examples of tricyclic monovalent 9 to 14 membered aromatic heterocyclic residues are dibenzofuryl, acridinyl, phenoxazinyl, 7H-cyclopenta[1,2-b:3,4-b']dithiophenyl and 4H-cyclopenta-[2,1-b:3,4-b']dithiophenyl. An example of a tricyclic monovalent 9 to 14 membered aromatic heterocyclic residue containing three heteroatoms is dithienothiophenyl of formula

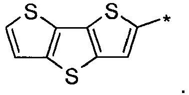

An example of a tetracyclic monovalent 9 to 14 membered aromatic heterocyclic residue containing four heteroatoms is trithienothiophenyl of formula

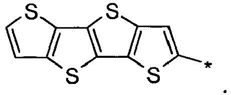

Examples of halogen are -F, -Cl, -Br and -I.

Examples of C₁₋₁₀-alkoxy are methoxy, ethoxy, *n*-propoxy, isopropoxy, *n*-butoxy, *sec*-butoxy, isobutoxy, *tert*-butoxy, *n*-pentoxy, neopentoxy, isopentoxy, hexoxy, *n*-heptoxy, *n*-octoxy, *n*-nonoxy and *n*-decoxy. Examples of C₁₋₃₀-alkoxy are C₁₋₁₀-alkoxy, and *n*-undecoxy, n-dodecoxy, *n*-undecoxy, *n*-dodecoxy, n-tridecoxy, n-tetradecoxy, *n*-pentadecoxy, *n*-hexadecoxy, *n*-heptadecoxy, *n*-octadecoxy, *n*-nonadecoxy and *n*-icosoxy (C₂₀), *n*-docosoxy (C₂₂), n-tetracosoxy (C₂₄), *n*-hexacosoxy (C₂₆), *n*-octacosoxy (C₂₈) and *n*-triacontoxy (C₃₀).

Examples of C₂₋₆-alkylene are ethylene, butylene, pentylene, hexylene and 2-methylpentylene.

Examples of C₆₋₁₄-arylene are monocyclic C₆-arylene such as phenylene, bicyclic C₉₋₁₀-arylene such as naphthylene, for example 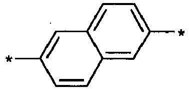 indenylene, for example 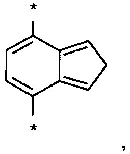 indanylene, for example 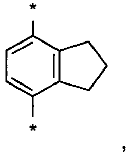 and tetrahydronaphthylene, for example 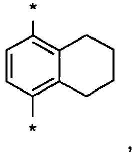 and tricyclic C₁₂₋₁₄-arylene such as anthrylene, for example 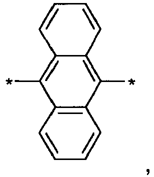 phenanthrylene, for example 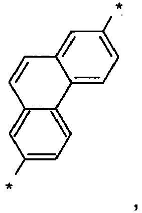 fluorenylene, for example 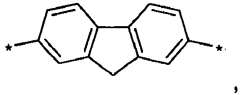 and
s-indacenylene, for example

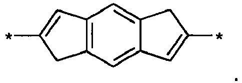

Examples of C₆₋₂₄-arylene are C₆₋₁₄-arylene and 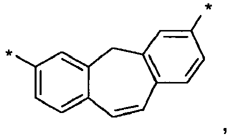 pyrenylene, for example 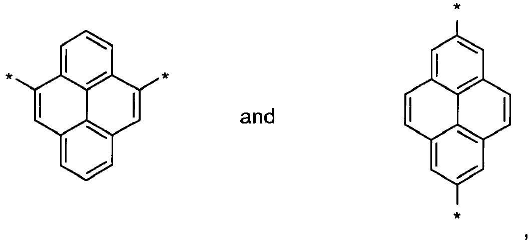 tetracenylene, for example 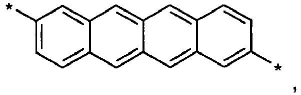 perylenylene, for example 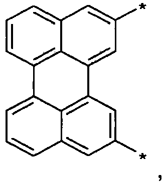 indenofluorenylene, for example 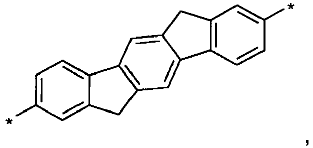 pentacenylene, for example 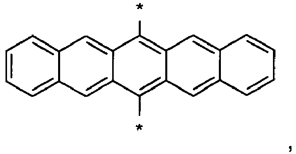 coronenylene, for example 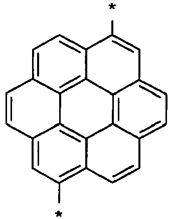 and tetraphenylenylene, for example

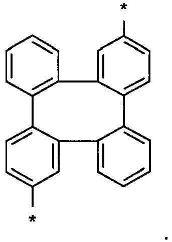

The bivalent 5 to 14 membered aromatic heterocyclic residues can be monocyclic bivalent 5 to 8 membered aromatic heterocyclic residues, or polycyclic, for example bicyclic bivalent 7 to 14 membered, tricyclic bivalent 9 to 14 membered aromatic heterocyclic residues, or tetracyclic bivalent 9 to 14 membered aromatic heterocyclic residues.

Examples of monocyclic bivalent 5 to 8 membered aromatic heterocyclic residues are monocyclic bivalent 5 membered aromatic heterocyclic residues containing one heteroatom such as pyrrolylene, furylene and thiophenylene, monocyclic bivalent 5 membered aromatic heterocyclic residues containing two heteroatoms such as imidazolylene, pyrazolylene, oxazolylene, isoxazolylene, thiazolylene, isothiazolylene, monocyclic bivalent 5 membered aromatic heterocyclic residues containing three heteroatoms such as 1,2,3-triazolylene, 1,2,4-triazolylene and oxadia-zolylene, monocyclic bivalent 5 membered aromatic heterocyclic residues containing four heteroatoms such as tetrazolylene, monocyclic bivalent 6 membered aromatic heterocyclic residues containing one heteroatom such as pyridylene, monocyclic bivalent 6 membered aromatic heterocyclic residues containing two heteroatoms such as pyrazinylene, pyrimidinylene and pyridazinylene, monocyclic bivalent 6 membered aromatic heterocyclic residues containing three heteroatoms such as 1,2,3-triazinylene, 1,2,4-triazinylene and 1,3,5-triazinylene, monocyclic bivalent 7 membered aromatic heterocyclic residues containing one heteroatom such as azepinylene, and monocyclic bivalent 7 membered aromatic heterocyclic residues containing two heteroatoms such as 1,2-diazepinylene.

Examples of bicyclic bivalent 7 to 14 membered aromatic heterocyclic residues are bicyclic bivalent 8 membered aromatic heterocyclic residues containing two heteroatoms such as thienothiophenylene, for example 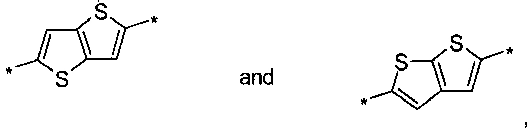 bicyclic bivalent 8 membered aromatic heterocyclic residues containing three heteroatoms such as as thienothiazolylene, for example 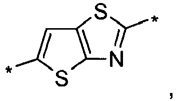 bicyclic bivalent 8 membered aromatic heterocyclic residues containing four heteroatoms such as thiazothiazolylene, for example 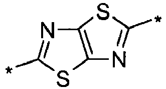 bicyclic bivalent 9 membered aromatic heterocyclic residues containing one heteroatom such as indolylene, isoindolylene, indolizinylene, indolinylene, isoindolinylene, for example 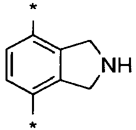 benzofurylene, isobenzofurylene, benzothiophenylene and isobenzothiophenylene,
bicyclic bivalent 9 membered aromatic heterocyclic residues containing two heteroatoms such as indazolylene, benzimidazolylene, benzimidazolinylene, benzoxazolylene, benzisooxazolylene, benzthiazolylene, benzisothiazolylene, furopyridylene and thienopyridylene,
bicyclic bivalent 9 membered aromatic heterocyclic residues containing three heteroatoms such as benzotriazolylene, benzoxadiazolylene, oxazolopyridylene, isooxazolopyridylene, thiazolopyridylene, isothiazolopyridylene, imidazopyridylene, benzothiadiazolylene, for example 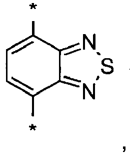 and dioxanothiophenylene, for example 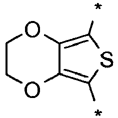 bicyclic bivalent 9 membered aromatic heterocyclic residues containing four heteroatoms such as purinylene,
bicyclic bivalent 10 membered aromatic heterocyclic residues containing one heteroatom such as quinolylene, isoquinolylene, chromenylene and chromanylene,
bicyclic bivalent 10 membered aromatic heterocyclic residues containing two heteroatoms such as quinoxalinylene, for example 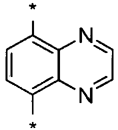 quinazolinylene, cinnolinylene, phthalazinylene, 1,5-naphthyridinylene and 1,8-naphthyridinylene,
bicyclic bivalent 10 membered aromatic heterocyclic residues containing three heteroatoms such as pyridopyrazinylene, pyridopyrimidinylene and pyridopyridazinylene, and bicyclic bivalent 10 membered aromatic heterocyclic residues containing four heteroatoms such as pteridinylene.

Examples of tricyclic bivalent 9 to 14 membered aromatic heterocyclic residues containing one heteroatom are dibenzofurylene, acridinylene, dibenzosilacyclopentadienylene, for example 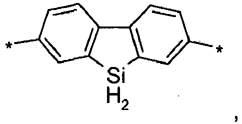 and dibenzopyrrolylene, for example

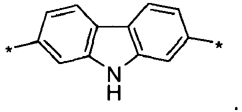

Examples of a tricyclic bivalent 9 to 14 membered aromatic heterocyclic residues containing two heteroatoms are phenoxazinylene, and the following compounds 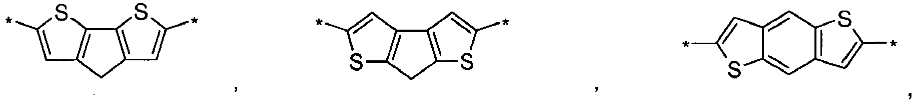 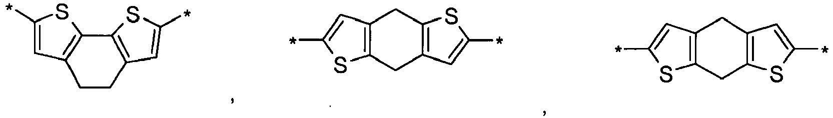 and

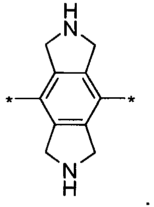

Examples of tricyclic bivalent 9 to 14 membered aromatic heterocyclic residue containing three heteroatoms are the following compounds

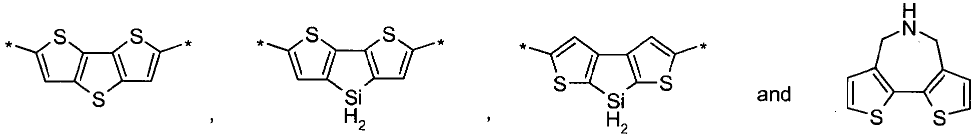

Examples of tricyclic bivalent 9 to 14 membered aromatic heterocyclic residue containing fourheteroatoms are the following compounds

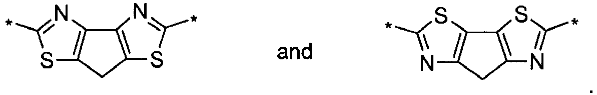

An example of a tricyclic bivalent 9 to 14 membered aromatic heterocyclic residue containing six heteroatoms is the following compound

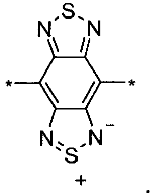

An example of a tetracyclic bivalent 9 to 14 membered aromatic heterocyclic residue containing four heteroatoms is the following compound

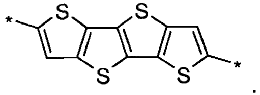

Examples of bivalent 5 to 24 membered aromatic heterocyclic residues are bivalent 5 to 14 membered aromatic heterocyclic residues, and the following compounds

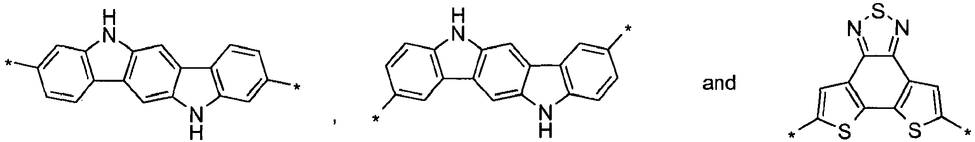

Examples of L are:

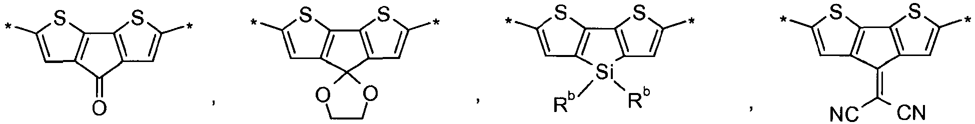

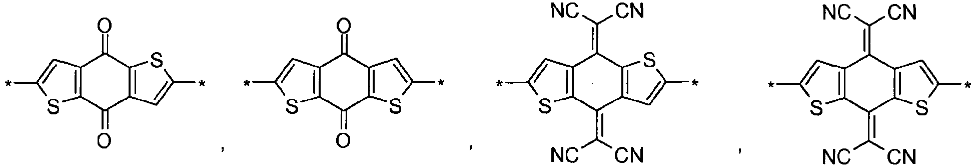

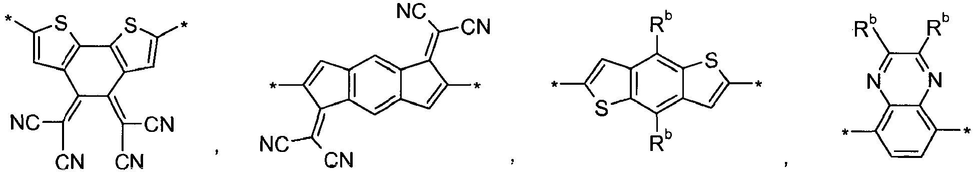

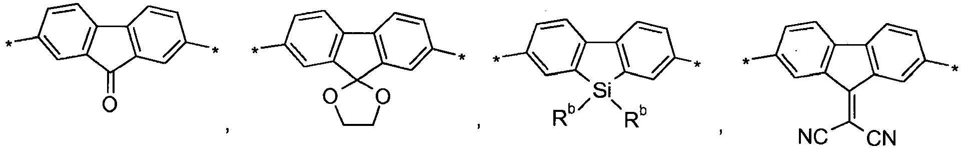

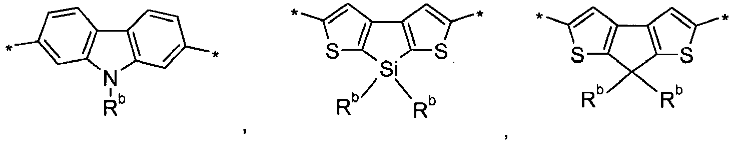

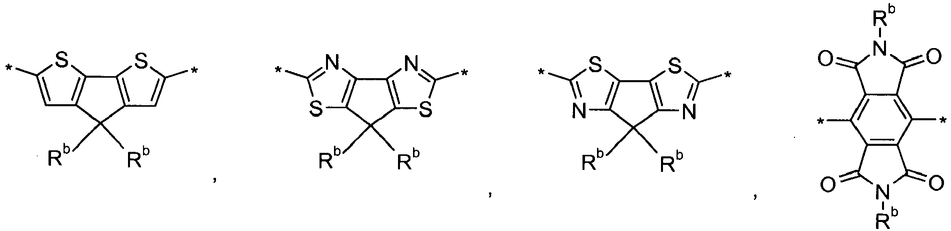

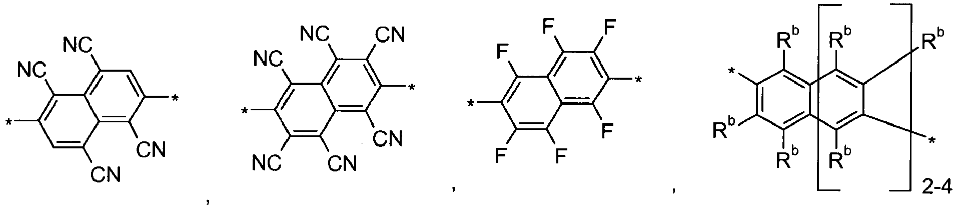

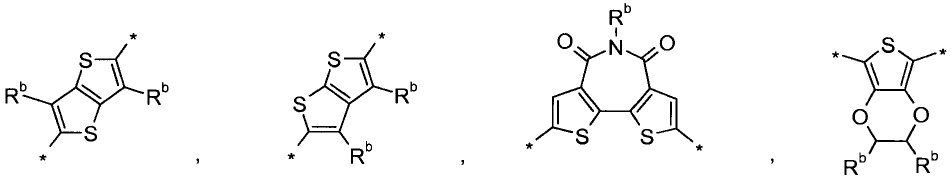

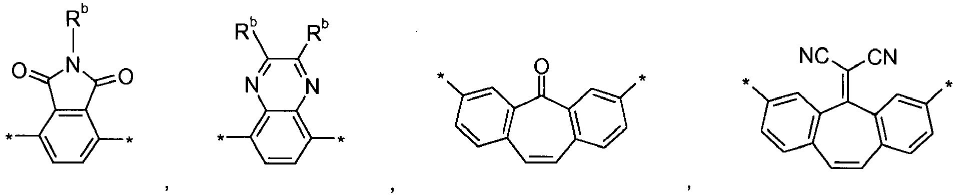

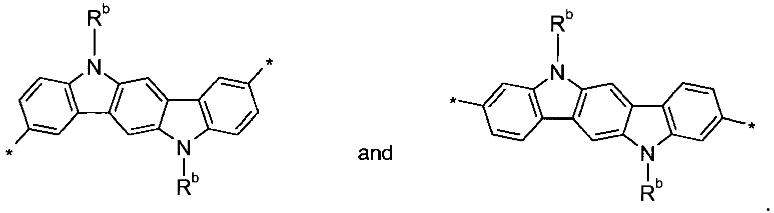

In preferred units of formula (1)
R¹ and R² are independently from each other H, C₁₋₃₀-alkyl optionally substituted with 1 to 6 substituents R^{c}, C₂₋₃₀-alkenyl optionally substituted with 1 to 6 substituents R^{c}, C₂₋₃₀-alkynyl optionally substituted with 1 to 6 substituents R^{c}, C₃₋₁₀-cycloalkyl optionally substituted with 1 to 6 substituents R^{d}, C₅₋₁₀-cycloalkenyl or C₆₋₁₄-aryl optionally substituted with 1 to 6 substituents Re,
wherein
R^{c} at each occurrence are independently from each other selected from the group consisting of =O, =C(CN)₂, -O-C₂₋₆-alkylene-O-, halogen, -CN, -NO₂, -OH, C₁₋₁₀-alkoxy, -O-CH₂CH₂O-C₁₋₁₀-alkyl, -O-COR³, -S-C₁₋₁₀-alkyl, -NH₂, -NHR³, -NR³R⁴, -NH-COR³, -COOH, -COOR³, -CONH₂, -CONHR³, -CONR³R⁴, -CO-H, -COR³, C₃₋₁₀-cycloalkyl, monovalent 3 to 14 membered aliphatic heterocyclic residue, C₆₋₁₄-aryl and monovalent 5 to 14 membered aromatic heterocyclic residue;
R^{d} at each occurrence are independently from each other selected from the group consisting of =O, =C(CN)₂, -O-C₂₋₆-alkylene-O-, halogen, -CN, -NO₂, -OH, C₁₋₁₀-alkoxy, -O-CH₂CH₂O-C₁₋₁₀-alkyl, -O-COR³, -S-C₁₋₁₀-alkyl, -NH₂, -NHR³, -NR³R⁴, -NH-COR³, -COOH, -COOR³, -CONH₂, -CONHR³, -CONR³R⁴, -CO-H, -COR³, C₁₋₁₀-alkyl, C₂₋₁₀-alkenyl, C₂₋₁₀-alkynyl, C₆₋₁₄-aryl and monovalent 5 to 14 membered aromatic heterocyclic residue;
R^{e} at each occurrence are independently from each other selected from the group consisting of =O, =C(CN)₂, -O-C₂₋₆-alkylene-O-, halogen, -CN, -NO₂, -OH, C₁₋₁₀-alkoxy, -O-CH₂CH₂O-C₁₋₁₀-alkyl, -O-COR³, -S-C₁₋₁₀-alkyl, -NH₂, -NHR³, -NR³R⁴, -NH-COR³, -COOH, -COOR³, -CONH₂, -CONHR³, -CONR³R⁴, -CO-H, -COR³, C₁₋₁₀-alkyl, C₂₋₁₀-alkenyl, C₂₋₁₀-alkynyl, C₃₋₁₀-cycloalkyl, C₅₋₁₀-cycloalkenyl and monovalent 3 to 14 membered aliphatic heterocyclic residue,
wherein R³ and R⁴ at each occurrence are independently from each other selected from the group consisting of C₁₋₁₀-alkyl, C₂₋₁₀-alkenyl, C₂₋₁₀-alkynyl, C₃₋₁₀-cycloalkyl, C₅₋₁₀-cycloalkenyl, monovalent 3 to 14 membered aliphatic heterocyclic residue, C₆₋₁₄-aryl and monovalent 5 to 14 membered aromatic heterocyclic residue,
G¹ and G² are independently from each other C₆₋₁₄-arylene optionally substituted with 1 to 6 substituents R^{a} or bivalent 5 to 14 membered aromatic heterocyclic residue optionally substituted with 1 to 6 substituents R^{a},
wherein
R^{a} at each occurrence are independently from each other selected from the group consisting of =O, =C(CN)₂, -O-C₂₋₆-alkylene-O-, halogen, -CN, -NO₂, -OH, C₁₋₃₀-alkoxy, -O-CH₂CH₂O-C₁₋₃₀-alkyl, -O-COR⁸, -S-C₁₋₃₀-alkyl, -NH₂, -NHR⁸, -NR⁸R⁹, -NH-COR⁸, -COOH, -COOR⁸, -CONH₂, -CONHR⁸, -CONR⁸R⁹, -CO-H, -COR⁸, C₁₋₃₀-alkyl optionally substituted with 1 to 6 substituents R^{f}, C₂₋₃₀-alkenyl optionally substituted with 1 to 6 substituents R^{f}, C₂₋₃₀-alkynyl optionally substituted with 1 to 6 substituents R^{f}, C₃₋₁₀-cycloalkyl optionally substituted with 1 to 6 substituents R^{g}, C₅₋₁₀-cycloalkenyl optionally substituted with 1 to 6 substituents R^{g} and monovalent 3 to 14 membered aliphatic heterocyclic residue optionally substituted with 1 to 6 substituents R^{g},
wherein
R⁸ and R⁹ at each occurrence are independently from each other selected from the group consisting of C₁₋₃₀-alkyl, C₂₋₃₀-alkenyl, C₂₋₃₀-alkynyl, C₃₋₁₀-cycloalkyl, C₅₋₁₀-cycloalkenyl, monovalent 3 to 14 membered aliphatic heterocyclic residue, C₆₋₁₄-aryl and monovalent 5 to 14 membered aromatic heterocyclic residue,
R^{f} at each occurrence are independently from each other selected from the group consisting of =O, =C(CN)₂, -O-C₂₋₆-alkylene-O-, halogen, -CN, -NO₂, -OH, C₁₋₁₀-alkoxy, -O-CH₂CH₂O-C₁₋₁₀-alkyl, -O-COR¹⁰, -S-C₁₋₁₀-alkyl, -NH₂, -NHR¹⁰, -NR¹⁰R¹¹, -NH-COR¹⁰, -COOH, -COOR¹⁰, -CONH₂, -CONHR¹⁰, -CONR¹⁰R¹¹, -CO-H, -COR¹⁰, C₃₋₁₀-cycloalkyl, monovalent 3 to 14 membered aliphatic heterocyclic residue, C₆₋₁₄-aryl and monovalent 5 to 14 membered aromatic heterocyclic residue;
R^{g} at each occurrence are independently from each other selected from the group consisting of =O, =C(CN)₂, -O-C₂₋₆-alkylene-O-, halogen, -CN, -NO₂, -OH, C₁₋₁₀-alkoxy, -O-CH₂CH₂O-C₁₋₁₀-alkyl, -O-COR¹⁰, -S-C₁₋₁₀-alkyl, -NH₂, -NHR¹⁰, -NR¹⁰R¹¹, -NH-COR¹⁰, -COOH, -COOR¹⁰, -CONH₂, -CONHR¹⁰, -CONR¹⁰R¹¹, -CO-H, -COR¹⁰, C₁₋₁₀-alkyl, C₂₋₁₀-alkenyl, C₂₋₁₀-alkynyl, C₆₋₁₄-aryl and monovalent 5 to 14 membered aromatic heterocyclic residue;
wherein R¹⁰ and R¹¹ at each occurrence are independently from each other selected from the group consisting of C₁₋₁₀-alkyl, C₂₋₁₀-alkenyl, C₂₋₁₀-alkynyl, C₃₋₁₀-cycloalkyl, C₅₋₁₀-cycloalkenyl, monovalent 3 to 14 membered aliphatic heterocyclic residue, C₆₋₁₄-aryl and monovalent 5 to 14 membered aromatic heterocyclic residue,
or
G¹ and G² are independently from each other 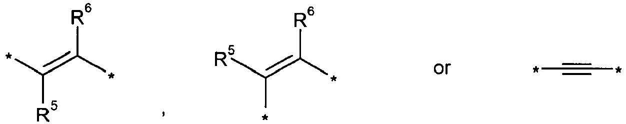 wherein
R⁵ and R⁶ are independently from each other H or C₁₋₃₀-alkyl,
L is C₆₋₂₄-arylene optionally substituted with 1 to 6 substituents R^{b} or bivalent 5 to 24 membered aromatic heterocyclic residue optionally substituted with 1 to 6 substituents R^{b},
wherein
R^{b} at each occurrence are independently from each other selected from the group consisting of =O, =C(CN)₂, -O-C₂₋₆-alkylene-O-, halogen, -CN, -NO₂, -OH, C₁₋₃₀-alkoxy, -O-CH₂CH₂O-C₁₋₃₀-alkyl, -O-COR¹², -S-C₁₋₃₀-alkyl, -NH₂, -NHR¹², -NR¹²R¹³, -NH-COR¹², -COOH, -COOR¹², -CONH₂, -CONHR¹², -CONR¹²R¹³, -CO-H, -COR¹², C₁₋₃₀-alkyl optionally substituted with 1 to 6 substituents R^{h}, C₂₋₃₀-alkenyl optionally substituted with 1 to 6 substituents R^{h}, C₂₋₃₀-alkynyl optionally substituted with 1 to 6 substituents R^{h}, C₃₋₁₀-cycloalkyl optionally substituted with 1 to 6 substituents Rⁱ, C₅₋₁₀-cycloalkenyl optionally substituted with 1 to 6 substituents Rⁱ and monovalent 3 to 14 membered aliphatic heterocyclic residue optionally substituted with 1 to 6 substituents Rⁱ,
wherein
R¹² and R¹³ at each occurrence are independently from each other selected from the group consisting of C₁₋₃₀-alkyl, C₂₋₃₀-alkenyl, C₂₋₃₀-alkynyl, C₃₋₁₀-cycloalkyl, C₅₋₁₀-cycloalkenyl, monovalent 3 to 14 membered aliphatic heterocyclic residue, C₆₋₁₄-aryl and monovalent 5 to 14 membered aromatic heterocyclic residue,
R^{h} at each occurrence are independently from each other selected from the group consisting of =O, =C(CN)₂, -O-C₂₋₆-alkylene-O-, halogen, -CN, -NO₂, -OH, C₁₋₁₀-alkoxy, -O-CH₂CH₂O-C₁₋₁₀-alkyl, -O-COR¹², -S-C₁₋₁₀-alkyl, -NH₂, -NHR¹⁴, -NR¹⁴R¹⁵, -NH-COR¹⁴, -COOH, -COOR¹⁴, -CONH₂, -CONHR¹⁴, -CONR¹⁴R¹⁵, -CO-H, -COR¹⁴, C₃₋₁₀-cycloalkyl, monovalent 3 to 14 membered aliphatic heterocyclic residue, C₆₋₁₄-aryl and monovalent 5 to 14 membered aromatic heterocyclic residue;
Rⁱ at each occurrence are independently from each other selected from the group consisting of =O, =C(CN)₂, -O-C₂₋₆-alkylene-O-, halogen, -CN, -NO₂, -OH, C₁₋₁₀-alkoxy, -O-CH₂CH₂O-C₁₋₁₀-alkyl, -O-COR¹², -S-C₁₋₁₀-alkyl, -NH₂, -NHR¹⁴, -NR¹⁴R¹⁵, -NH-COR¹⁴, -COOH, -COOR¹⁴, -CONH₂, -CONHR¹⁴, -CONR¹⁴R¹⁵, -CO-H, -COR¹⁴, C₁₋₁₀-alkyl, C₂₋₁₀-alkenyl, C₂₋₁₀-alkynyl, C₆₋₁₄-aryl and monovalent 5 to 14 membered aromatic heterocyclic residue;
wherein R¹⁴ and R¹⁵ at each occurrence are independently from each other selected from the group consisting of C₁₋₁₀-alkyl, C₂₋₁₀-alkenyl, C₂₋₁₀-alkynyl, C₃₋₁₀-cycloalkyl, C₅₋₁₀-cycloalkenyl, monovalent 3 to 14 membered aliphatic heterocyclic residue, C₆₋₁₄-aryl and monovalent 5 to 14 membered aromatic heterocyclic residue,
or
L is 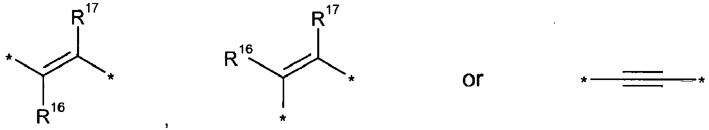 wherein
R¹⁶ and R¹⁷ are independently from each other H, C₁₋₃₀-alkyl, -CN or halogen,
q and s are independently from each other 0, 1, 2, 3, 4 or 5,
r is 0, 1 or 2,
and
n is an integer from 2 to 10'000.

In more preferred units of formula (1)
R¹ and R² are independently from each other C₁₋₃₀-alkyl optionally substituted with 1 to 6 substituents R^{c}, preferably C₁₋₁₆-alkyl optionally substituted with 1 to 6 substituents R^{c}, more preferably C₁₋₁₂-alkyl optionally substituted with 1 to 6 substituents R^{c},
wherein
R^{c} at each occurrence are independently from each other selected from the group consisting of =O, =C(CN)₂, -O-C₂₋₆-alkylene-O-, halogen, -CN, -NO₂, -OH, C₁₋₁₀-alkoxy, -O-CH₂CH₂O-C₁₋₁₀-alkyl, -O-COR³, -S-C₁₋₁₀-alkyl, -NH₂, -NHR³, -NR³R⁴, -NH-COR³, -COOH, -COOR³, -CONH₂, -CONHR³, -CONR³R⁴, -CO-H, -COR³, C₃₋₁₀-cycloalkyl, monovalent 3 to 14 membered aliphatic heterocyclic residue, C₆₋₁₄-aryl and monovalent 5 to 14 membered aromatic heterocyclic residue;
wherein R³ and R⁴ at each occurrence are independently from each other selected from the group consisting of C₁₋₁₀-alkyl, C₂₋₁₀-alkenyl, C₂₋₁₀-alkynyl, C₃₋₁₀-cycloalkyl, C₅₋₁₀-cycloalkenyl, monovalent 3 to 14 membered aliphatic heterocyclic residue, C₆₋₁₄-aryl and monovalent 5 to 14 membered aromatic heterocyclic residue,
G¹ and G² are independently from each other C₆₋₁₄-arylene optionally substituted with 1 to 6 substituents R^{a} or bivalent 5 to 14 membered aromatic heterocyclic residue optionally substituted with 1 to 6 substituents R^{a},
wherein
R^{a} at each occurrence are independently from each other selected from the group consisting of =O, =C(CN)₂, -O-C₂₋₆-alkylene-O-, halogen, -CN, -NO₂, -OH, C₁₋₃₀-alkoxy, -O-CH₂CH₂O-C₁₋₃₀-alkyl, -O-COR⁸, -S-C₁₋₃₀-alkyl, -NH₂, -NHR⁸, -NR⁸R⁹, -NH-COR⁸, -COOH, -COOR⁸, -CONH₂, -CONHR⁸, -CONR⁸R⁹, -CO-H, -COR⁸, C₁₋₃₀-alkyl optionally substituted with 1 to 6 substituents R^{f}, C₂₋₃₀-alkenyl optionally substituted with 1 to 6 substituents R^{f}, C₂₋₃₀-alkynyl optionally substituted with 1 to 6 substituents R^{f}, C₃₋₁₀-cycloalkyl optionally substituted with 1 to 6 substituents R^{g}, C₅₋₁₀-cycloalkenyl optionally substituted with 1 to 6 substituents R^{g} and monovalent 3 to 14 membered aliphatic heterocyclic residue optionally substituted with 1 to 6 substituents R^{g},
wherein
R⁸ and R⁹ at each occurrence are independently from each other selected from the group consisting of C₁₋₃₀-alkyl, C₂₋₃₀-alkenyl, C₂₋₃₀-alkynyl, C₃₋₁₀-cycloalkyl, C₅₋₁₀-cycloalkenyl, monovalent 3 to 14 membered aliphatic heterocyclic residue, C₆₋₁₄-aryl and monovalent 5 to 14 membered aromatic heterocyclic residue,
R^{f} at each occurrence are independently from each other selected from the group consisting of =O, =C(CN)₂, -O-C₂₋₆-alkylene-O-, halogen, -CN, -NO₂, -OH, C₁₋₁₀-alkoxy, -O-CH₂CH₂O-C₁₋₁₀-alkyl, -O-COR¹⁰, -S-C₁₋₁₀-alkyl, -NH₂, -NHR¹⁰, -NR¹⁰R¹¹, -NH-COR¹⁰, -COOH, -COOR¹⁰, -CONH₂, -CONHR¹⁰, -CONR¹⁰R¹¹, -CO-H, -COR¹⁰, C₃₋₁₀-cycloalkyl, monovalent 3 to 14 membered aliphatic heterocyclic residue, C₆₋₁₄-aryl and monovalent 5 to 14 membered aromatic heterocyclic residue;
R^{g} at each occurrence are independently from each other selected from the group consisting of =O, =C(CN)₂, -O-C₂₋₆-alkylene-O-, halogen, -CN, -NO₂, -OH, C₁₋₁₀-alkoxy, -O-CH₂CH₂O-C₁₋₁₀-alkyl, -O-COR¹², -S-C₁₋₁₀-alkyl, -NH₂, -NHR¹⁰, -NR¹⁰R¹¹, -NH-COR¹⁰, -COOH, -COOR¹⁰, -CONH₂, -CONHR¹⁰, -CONR¹⁰R¹¹, -CO-H, -COR¹⁰, C₁₋₁₀-alkyl, C₂₋₁₀-alkenyl, C₂₋₁₀-alkynyl, C₆₋₁₄-aryl and monovalent 5 to 14 membered aromatic heterocyclic residue;
wherein R¹⁰ and R¹¹ at each occurrence are independently from each other selected from the group consisting of C₁₋₁₀-alkyl, C₂₋₁₀-alkenyl, C₂₋₁₀-alkynyl, C₃₋₁₀-cycloalkyl, C₅₋₁₀-cycloalkenyl, monovalent 3 to 14 membered aliphatic heterocyclic residue, C₆₋₁₄-aryl and monovalent 5 to 14 membered aromatic heterocyclic residue,
or
G¹ and G² are independently from each other 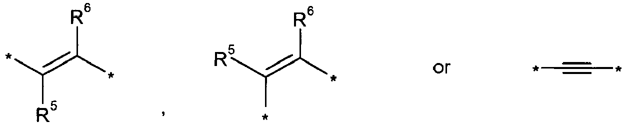 wherein R⁵ and R⁶ are independently from each other H or C₁₋₃₀-alkyl,
L is C₆₋₂₄-arylene optionally substituted with 1 to 6 substituents R^{b} or bivalent 5 to 24 membered aromatic heterocyclic residue optionally substituted with 1 to 6 substituents R^{b},
wherein
R^{b} at each occurrence are independently from each other selected from the group consisting of =O, =C(CN)₂, -O-C₂₋₆-alkylene-O-, halogen, -CN, -NO₂, -OH, C₁₋₃₀-alkoxy, -O-CH₂CH₂O-C₁₋₃₀-alkyl, -O-COR¹², -S-C₁₋₃₀-alkyl, -NH₂, -NHR¹², -NR¹²R¹³, -NH-COR¹², -COOH, -COOR¹², -CONH₂, -CONHR¹², -CONR¹²R¹³, -CO-H, -COR¹², C₁₋₃₀-alkyl optionally substituted with 1 to 6 substituents R^{h}, C₂₋₃₀-alkenyl optionally substituted with 1 to 6 substituents R^{h}, C₂₋₃₀-alkynyl optionally substituted with 1 to 6 substituents R^{h}, C₃₋₁₀-cycloalkyl optionally substituted with 1 to 6 substituents Rⁱ, C₅₋₁₀-cycloalkenyl optionally substituted with 1 to 6 substituents Rⁱ and monovalent 3 to 14 membered aliphatic heterocyclic residue optionally substituted with 1 to 6 substituents Rⁱ,
wherein
R¹² and R¹³ at each occurrence are independently from each other selected from the group consisting of C₁₋₃₀-alkyl, C₂₋₃₀-alkenyl, C₂₋₃₀-alkynyl, C₃₋₁₀-cycloalkyl, C₅₋₁₀-cycloalkenyl, monovalent 3 to 14 membered aliphatic heterocyclic residue, C₆₋₁₄-aryl and monovalent 5 to 14 membered aromatic heterocyclic residue,
R^{h} at each occurrence are independently from each other selected from the group consisting of =O, =C(CN)₂, -O-C₂₋₆-alkylene-O-, halogen, -CN, -NO₂, -OH, C₁₋₁₀-alkoxy, -O-CH₂CH₂O-C₁₋₁₀-alkyl, -O-COR¹⁴, -S-C₁₋₁₀-alkyl, -NH₂, -NHR¹⁴, -NR¹⁴R¹⁵, -NH-COR¹⁴, -COOH, -COOR¹⁴, -CONH₂, -CONHR¹⁴, -CONR¹⁴R¹⁵, -CO-H, -COR¹⁴, C₃₋₁₀-cycloalkyl, monovalent 3 to 14 membered aliphatic heterocyclic residue, C₆₋₁₄-aryl and monovalent 5 to 14 membered aromatic heterocyclic residue;
Rⁱ at each occurrence are independently from each other selected from the group consisting of =O, =C(CN)₂, -O-C₂₋₆-alkylene-O-, halogen, -CN, -NO₂, -OH, C₁₋₁₀-alkoxy, -O-CH₂CH₂O-C₁₋₁₀-alkyl, -O-COR¹⁴, -S-C₁₋₁₀-alkyl, -NH₂, -NHR¹⁴, -NR¹⁴R¹⁵, -NH-COR¹⁴, -COOH, -COOR¹⁴, -CONH₂, -CONHR¹⁴, -CONR¹⁴R¹⁵, -CO-H, -COR¹⁴, C₁₋₁₀-alkyl, C₂₋₁₀-alkenyl, C₂₋₁₀-alkynyl, C₆₋₁₄-aryl and monovalent 5 to 14 membered aromatic heterocyclic residue;
wherein R¹⁴ and R¹⁵ at each occurrence are independently from each other selected from the group consisting of C₁₋₁₀-alkyl, C₂₋₁₀-alkenyl, C₂₋₁₀-alkynyl, C₃₋₁₀-cycloalkyl, C₅₋₁₀-cycloalkenyl, monovalent 3 to 14 membered aliphatic hetero-cyclic residue, C₆₋₁₄-aryl and monovalent 5 to 14 membered aromatic heterocyclic residue,
or
L is 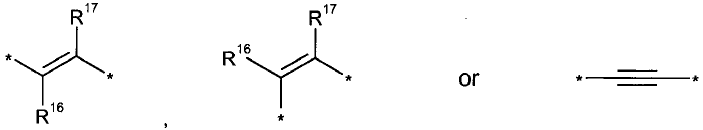 wherein
R¹⁶ and R¹⁷ are independently from each other H, C₁₋₃₀-alkyl, -CN or halogen,
q and s are independently from each other 0, 1, 2, 3, 4 or 5,
r is 0, 1 or 2,
and
n is an integer from 2 to 10'000.

In even more preferred units of formula (1)
R¹ and R² are independently from each other C₁₋₃₀-alkyl optionally substituted with 1 to 6 substituents R^{c}, preferably C₁₋₁₆-alkyl optionally substituted with 1 to 6 substituents R^{c}, more preferably C₁₋₁₂-alkyl optionally substituted with 1 to 6 substituents R^{c},
wherein
R^{c} at each occurrence are independently from each other selected from the group consisting of =O, =C(CN)₂, -O-C₂₋₆-alkylene-O-, halogen, -CN, -NO₂, -OH, C₁₋₁₀-alkoxy, -O-CH₂CH₂O-C₁₋₁₀-alkyl, -O-COR³, -S-C₁₋₁₀-alkyl, -NH₂, -NHR³, -NR³R⁴, -NH-COR³, -COOH, -COOR³, -CONH₂, -CONHR³, -CONR³R⁴, -CO-H, -COR³, C₃₋₁₀-cycloalkyl, monovalent 3 to 14 membered aliphatic heterocyclic residue, C₆₋₁₄-aryl and monovalent 5 to 14 membered aromatic heterocyclic residue;
wherein R³ and R⁴ at each occurrence are independently from each other selected from the group consisting of C₁₋₁₀-alkyl, C₂₋₁₀-alkenyl, C₂₋₁₀-alkynyl, C₃₋₁₀-cycloalkyl, C₅₋₁₀-cycloalkenyl, monovalent 3 to 14 membered aliphatic heterocyclic residue, C₆₋₁₄-aryl and monovalent 5 to 14 membered aromatic heterocyclic residue,
G¹ and G² are independently from each other bivalent 5 to 14 membered aromatic heterocyclic residue optionally substituted with 1 to 6 substituents R^{a},
wherein
R^{a} at each occurrence are independently from each other selected from the group consisting of =O, =C(CN)₂, -O-C₂₋₆-alkylene-O-, halogen, -CN, -NO₂, -OH, C₁₋₃₀-alkoxy, -O-CH₂CH₂O-C₁₋₃₀-alkyl, -O-COR⁸, -S-C₁₋₃₀-alkyl, -NH₂, -NHR⁸, -NR⁸R⁹, -NH-COR⁸, -COOH, -COOR⁸, -CONH₂, -CONHR⁸, -CONR⁸R⁹, -CO-H, -COR⁸, C₁₋₃₀-alkyl optionally substituted with 1 to 6 substituents R^{f}, C₂₋₃₀-alkenyl optionally substituted with 1 to 6 substituents R^{f}, C₂₋₃₀-alkynyl optionally substituted with 1 to 6 substituents R^{f}, C₃₋₁₀-cycloalkyl optionally substituted with 1 to 6 substituents R^{g}, C₅₋₁₀-cycloalkenyl optionally substituted with 1 to 6 substituents R^{g} and monovalent 3 to 14 membered aliphatic heterocyclic residue optionally substituted with 1 to 6 substituents R^{g},
wherein
R⁸ and R⁹ at each occurrence are independently from each other selected from the group consisting of C₁₋₃₀-alkyl, C₂₋₃₀-alkenyl, C₂₋₃₀-alkynyl, C₃₋₁₀-cycloalkyl, C₅₋₁₀-cycloalkenyl, monovalent 3 to 14 membered aliphatic heterocyclic residue, C₆₋₁₄-aryl and monovalent 5 to 14 membered aromatic heterocyclic residue,
R^{f} at each occurrence are independently from each other selected from the group consisting of =O, =C(CN)₂, -O-C₂₋₆-alkylene-O-, halogen, -CN, -NO₂, -OH, C₁₋₁₀-alkoxy, -O-CH₂CH₂O-C₁₋₁₀-alkyl, -O-COR¹⁰, -S-C₁₋₁₀-alkyl, -NH₂, -NHR¹⁰, -NR¹⁰R¹¹, -NH-COR¹⁰, -COOH, -COOR¹⁰, -CONH₂, -CONHR¹⁰, -CONR¹⁰R¹¹, -CO-H, -COR¹⁰, C₃₋₁₀-cycloalkyl, monovalent 3 to 14 membered aliphatic heterocyclic residue, C₆₋₁₄-aryl and monovalent 5 to 14 membered aromatic heterocyclic residue;
R^{g} at each occurrence are independently from each other selected from the group consisting of =O, =C(CN)₂, -O-C₂₋₆-alkylene-O-, halogen, -CN, -NO₂, -OH, C₁₋₁₀-alkoxy, -O-CH₂CH₂O-C₁₋₁₀-alkyl, -O-COR¹⁰, -S-C₁₋₁₀-alkyl, -NH₂, -NHR¹⁰, -NR¹⁰R¹¹, -NH-COR¹⁰, -COOH, -COOR¹⁰, -CONH₂, -CONHR¹⁰, -CONR¹⁰R¹¹, -CO-H, -COR¹⁰, C₁₋₁₀-alkyl, C₂₋₁₀-alkenyl, C₂₋₁₀-alkynyl, C₆₋₁₄-aryl and monovalent 5 to 14 membered aromatic heterocyclic residue;
wherein R¹⁰ and R¹¹ at each occurrence are independently from each other selected from the group consisting of C₁₋₁₀-alkyl, C₂₋₁₀-alkenyl, C₂₋₁₀-alkynyl, C₃₋₁₀-cycloalkyl, C₅₋₁₀-cycloalkenyl, monovalent 3 to 14 membered aliphatic heterocyclic residue, C₆₋₁₄-aryl and monovalent 5 to 14 membered aromatic heterocyclic residue,
or
G¹ and G² are independently from each other 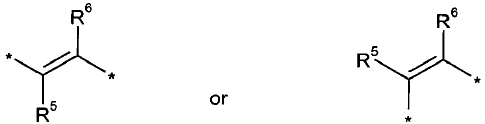 wherein
R⁵ and R⁶ are independently from each other H or C₁₋₃₀-alkyl,
L is bivalent 5 to 24 membered aromatic heterocyclic residue optionally substituted with 1 to 6 substituents R^{b},
wherein
R^{b} at each occurrence are independently from each other selected from the group consisting of =O, =C(CN)₂, -O-C₂₋₆-alkylene-O-, halogen, -CN, -NO₂, -OH, C₁₋₃₀-alkoxy, -O-CH₂CH₂O-C₁₋₃₀-alkyl, -O-COR¹², -S-C₁₋₃₀-alkyl, -NH₂, -NHR¹², -NR¹²R¹³, -NH-COR¹², -COOH, -COOR¹², -CONH₂, -CONHR¹², -CONR¹²R¹³, -CO-H, -COR¹², C₁₋₃₀-alkyl optionally substituted with 1 to 6 substituents R^{h}, C₂₋₃₀-alkenyl optionally substituted with 1 to 6 substituents R^{h}, C₂₋₃₀-alkynyl optionally substituted with 1 to 6 substituents R^{h}, C₃₋₁₀-cycloalkyl optionally substituted with 1 to 6 substituents Rⁱ, C₅₋₁₀-cycloalkenyl optionally substituted with 1 to 6 substituents Rⁱ and monovalent 3 to 14 membered aliphatic heterocyclic residue optionally substituted with 1 to 6 substituents Rⁱ,
wherein
R¹² and R¹³ at each occurrence are independently from each other selected from the group consisting of C₁₋₃₀-alkyl, C₂₋₃₀-alkenyl, C₂₋₃₀-alkynyl, C₃₋₁₀-cycloalkyl, C₅₋₁₀-cycloalkenyl, monovalent 3 to 14 membered aliphatic heterocyclic residue, C₆₋₁₄-aryl and monovalent 5 to 14 membered aromatic heterocyclic residue,
R^{h} at each occurrence are independently from each other selected from the group consisting of =O, =C(CN)₂, -O-C₂₋₆-alkylene-O-, halogen, -CN, -NO₂, -OH, C₁₋₁₀-alkoxy, -O-CH₂CH₂O-C₁₋₁₀-alkyl, -O-COR¹⁴, -S-C₁₋₁₀-alkyl, -NH₂, -NHR¹⁴, -NR¹⁴R¹⁵, -NH-COR¹⁴, -COOH, -COOR¹⁴, -CONH₂, -CONHR¹⁴, -CONR¹⁴R¹⁵, -CO-H, -COR¹⁴, C₃₋₁₀-cycloalkyl, monovalent 3 to 14 membered aliphatic heterocyclic residue, C₆₋₁₄-aryl and monovalent 5 to 14 membered aromatic heterocyclic residue;
Rⁱ at each occurrence are independently from each other selected from the group consisting of =O, =C(CN)₂, -O-C₂₋₆-alkylene-O-, halogen, -CN, -NO₂, -OH, C₁₋₁₀-alkoxy, -O-CH₂CH₂O-C₁₋₁₀-alkyl, -O-COR¹⁴, -S-C₁₋₁₀-alkyl, -NH₂, -NHR¹⁴, -NR¹⁴R¹⁵, -NH-COR¹⁴, -COOH, -COOR¹⁴, -CONH₂, -CONHR¹⁴, -CONR¹⁴R¹⁵, -CO-H, -COR¹⁴, C₁₋₁₀-alkyl, C₂₋₁₀-alkenyl, C₂₋₁₀-alkynyl, C₆₋₁₄-aryl and monovalent 5 to 14 membered aromatic heterocyclic residue;
wherein R¹⁴ and R¹⁵ at each occurrence are independently from each other selected from the group consisting of C₁₋₁₀-alkyl, C₂₋₁₀-alkenyl, C₂₋₁₀-alkynyl, C₃₋₁₀-cycloalkyl, C₅₋₁₀-cycloalkenyl, monovalent 3 to 14 membered aliphatic hetero-cyclic residue, C₆₋₁₄-aryl and monovalent 5 to 14 membered aromatic heterocyclic residue,
or
L is 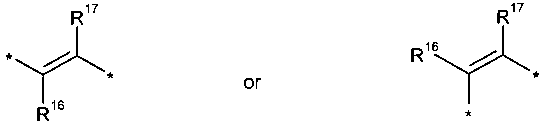 wherein
R¹⁶ and R¹⁷ are independently from each other H, C₁₋₃₀-alkyl, -CN or halogen,
q and s are independently from each other 0, 1, 2, 3, 4 or 5,
r is 0, 1 or 2,
and
n is an integer from 2 to 10'000.

In most preferred units of formula (1)
R¹ and R² are independently from each other C₁₋₁₆-alkyl, more preferably C₁₋₁₂-alkyl,
G¹ and G² are independently from each other monocyclic bivalent 5 to 8 membered aromatic heterocyclic residue optionally substituted with 1 to 4 substituents R^{a},
wherein
R^{a} at each occurrence are independently from each other C₁₋₃₀-alkyl optionally substituted with 1 to 4 substituents R^{f},
wherein
R^{f} at each occurrence are independently from each other selected from the group consisting of =O, =C(CN)₂, -O-C₂₋₆-alkylene-O-, halogen, -CN, -NO₂, -OH, C₁₋₁₀-alkoxy, -O-CH₂CH₂O-C₁₋₁₀-alkyl, -O-COR¹⁰, -S-C₁₋₁₀-alkyl, -NH₂, -NHR¹⁰, -NR¹⁰R¹¹, -NH-COR¹⁰, -COOH, -COOR¹⁰, -CONH₂, -CONHR¹⁰, -CONR¹⁰R¹¹, -CO-H, -COR¹⁰, C₃₋₁₀-cycloalkyl, monovalent 3 to 14 membered aliphatic heterocyclic residue, C₆₋₁₄-aryl and monovalent 5 to 14 membered aromatic heterocyclic residue;
L is bivalent 5 to 14 membered aromatic heterocyclic residue optionally substituted with 1 to 4 substituents R^{b},
wherein
R^{b} at each occurrence are independently from each other C₁₋₃₀-alkyl optionally substituted with 1 to 4 substituents R^{h},
wherein
R^{h} at each occurrence are independently from each other selected from the group consisting of =O, =C(CN)₂, -O-C₂₋₆-alkylene-O-, halogen, -CN, -NO₂, -OH, C₁₋₁₀-alkoxy, -O-CH₂CH₂O-C₁₋₁₀-alkyl, -O-COR¹⁴, -S-C₁₋₁₀-alkyl, -NH₂, -NHR¹⁴, -NR¹⁴R¹⁵, -NH-COR¹⁴, -COOH, -COOR¹⁴, -CONH₂, -CONHR¹⁴, -CONR¹⁴R¹⁵, -CO-H, -COR¹⁴, C₃₋₁₀-cycloalkyl, monovalent 3 to 14 membered aliphatic heterocyclic residue, C₆₋₁₄-aryl and monovalent 5 to 14 membered aromatic heterocyclic residue;
q and s are independently from each other 1, 2 or 3,
r is 1 or 2,
and
n is an integer from 5 to 10'000.

In even most preferred units of formula (1)
R¹ and R² are independently from each other C₁₋₁₆-alkyl, more preferably C₁₋₁₂-alkyl,
G¹ and G² are independently from each other monocyclic bivalent 5 to 8 membered aromatic heterocyclic residue, wherein G¹ and G² are substituted with 1 to 2 substituents R^{a},
wherein
R^{a} at each occurrence are independently from each other C₆₋₂₀-alkyl,
L is bivalent 5 to 14 membered aromatic heterocyclic residue, wherein L is substituted with 1 to 2 substituents R^{b},
wherein
R^{b} at each occurrence are independently from each other C₆₋₂₀-alkyl,
q and s are both 1,
r is 1,
and
n is an integer from 5 to 10'000.

Particular preferred units of formula (1) are units of formula 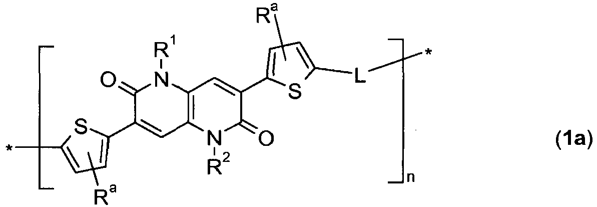 wherein R¹, R², R^{a}, L and n are as defined above.

In particular preferred units of formula (1a)
L is 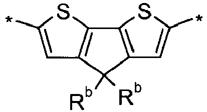 wherein R^{b} is as defined above.

Preferably, n is an integer from 5 to 5'000, more preferably from 5 to 1'000, even more preferably from 5 to 100, and most preferably from 10 to 100.

A particular preferred example of the units of formulae (1) and (**1a**) is the unit of formula 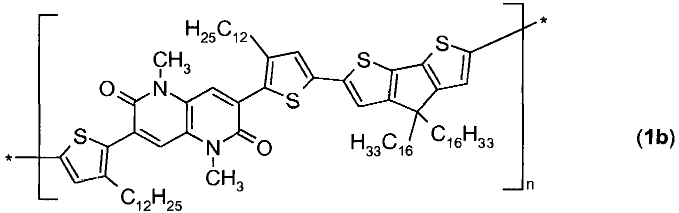 wherein n is an integer from 10 to 1000, preferably from 10 to 100.

The semiconducting material of the present invention can be a polymer comprising preferably at least 80% by weight, more preferably at least 90% by weight, of a unit of formula (1), respectively, (**1a**) based on the weight of the polymer.

Most preferably, the semiconducting material of the present invention is a polymer consisting essentially of a unit of formula (1), respectively, (1a).

The polymer comprising a unit of formula (1) can be prepared by treating a compound of formula 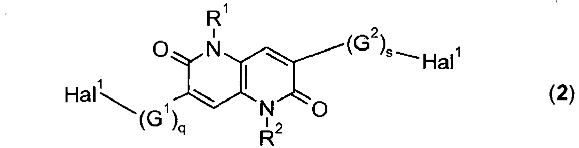 wherein R¹, R², G¹, G², q and s are as defined above, and Hal¹ is halogen, preferably -Br,
with a compound of formula 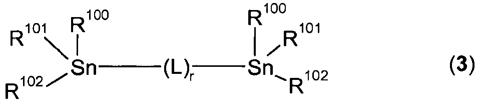 wherein L and q are as defined above, and R¹⁰⁰, R¹⁰¹ and R¹⁰² are independently from each other C₁₋₁₀-alkyl, preferably methyl.

in the presence of transition metal catalyst 1.

Transition metal catalyst 1 is preferably a palladium catalyst such tris(dibenzylideneacetone)-dipalladium(0), preferably in combination with a phosphine such as tri-o-tolylphosphine. The reaction is preferably performed at elevated temperatures such 80 to 200 °C, preferably 90 to 150 °C. The reaction can be performed in an inert organic solvent such as chlorobenzene. The reaction can be stopped by the addition of end cappers such as 2-bromothiophene and 2-thiophene boronic acid. The crude product may be worked up by conventional methods, for example by extracting the crude product with an appropriate solvent, for example with acetone.

The compound of formula (2) can be prepared by treating a compound of formula 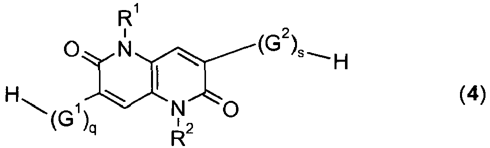 wherein R¹, R², G¹, G², q and s are as defined above,
with a halogenating agent.

The halogenating agent is preferably *N*-bromosuccinimide. The reaction is preferably performed at ambient temperatures such -5 to 50 °C, preferably 0 to 30 °C. The reaction can be performed in an organic solvent such chloroform. The crude product may be worked up by conventional methods, for example by column chromatography.

The compound of formula (4) can be prepared by reacting a compound of formula 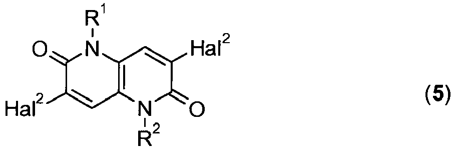 wherein R¹ and R² are as defined above,
with compounds of formulae 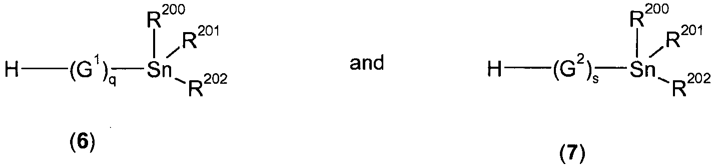 wherein G¹, G², q and s are as defined above, and R²⁰⁰, R²⁰¹ and R²⁰² are independently from each other C₁₋₁₀-alkyl, preferably methyl

in the presence of a transition metal catalyst 2.

Transition metal catalyst 2 is preferably a palladium catalyst such tetrakis(triphenylphosphine) palladium(0). The reaction is preferably performed at elevated temperatures such 80 to 200 °C, preferably 90 to 150 °C. The reaction can be performed in an inert organic solvent such as dimethylformamide. The crude product may be worked up by conventional methods, for example by column chromatography.

The compound of formula (5) can be prepared by treating a compound of formula 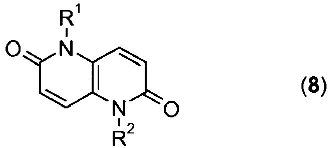 wherein R¹ and R² are as defined above,
with a halogenating agent.

The halogenating agent is preferably Br₂. The reaction is preferably performed at ambient temperatures such -5 to 30 °C, preferably 0 to 30 °C. The reaction can be performed in an organic solvent such dichloromethane. The crude product may be worked up by conventional methods.

The compound of formula (8) can be prepared according to following reaction scheme:

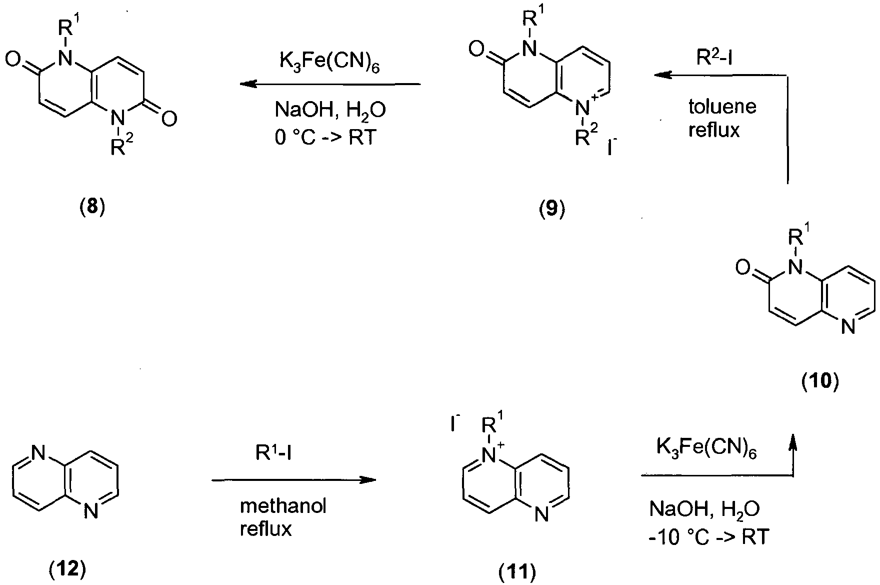

The compounds of formulae **(2), (4)** and **(5)** are also part of the invention.

Also part of the present invention is an electronic device comprising the polymer comprising a unit of formula (1) as semiconducting material. Preferably, the electronic device is an organic field effect transistor (OFET), and in particular a thin film transistor (TFT). Preferably, the electronic device is an organic photovoltaic device (OPV).

Usually, an organic field effect transistor comprises a dielectric layer, a semiconducting layer and a substrate. In addition, on organic field effect transistor usually comprises a gate electrode and source/drain electrodes.

An organic field effect transistor can have various designs.

The most common design of a field-effect transistor is the Bottom-Gate Top-Contact (BGTC) design. Here, the gate is on top of the substrate and at the bottom of the dielectric layer, the semiconducting layer is at the top of the dielectric layer and the source/drain electrodes are on top of the semiconducting layer.

Another design of a field-effect transistor is the Top-Gate Bottom-Contact (TGBC) design. Here, the source/drain electrodes are on top of the substrate and at the bottom of the semiconducting layer, the dielectric layer is on top of the semiconducting layer and the gate electrode is on top of the dielectric layer.

The semiconducting layer comprises the semiconducting material of the present invention. The semiconducting layer can have a thickness of 5 to 500 nm, preferably of 10 to 100 nm, more preferably of 20 to 50 nm.

The dielectric layer comprises a dielectric material. The dielectric material can be silicium/silicium dioxide, or, preferably, an organic polymer such as polystyrene (PS), poly(methylmethacrylate) (PMMA), poly(4-vinylphenol) (PVP), poly(vinyl alcohol) (PVA), anzocyclobutene (BCB), or polyimide (PI). The dielectric layer can have a thickness of 10 to 2000 nm, preferably of 50 to 1000 nm, more preferably of 100 to 800 nm.

The source/drain contacts and the gate contact can be made from any suitable material, for example Au.

The substrate can be any suitable substrate such as glass, or a plastic substrate. Preferably the substrate is a plastic substrate such as polyethersulfone, polycarbonate, polysulfone, polyethylene terephthalate (PET) and polyethylene naphthalate (PEN). More preferably, the plastic substrate is a plastic foil.

The organic field effect transistor can be prepared by methods known in the art.

For example, a top-gate bottom-contact (TGBC) thin film transistors (TFTs) can be prepared as follows: first: the source/drain contacts are placed on the substrate, for example by thermal evaporation of the source/drain material; second: the substrate is coated with the semiconducting layer, for example by spin-coating a solution of the semiconducting material in a suitable solvent and drying the semiconducting layer at elevated temperatures, for example at 80 to 100 °C; third: the semiconducting layer is coated with a solution of the dielectric material in a suitable solvent, for example by spin-coating a solution of the dielectric material and drying the dielectric layer at elevated temperatures, for example at 80 to 100 °C; fourth: the gate contact is placed on top of the dielectric layer, for example by thermal evaporation of the gate material.

Also part of the present invention is the use of the polymer comprising the unit of formula (1) as semiconducting material.

Electronic devices comprising the semiconducting materials of the present invention show high charge carrier mobility as well as high stability, in particular towards oxidation by air, under ambient environmental conditions.

In addition, the semiconducting materials of the present invention are compatible with liquid processing techniques such as spin coating and thus allow the production of low cost, light weight and flexible electronic devices.

### Examples

### Example 1

### Preparation of polymer P1 essentially consisting of units of formula (1b)

The polymer **P1** essentially consisting of units of formula **(1 b)** is prepared according to the following reaction scheme:

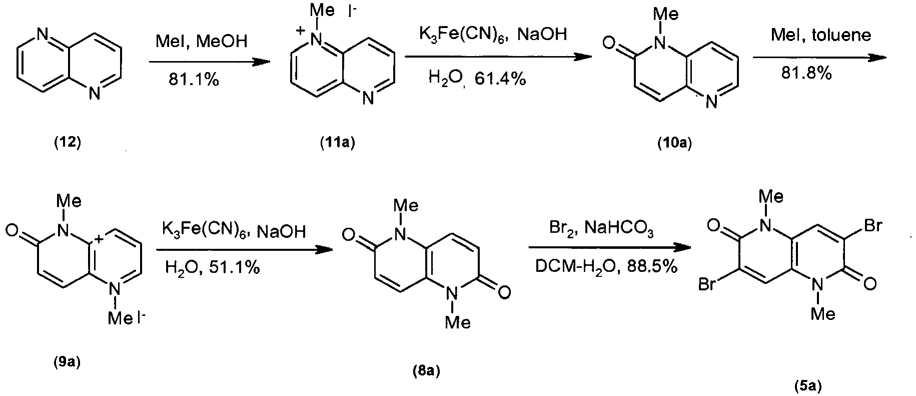

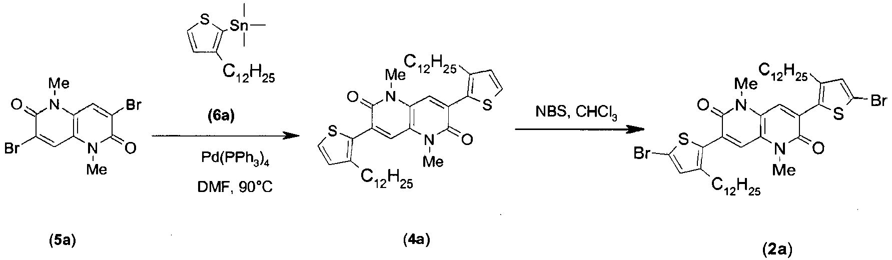

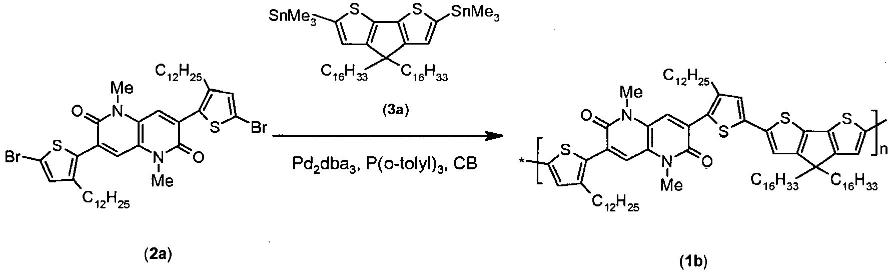

### Preparation of the compound of formula (11a)

Methyl iodide (10.9 g, 76.8 mmol) is added to a solution of 1,5-naphthyridine (12) (5 g, 38.4 mmol) in MeOH (30 mL) and the reaction mixture is heated at 40 °C over 3 days under N₂. The precipitate is filtered and dried under high vacuum to afford compound **11a** as yellowish green solid (8.51 g, 81.1 %). ¹H NMR (400 MHz, CDCl₃, r.t) δ 9.49 (d, 1 H), 9.38 (dd, 1 H), 9.26 (d, 1 H), 8.98 (dd, 1 H), 4.75 (s, 3H).

### Preparation of the compound of formula (10a)

NaOH solution (5.6 g, 140.2 mmol, in 30 mL H₂O) and K₃Fe(CN)₆ solution (21.6 g, 65.5 mmol, in 30 mL H₂O) are added concurrently over 30 min to a solution of napthyridine methiodide **(11a)** (8.5 g, 31.2 mmol) in H₂O (80 mL) at -10 °C. The reaction mixture is allowed to warm to RT overnight. Excess NaCl is added and the reaction mixture is then extracted with CHCl₃ (150 mL x 3). The combined organic phases are dried over Na₂SO₄, filtered and concentrated in *vacuo.* The crude product is purified by flash column using MeOH+1% TEA on silica gel to afford compound 10a as violet solid (3.07 g, 61.4 %). ¹H NMR (400 MHz, CD₃OD, r.t) δ 12.49 (d, 1 H), 12.00 (d, 1H), 11.91 (d, 1H), 11.59 (dd, 1H), 10.88 (d, 1H), 8.79 (s, 3H).

### Preparation of the compound of formula (9a)

Mel (3.58 mL, 57.5 mmol) is added to a solution of compound **10a** (3.07 g, 19.2 mmol) in toluene (50 mL) and the reaction mixture is allowed to stir at 115°C for 2 days. The reaction mixture is filtered and dried in *vacuo* to afford compound **9a** as green solid (4.75 g, 81.8 %). ¹H NMR (400 MHz, CD₃OD, r.t) δ 8.95 (d, 1 H), 8.79 (d, 1 H), 8.50 (dd, 1 H), 8.19 (dd, 1 H), 7.34 (d, 1 H), 4.63 (s, 3H), 3.87 (s, 3H).

### Preparation of the compound of formula (8a)

NaOH solution (4.39 g, 109.7 mmol, in 15 mL H₂O) and K₃Fe(CN)₆ solution (15.51 g, 47.1 mmol, in 50 mL of water) are added concurrently over 30 min to a solution of methyl-napthyridine methiodide **9a** (4.75 g, 15.7 mmol) in H₂O (25 mL) at 0 °C. The reaction mixture is allowed to stir at 0 °C for 30 min and is then allowed to warm to RT overnight. Excess NaCl is added followed by extraction with CHCl₃ (100 mL x 3). The combined organic phases are dried over Na₂SO₄ and concentrated in *vacuo.* Recrystallization in MeOH/Acetone mixture afforded compound **8a** as orange brown crystals (1.52 g, 51.1 %). ¹H NMR (400 MHz, CD₃OD, r.t) δ 8.04 (d, 2H), 6.92 (d, 2H), 4.87 (s, 3 H), 3.80 (s, 3H).

### Preparation of the compound of formula (5a)

1,5-dimethylnapthyridine-dione **8a** (1.35 g, 7.08 mmol), NaHCO₃ (2.38 g, 28.3 mmol) and bromine (2.83 g, 17.1 mmol) are dissolved in dichloromethane/H₂O mixture (1:1, 200 mL) at 0 °C and allowed to warm to RT overnight. The reaction mixture is filtered and washed with MeOH. Saturated sodium thiosulfate (aq) is added to the filtrate and the aqueous phase is extracted with dichloromethane (200 mL x 3). The combined organic phases are dried over Na₂SO₄ and concentrated in *vacuo.* The combined solids are dispersed in methanol, subjected to 3 cycles of sonication, followed by centrifugation and decantation to yield yellow compound **5a** (2.18 g, 88.5 %). ¹H NMR (400 MHz, DMSO, r.t) δ 8.36 (s, 2H), 3.72 (s, 6H).

### Preparation of the compound of formula (4a)

Pd(PPh₃)₄ (0.11 g, 0.10 mmol) is added to a solution of compound **5a** (0.68 g, 1.97 mmol) and compounds **6a** (2.45 g, 5.90 mmol) in degassed dimethylformamide (23 mL). The reaction mixture is heated to 130 °C and stirred overnight. The reaction mixture is allowed to cool to RT, washed with H₂O (25 mL), extracted with CH₂Cl₂ (25 mL x 3), dried over Na₂SO₄ and concentrated. The residue is purified by flash column (0 → 100% ethyl acetate/hexane) to afford compound **4a** as red solid (0.42 g, 31%). ¹H NMR (400 MHz, CDCl₃, r.t) δ 7.71 (s, 2H), 7.42 (d, 2H), 7.04 (d, 2H), 3.82 (s, 6H), 2.73 (t, 4H), 1.67 - 1.48 (m, 35H), 0.87 - 0.85 (m, 11 H).

### Preparation of the compound of formula (2a)

*N*-bromosuccinimide (0.17 g, 0.97 mmol) is added to a solution of compound **4a** (0.32 g, 0.46 mmol) in CHCl₃ (32 mL) at 0 °C. The temperature of the reaction mixture is allowed to slowly rise to RT and the reaction mixture is stirred overnight. The reaction mixture is quenched with H₂O (50 mL), extracted with CHCl₃ (50 mL x 3), washed with brine, dried over Na₂SO₄ and concentrated. Crude compound **2a** is purified by flash column (0 → 50% ethyl acetate/hexane) to afford compound **2a** as red solid (0.46 g, 88%). ¹H NMR (400 MHz, CDCl₃, r.t) δ 7.68 (s, 2H), 6.98 (s, 2H), 3.80 (s, 6H), 2.69 (t, 4H), 1.68 - 1.56 (m, 35H), 0.88 - 0.84 (m, 11 H).

### Preparation of polymer P1 essentially consisting of units of formula (1 b)

Compound **2a** (100 mg, 0.12 mmol), compound **3a** (112 mg, 0.12 mmol), Pd₂dba₃ (5.4 mg, 0.006 mmol) and P(o-tolyl)₃ (3.6 mg, 0.01 mmol) are added to a Schlenk tube and degassed 3 times with nitrogen. Chlorobenzene (3 mL) is then added and the reaction mixture is heated under N₂ at 130 °C. After 2 days, 1 drop of 2-bromothiophene is added and the reaction mixture is allowed to stir for 1 h. 1 drop of 2-(tributylstannyl)thiophene is added and the reaction mixture is allowed to stir at 130 °C overnight. The reaction mixture is poured slowly into 500 mL of MeOH. The mixture is stirred for 2 h. The precipitate obtained is filtered and subjected to Soxhlet extraction with acetone overnight. The filtrate is dried under *vacuo,* dissolved in minimum amount of hot chlorobenzene and precipitated again by pouring it into beaker with methanol. The mixture is stirred for 1 h, filtered and the filtrate is dried under vacuum overnight to afforded polymer P1 as red solid (36 mg, 23 %). ¹H NMR (400 MHz, DCE, r.t) δ 7.72 (brs, 2 H), 7.22-7.12 (m, 4H), 3.83 (brs, 6 H), 2.80 (brs, 4H), 1.79 - 0.85 (m, 112H). Mn: 1.24 x 10⁴, PDI: 2.53.

### Example 2

### Preparation of top-gate bottom-contact transistors (TGBC) containing the polymer P1, essentially consisting of the units of formula 1 b, as semiconducting material

A top-gate bottom-contact (TGBC) thin film transistor (TFT) is fabricated on glass (PGO glass used as received). Au source-drain contacts (30 nm-thick) are thermally-evaporated. The substrate is then coated with the semiconductor layer (thickness: 40 to 50 nm) by spin-coating (1000 rpm) a solution of polymer **P1** (prepared as described in example 1) in dichloromethane (concentration ~ 10 mg/mL), and drying the film at 90 °C for 30 seconds. A 4 weight% polystyrene solution in isopropyl acetate is spin-coated (3600 rpm) and the dielectric film formed is dried at 90 °C for 30 seconds to yield a dielectric layer (thickness: 500 to 600 nm). The device structure is completed by vapor deposition of patterned Au gate contacts (∼30 nm thick) through a shadow mask. Channel lengths and widths are 50 µm and 0.5 mm, respectively, to afford W/L = 10.

The top-gate, bottom-contact (TGBC) thin film transistors of example 2 show the following mobility: 4 × 10⁻³ cm²V⁻¹s⁻¹.

## Claims

1. A polymer comprising a unit of formula 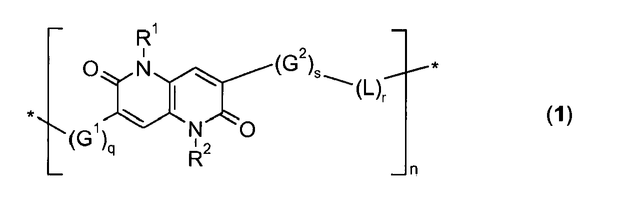 wherein
R¹ and R² are independently from each other H, C₁₋₃₀-alkyl optionally substituted with 1 to 6 substituents R^{c}, C₂₋₃₀-alkenyl optionally substituted with 1 to 6 substituents R^{c}, C₂₋₃₀-alkynyl optionally substituted with 1 to 6 substituents R^{c}, C₃₋₁₀-cycloalkyl optionally substituted with 1 to 6 substituents R^{d}, C₅₋₁₀-cycloalkenyl optionally substituted with 1 to 6 substituents R^{d}, monovalent 3 to 14 membered aliphatic heterocyclic residue optionally substituted with 1 to 6 substituents R^{d}, C₆₋₁₄-aryl optionally substituted with 1 to 6 substituents R^{e} or monovalent 5 to14 membered aromatic heterocyclic residue optionally substituted with 1 to 6 substituents R^{e},
wherein
R^{c} at each occurrence are independently from each other selected from the group consisting of =O, =C(CN)₂, -O-C₂₋₆-alkylene-O-, halogen, -CN, -NO₂, -OH, C₁₋₁₀-alkoxy, -O-CH₂CH₂O-C₁₋₁₀-alkyl, -O-COR³, -S-C₁₋₁₀-alkyl, -NH₂, -NHR³, -NR³R⁴, -NH-COR³, -COOH, -COOR³, -CONH₂, -CONHR³, -CONR³R⁴, -CO-H, -COR³, C₃₋₁₀-cycloalkyl, monovalent 3 to 14 membered aliphatic heterocyclic residue, C₆₋₁₄-aryl and monovalent 5 to 14 membered aromatic heterocyclic residue;
R^{d} at each occurrence are independently from each other selected from the group consisting of =O, =C(CN)₂, -O-C₂₋₆-alkylene-O-, halogen, -CN, -NO₂, -OH, C₁₋₁₀-alkoxy, -O-CH₂CH₂O-C₁₋₁₀-alkyl, -O-COR³, -S-C₁₋₁₀-alkyl, -NH₂, -NHR³, -NR³R⁴, -NH-COR³, -COOH, -COOR³, -CONH₂, -CONHR³, -CONR³R⁴, -CO-H, -COR³, C₁₋₁₀-alkyl, C₂₋₁₀-alkenyl, C₂₋₁₀-alkynyl, C₆₋₁₄-aryl and monovalent 5 to 14 membered aromatic heterocyclic residue;
Re at each occurrence are independently from each other selected from the group consisting of =O, =C(CN)₂, -O-C₂₋₆-alkylene-O-, halogen, -CN, -NO₂, -OH, C₁₋₁₀-alkoxy, -O-CH₂CH₂O-C₁₋₁₀-alkyl, -O-COR³, -S-C₁₋₁₀-alkyl, -NH₂, -NHR³, -NR³R⁴, -NH-COR³, -COOH, -COOR³, -CONH₂, -CONHR³, -CONR³R⁴, -CO-H, -COR³, C₁₋₁₀-alkyl, C₂₋₁₀-alkenyl, C₂₋₁₀-alkynyl, C₃₋₁₀-cycloalkyl, C₅₋₁₀-cycloalkenyl and monovalent 3 to 14 membered aliphatic heterocyclic residue,
wherein R³ and R⁴ at each occurrence are independently from each other selected from the group consisting of C₁₋₁₀-alkyl, C₂₋₁₀-alkenyl, C₂₋₁₀-alkynyl, C₃₋₁₀-cycloalkyl, C₅₋₁₀-cycloalkenyl, monovalent 3 to 14 membered aliphatic heterocyclic residue, C₆₋₁₄-aryl and monovalent 5 to 14 membered aromatic heterocyclic residue,
G¹ and G² are independently from each other C₆₋₁₄-arylene optionally substituted with 1 to 6 substituents R^{a} or bivalent 5 to 14 membered aromatic heterocyclic residue optionally substituted with 1 to 6 substituents R^{a},
wherein
R^{a} at each occurrence are independently from each other selected from the group consisting of =O, =C(CN)₂, -O-C₂₋₆-alkylene-O-, halogen, -CN, -NO₂, -OH, C₁₋₃₀-alkoxy, -O-CH₂CH₂O-C₁₋₃₀-alkyl, -O-COR⁸, -S-C₁₋₃₀-alkyl, -NH₂, -NHR⁸, -NR⁸R⁹, -NH-COR⁸, -COOH, -COOR⁸, -CONH₂, -CONHR⁸, -CONR⁸R⁹, -CO-H, -COR⁸, C₁₋₃₀-alkyl optionally substituted with 1 to 6 substituents R^{f}, C₂₋₃₀-alkenyl optionally substituted with 1 to 6 substituents R^{f}, C₂₋₃₀-alkynyl optionally substituted with 1 to 6 substituents R^{f}, C₃₋₁₀-cycloalkyl optionally substituted with 1 to 6 substituents R^{g}, C₅₋₁₀-cycloalkenyl optionally substituted with 1 to 6 substituents R^{g} and monovalent 3 to 14 membered aliphatic heterocyclic residue optionally substituted with 1 to 6 substituents R^{g},
wherein
R⁸ and R⁹ at each occurrence are independently from each other selected from the group consisting of C₁₋₃₀-alkyl, C₂₋₃₀-alkenyl, C₂₋₃₀-alkynyl, C₃₋₁₀-cycloalkyl, C₅₋₁₀-cycloalkenyl, monovalent 3 to 14 membered aliphatic heterocyclic residue, C₆₋₁₄-aryl and monovalent 5 to14 membered aromatic heterocyclic residue,
R^{f} at each occurrence are independently from each other selected from the group consisting of =O, =C(CN)₂, -O-C₂₋₆-alkylene-O-, halogen, -CN, -NO₂, -OH, C₁₋₁₀-alkoxy, -O-CH₂CH₂O-C₁₋₁₀-alkyl, -O-COR¹⁰, -S-C₁₋₁₀-alkyl, -NH₂, -NHR¹⁰, -NR¹⁰R¹¹, -NH-COR¹⁰, -COOH, -COOR¹⁰, -CONH₂, -CONHR¹⁰, -CONR¹⁰R¹¹, -CO-H, -COR¹⁰, C₃₋₁₀-cycloalkyl, monovalent 3 to 14 membered aliphatic heterocyclic residue, C₆₋₁₄-aryl and monovalent 5 to 14 membered aromatic heterocyclic residue;
R^{g} at each occurrence are independently from each other selected from the group consisting of =O, =C(CN)₂, -O-C₂₋₆-alkylene-O-, halogen, -CN, -NO₂, -OH, C₁₋₁₀-alkoxy, -O-CH₂CH₂O-C₁₋₁₀-alkyl, -O-COR¹⁰, -S-C₁₋₁₀-alkyl, -NH₂, -NHR¹⁰, -NR¹⁰R¹¹, -NH-COR¹⁰, -COOH, -COOR¹⁰, -CONH₂, -CONHR¹⁰, -CONR¹⁰R¹¹, -CO-H, -COR¹⁰, C₁₋₁₀-alkyl, C₂₋₁₀-alkenyl, C₂₋₁₀-alkynyl, C₆₋₁₄-aryl and monovalent 5 to 14 membered aromatic heterocyclic residue;
wherein R¹⁰ and R¹¹ at each occurrence are independently from each other selected from the group consisting of C₁₋₁₀-alkyl, C₂₋₁₀-alkenyl, C₂₋₁₀-alkynyl, C₃₋₁₀-cycloalkyl, C₅₋₁₀-cycloalkenyl, monovalent 3 to 14 membered aliphatic heterocyclic residue, C₆₋₁₄-aryl and monovalent 5 to14 membered aromatic heterocyclic residue,
or
G¹ and G² are independently from each other 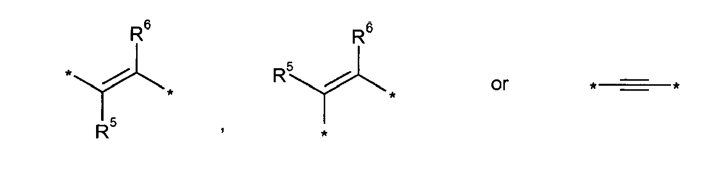 wherein
R⁵ and R⁶ are independently from each other H or C₁₋₃₀-alkyl,
L is C₆₋₂₄-arylene optionally substituted with 1 to 6 substituents R^{b} or bivalent 5 to 24 membered aromatic heterocyclic residue optionally substituted with 1 to 6 substituents R^{b},
wherein
R^{b} at each occurrence are independently from each other selected from the group consisting of =O, =C(CN)₂, -O-C₂₋₆-alkylene-O-, halogen, -CN, -NO₂, -OH, C₁₋₃₀-alkoxy, -O-CH₂CH₂O-C₁₋₃₀-alkyl, -O-COR¹², -S-C₁₋₃₀-alkyl, -NH₂, -NHR¹², -NR¹²R¹³, -NH-COR¹², -COOH, -COOR¹², -CONH₂, -CONHR¹², -CONR¹²R¹³, -CO-H, -COR¹², C₁₋₃₀-alkyl optionally substituted with 1 to 6 substituents R^{h}, C₂₋₃₀-alkenyl optionally substituted with 1 to 6 substituents R^{h}, C₂₋₃₀-alkynyl optionally substituted with 1 to 6 substituents R^{h}, C₃₋₁₀-cycloalkyl optionally substituted with 1 to 6 substituents Rⁱ, C₅₋₁₀-cycloalkenyl optionally substituted with 1 to 6 substituents Rⁱ and monovalent 3 to 14 membered aliphatic heterocyclic residue optionally substituted with 1 to 6 substituents Rⁱ,
wherein
R¹² and R¹³ at each occurrence are independently from each other selected from the group consisting of C₁₋₃₀-alkyl, C₂₋₃₀-alkenyl, C₂₋₃₀-alkynyl, C₃₋₁₀-cycloalkyl, C₅₋₁₀-cycloalkenyl, monovalent 3 to 14 membered aliphatic heterocyclic residue, C₆₋₁₄-aryl and monovalent 5 to14 membered aromatic heterocyclic residue,
R^{h} at each occurrence are independently from each other selected from the group consisting of =O, =C(CN)₂, -O-C₂₋₆-alkylene-O-, halogen, -CN, -NO₂, -OH, C₁₋₁₀-alkoxy, -O-CH₂CH₂O-C₁₋₁₀-alkyl, -O-COR¹⁴, -S-C₁₋₁₀-alkyl, -NH₂, -NHR¹⁴, -NR¹⁴R¹⁵, -NH-COR¹⁴, -COOH, -COOR¹⁴, -CONH₂, -CONHR¹⁴, -CONR¹⁴R¹⁵, -CO-H, -COR¹⁴, C₃₋₁₀-cycloalkyl, monovalent 3 to 14 membered aliphatic heterocyclic residue, C₆₋₁₄-aryl and monovalent 5 to 14 membered aromatic heterocyclic residue;
Rⁱ at each occurrence are independently from each other selected from the group consisting of =O, =C(CN)₂, -O-C₂₋₆-alkylene-O-, halogen, -CN, -NO₂, -OH, C₁₋₁₀-alkoxy, -O-CH₂CH₂O-C₁₋₁₀-alkyl, -O-COR¹⁴, -S-C₁₋₁₀-alkyl, -NH₂, -NHR¹⁴, -NR¹⁴R¹⁵, -NH-COR¹⁴, -COOH, -COOR¹⁴, -CONH₂, -CONHR¹⁴, -CONR¹⁴R¹⁵, -CO-H, -COR¹⁴, C₁₋₁₀-alkyl, C₂₋₁₀-alkenyl, C₂₋₁₀-alkynyl, C₆₋₁₄-aryl and monovalent 5 to 14 membered aromatic heterocyclic residue;
wherein R¹⁴ and R¹⁵ at each occurrence are independently from each other selected from the group consisting of C₁₋₁₀-alkyl, C₂₋₁₀-alkenyl, C₂₋₁₀-alkynyl, C₃₋₁₀-cycloalkyl, C₅₋₁₀-cycloalkenyl, monovalent 3 to 14 membered aliphatic heterocyclic residue, C₆₋₁₄-aryl and monovalent 5 to14 membered aromatic heterocyclic residue,
or
L is 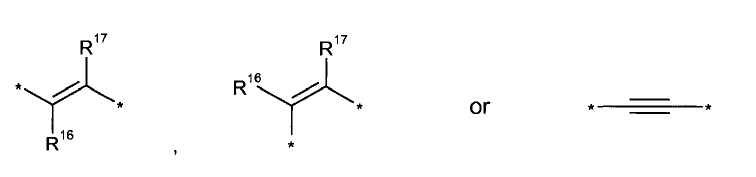 wherein
R¹⁶ and R¹⁷ are independently from each other H, C₁₋₃₀-alkyl, -CN or halogen,
q and s are independently from each other 0, 1, 2, 3, 4 or 5,
r is 0, 1 or 2,
and
n is an integer from 2 to 10'000.

2. The polymer of claim 1, wherein
R¹ and R² are independently from each other H, C₁₋₃₀-alkyl optionally substituted with 1 to 6 substituents R^{c}, C₂₋₃₀-alkenyl optionally substituted with 1 to 6 substituents R^{c}, C₂₋₃₀-alkynyl optionally substituted with 1 to 6 substituents R^{c}, C₃₋₁₀-cycloalkyl optionally substituted with 1 to 6 substituents R^{d}, C₅₋₁₀-cycloalkenyl or C₆₋₁₄-aryl optionally substituted with 1 to 6 substituents Re,
wherein
R^{c} at each occurrence are independently from each other selected from the group consisting of =O, =C(CN)₂, -O-C₂₋₆-alkylene-O-, halogen, -CN, -NO₂, -OH, C₁₋₁₀-alkoxy, -O-CH₂CH₂O-C₁₋₁₀-alkyl, -O-COR³, -S-C₁₋₁₀-alkyl, -NH₂, -NHR³, -NR³R⁴, -NH-COR³, -COOH, -COOR³, -CONH₂, -CONHR³, -CONR³R⁴, -CO-H, -COR³, C₃₋₁₀-cycloalkyl, monovalent 3 to 14 membered aliphatic heterocyclic residue, C₆₋₁₄-aryl and monovalent 5 to 14 membered aromatic heterocyclic residue;
R^{d} at each occurrence are independently from each other selected from the group consisting of =O, =C(CN)₂, -O-C₂₋₆-alkylene-O-, halogen, -CN, -NO₂, -OH, C₁₋₁₀-alkoxy, -O-CH₂CH₂O-C₁₋₁₀-alkyl, -O-COR³, -S-C₁₋₁₀-alkyl, -NH₂, -NHR³, -NR³R⁴, -NH-COR³, -COOH, -COOR³, -CONH₂, -CONHR³, -CONR³R⁴, -CO-H, -COR³, C₁₋₁₀-alkyl, C₂₋₁₀-alkenyl, C₂₋₁₀-alkynyl, C₆₋₁₄-aryl and monovalent 5 to 14 membered aromatic heterocyclic residue;
Re at each occurrence are independently from each other selected from the group consisting of =O, =C(CN)₂, -O-C₂₋₆-alkylene-O-, halogen, -CN, -NO₂, -OH, C₁₋₁₀-alkoxy, -O-CH₂CH₂O-C₁₋₁₀-alkyl, -O-COR³, -S-C₁₋₁₀-alkyl, -NH₂, -NHR³, -NR³R⁴, -NH-COR³, -COOH, -COOR³, -CONH₂, -CONHR³, -CONR³R⁴, -CO-H, -COR³, C₁₋₁₀-alkyl, C₂₋₁₀-alkenyl, C₂₋₁₀-alkynyl, C₃₋₁₀-cycloalkyl, C₅₋₁₀-cycloalkenyl and monovalent 3 to 14 membered aliphatic heterocyclic residue,
wherein R³ and R⁴ at each occurrence are independently from each other selected from the group consisting of C₁₋₁₀-alkyl, C₂₋₁₀-alkenyl, C₂₋₁₀-alkynyl, C₃₋₁₀-cycloalkyl, C₅₋₁₀-cycloalkenyl, monovalent 3 to 14 membered aliphatic heterocyclic residue, C₆₋₁₄-aryl and monovalent 5 to 14 membered aromatic heterocyclic residue.

3. The polymer of claim 1, wherein
R¹ and R² are independently from each other C₁₋₃₀-alkyl optionally substituted with 1 to 6 substituents R^{c},
wherein
R^{c} at each occurrence are independently from each other selected from the group consisting of =O, =C(CN)₂, -O-C₂₋₆-alkylene-O-, halogen, -CN, -NO₂, -OH, C₁₋₁₀-alkoxy, -O-CH₂CH₂O-C₁₋₁₀-alkyl, -O-COR³, -S-C₁₋₁₀-alkyl, -NH₂, -NHR³, -NR³R⁴, -NH-COR³, -COOH, -COOR³, -CONH₂, -CONHR³, -CONR³R⁴, -CO-H, -COR³, C₃₋₁₀-cycloalkyl, monovalent 3 to 14 membered aliphatic heterocyclic residue, C₆₋₁₄-aryl and monovalent 5 to 14 membered aromatic heterocyclic residue;
wherein R³ and R⁴ at each occurrence are independently from each other selected from the group consisting of C₁₋₁₀-alkyl, C₂₋₁₀-alkenyl, C₂₋₁₀-alkynyl, C₃₋₁₀-cycloalkyl, C₅₋₁₀-cycloalkenyl, monovalent 3 to 14 membered aliphatic heterocyclic residue, C₆₋₁₄-aryl and monovalent 5 to 14 membered aromatic heterocyclic residue.

4. The polymer of claim 1, wherein
R¹ and R² are independently from each other C₁₋₁₆-alkyl, more preferably C₁₋₁₂-alkyl.

5. The polymer of any of claims 1 to 4, wherein
G¹ and G² are independently from each other bivalent 5 to 14 membered aromatic heterocyclic residue optionally substituted with 1 to 6 substituents R^{a},
wherein
R^{a} at each occurrence are independently from each other selected from the group consisting of =O, =C(CN)₂, -O-C₂₋₆-alkylene-O-, halogen, -CN, -NO₂, -OH, C₁₋₃₀-alkoxy, -O-CH₂CH₂O-C₁₋₃₀-alkyl, -O-COR⁸, -S-C₁₋₃₀-alkyl, -NH₂, -NHR⁸, -NR⁸R⁹, -NH-COR⁸, -COOH, -COOR⁸, -CONH₂, -CONHR⁸, -CONR⁸R⁹, -CO-H, -COR⁸, C₁₋₃₀-alkyl optionally substituted with 1 to 6 substituents R^{f}, C₂₋₃₀-alkenyl optionally substituted with 1 to 6 substituents R^{f}, C₂₋₃₀-alkynyl optionally substituted with 1 to 6 substituents R^{f}, C₃₋₁₀-cycloalkyl optionally substituted with 1 to 6 substituents R^{g}, C₅₋₁₀-cycloalkenyl optionally substituted with 1 to 6 substituents R^{g} and monovalent 3 to 14 membered aliphatic heterocyclic residue optionally substituted with 1 to 6 substituents R^{g},
wherein
R⁸ and R⁹ at each occurrence are independently from each other selected from the group consisting of C₁₋₃₀-alkyl, C₂₋₃₀-alkenyl, C₂₋₃₀-alkynyl, C₃₋₁₀-cycloalkyl, C₅₋₁₀-cycloalkenyl, monovalent 3 to 14 membered aliphatic heterocyclic residue, C₆₋₁₄-aryl and monovalent 5 to14 membered aromatic heterocyclic residue,
R^{f} at each occurrence are independently from each other selected from the group consisting of =O, =C(CN)₂, -O-C₂₋₆-alkylene-O-, halogen, -CN, -NO₂, -OH, C₁₋₁₀-alkoxy, -O-CH₂CH₂O-C₁₋₁₀-alkyl, -O-COR¹⁰, -S-C₁-₁₀-alkyl, -NH₂, -NHR¹⁰, -NR¹⁰R¹¹, -NH-COR¹⁰, -COOH, -COOR¹⁰, -CONH₂, -CONHR¹⁰, -CONR¹⁰R¹¹, -CO-H, -COR¹⁰, C₃₋₁₀-cycloalkyl, monovalent 3 to 14 membered aliphatic heterocyclic residue, C₆₋₁₄-aryl and monovalent 5 to 14 membered aromatic heterocyclic residue;
R^{g} at each occurrence are independently from each other selected from the group consisting of =O, =C(CN)₂, -O-C₂₋₆-alkylene-O-, halogen, -CN, -NO₂, -OH, C₁₋₁₀-alkoxy, -O-CH₂CH₂O-C₁₋₁₀-alkyl, -O-COR¹⁰, -S-C₁-₁₀-alkyl, -NH₂, -NHR¹⁰, -NR¹⁰R¹¹, -NH-COR¹⁰, -COOH, -COOR¹⁰, -CONH₂, -CONHR¹⁰, -CONR¹⁰R¹¹, -CO-H, -COR¹⁰, C₁₋₁₀-alkyl, C₂₋₁₀-alkenyl, C₂₋₁₀-alkynyl, C₆₋₁₄-aryl and monovalent 5 to 14 membered aromatic heterocyclic residue;
wherein R¹⁰ and R¹¹ at each occurrence are independently from each other selected from the group consisting of C₁₋₁₀-alkyl, C₂₋₁₀-alkenyl, C₂₋₁₀-alkynyl, C₃₋₁₀-cycloalkyl, C₅₋₁₀-cycloalkenyl, monovalent 3 to 14 membered aliphatic heterocyclic residue, C₆₋₁₄-aryl and monovalent 5 to14 membered aromatic heterocyclic residue,
or
G¹ and G² are independently from each other 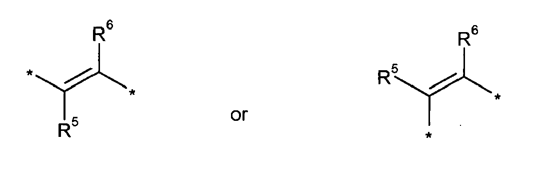 wherein
R⁵ and R⁶ are independently from each other H or C₁₋₃₀-alkyl.

6. The polymer of any of claims 1 to 4, wherein
G¹ and G² are independently from each other monocyclic bivalent 5 to 8 membered aromatic heterocyclic residue optionally substituted with 1 to 4 substituents R^{a},
wherein
R^{a} at each occurrence are independently from each other C₁₋₃₀-alkyl optionally substituted with 1 to 4 substituents R^{f},
wherein
R^{f} at each occurrence are independently from each other selected from the group consisting of =O, =C(CN)₂, -O-C₂₋₆-alkylene-O-, halogen, -CN, -NO₂, -OH, C₁₋₁₀-alkoxy, -O-CH₂CH₂O-C₁₋₁₀-alkyl, -O-COR¹⁰, -S-C₁-₁₀-alkyl, -NH₂, -NHR¹⁰, -NR¹⁰R¹¹, -NH-COR¹⁰, -COOH, -COOR¹⁰, -CONH₂, -CONHR¹⁰, -CONR¹⁰R¹¹, -CO-H, -COR¹⁰, C₃₋₁₀-cycloalkyl, monovalent 3 to 14 membered aliphatic heterocyclic residue, C₆₋₁₄-aryl and monovalent 5 to 14 membered aromatic heterocyclic residue.

7. The polymer of any of claims 1 to 4, wherein
G¹ and G² are independently from each other monocyclic bivalent 5 to 8 membered aromatic heterocyclic residue, wherein G¹ and G² are substituted with 1 to 2 substituents R^{a},
wherein
R^{a} at each occurrence are independently from each other C₆₋₂₀-alkyl.

8. The polymer of any of claims 1 to 7, wherein
L is bivalent 5 to 24 membered aromatic heterocyclic residue optionally substituted with 1 to 6 substituents R^{b},
wherein
R^{b} at each occurrence are independently from each other selected from the group consisting of =O, =C(CN)₂, -O-C₂₋₆-alkylene-O-, halogen, -CN, -NO₂, -OH, C₁₋₃₀-alkoxy, -O-CH₂CH₂O-C₁₋₃₀-alkyl, -O-COR¹², -S-C₁₋₃₀-alkyl, -NH₂, -NHR¹², -NR¹²R¹³, -NH-COR¹², -COOH, -COOR¹², -CONH₂, -CONHR¹², -CONR¹²R¹³, -CO-H, -COR¹², C₁₋₃₀-alkyl optionally substituted with 1 to 6 substituents R^{h}, C₂₋₃₀-alkenyl optionally substituted with 1 to 6 substituents R^{h}, C₂₋₃₀-alkynyl optionally substituted with 1 to 6 substituents R^{h}, C₃₋₁₀-cycloalkyl optionally substituted with 1 to 6 substituents Rⁱ, C₅₋₁₀-cycloalkenyl optionally substituted with 1 to 6 substituents Rⁱ and monovalent 3 to 14 membered aliphatic heterocyclic residue optionally substituted with 1 to 6 substituents Rⁱ,
wherein
R¹² and R¹³ at each occurrence are independently from each other selected from the group consisting of C₁₋₃₀-alkyl, C₂₋₃₀-alkenyl, C₂₋₃₀-alkynyl, C₃₋₁₀-cycloalkyl, C₅₋₁₀-cycloalkenyl, monovalent 3 to 14 membered aliphatic heterocyclic residue, C₆₋₁₄-aryl and monovalent 5 to14 membered aromatic heterocyclic residue,
R^{h} at each occurrence are independently from each other selected from the group consisting of =O, =C(CN)₂, -O-C₂₋₆-alkylene-O-, halogen, -CN, -NO₂, -OH, C₁₋₁₀-alkoxy, -O-CH₂CH₂O-C₁₋₁₀-alkyl, -O-COR¹⁴, -S-C₁₋₁₀-alkyl, -NH₂, -NHR¹⁴, -NR¹⁴R¹⁵, -NH-COR¹⁴, -COOH, -COOR¹⁴, -CONH₂, -CONHR¹⁴, -CONR¹⁴R¹⁵, -CO-H, -COR¹⁴, C₃₋₁₀-cycloalkyl, monovalent 3 to 14 membered aliphatic heterocyclic residue, C₆₋₁₄-aryl and monovalent 5 to 14 membered aromatic heterocyclic residue;
Rⁱ at each occurrence are independently from each other selected from the group consisting of =O, =C(CN)₂, -O-C₂₋₆-alkylene-O-, halogen, -CN, -NO₂, -OH, C₁₋₁₀-alkoxy, -O-CH₂CH₂O-C₁₋₁₀-alkyl, -O-COR¹⁴, -S-C₁₋₁₀-alkyl, -NH₂, -NHR¹⁴, -NR¹⁴R¹⁵, -NH-COR¹⁴, -COOH, -COOR¹⁴, -CONH₂, -CONHR¹⁴, -CONR¹⁴R¹⁵, -CO-H, -COR¹⁴, C₁₋₁₀-alkyl, C₂₋₁₀-alkenyl, C₂₋₁₀-alkynyl, C₆₋₁₄-aryl and monovalent 5 to 14 membered aromatic het-erocyclic residue;
wherein R¹⁴ and R¹⁵ at each occurrence are independently from each other selected from the group consisting of C₁₋₁₀-alkyl, C₂₋₁₀-alkenyl, C₂₋₁₀-alkynyl, C₃₋₁₀-cycloalkyl, C₅₋₁₀-cycloalkenyl, monovalent 3 to 14 membered aliphatic heterocyclic residue, C₆₋₁₄-aryl and monovalent 5 to14 membered aromatic heterocyclic residue,
or
L is 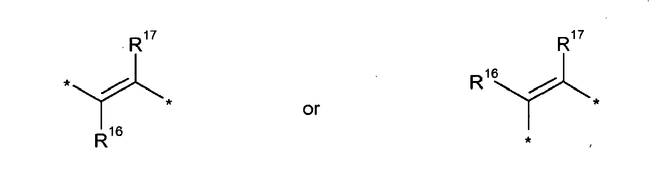 wherein
R¹⁶ and R¹⁷ are independently from each other H, C₁₋₃₀-alkyl, -CN or halogen.

9. A polymer of any of claims 1 to 7, wherein
L is bivalent 5 to 14 membered aromatic heterocyclic residue optionally substituted with 1 to 4 substituents R^{b},
wherein
R^{b} at each occurrence are independently from each other C₁₋₃₀-alkyl optionally substituted with 1 to 4 substituents R^{h},
wherein
R^{h} at each occurrence are independently from each other selected from the group consisting of =O, =C(CN)₂, -O-C₂₋₆-alkylene-O-, halogen, -CN, -NO₂, -OH, C₁₋₁₀-alkoxy, -O-CH₂CH₂O-C₁₋₁₀-alkyl, -O-COR¹⁴, -S-C₁₋₁₀-alkyl, -NH₂, -NHR¹⁴, -NR¹⁴R¹⁵, -NH-COR¹⁴, -COOH, -COOR¹⁴, -CONH₂, -CONHR¹⁴, -CONR¹⁴R¹⁵, -CO-H, -COR¹⁴, C₃₋₁₀-cycloalkyl, monovalent 3 to 14 membered aliphatic heterocyclic residue, C₆₋₁₄-aryl and monovalent 5 to 14 membered aromatic heterocyclic residue.

10. A polymer of any of claims 1 to 7, wherein
L is bivalent 5 to 14 membered aromatic heterocyclic residue, wherein L is substituted with 1 to 2 substituents R^{b},
wherein
R^{b} at each occurrence are independently from each other C₆₋₂₀-alkyl.

11. A polymer of any of claims 1 to 10, wherein
q and s are independently from each other 1, 2 or 3,
r is 1 or 2,
and
n is an integer from 5 to 10'000.

12. A polymer of claim 11, wherein
q and s are both 1,
r is 1,
and
n is an integer from 5 to 10'000.

13. A polymer of claim 1, wherein the unit of formula (1) is a unit of formula 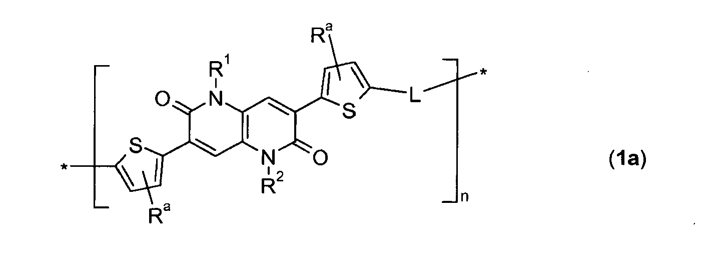 wherein R¹, R², R^{a}, L and n are as defined in claim 1.

14. A polymer of claim 13, wherein L is 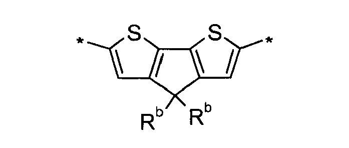 wherein R^{b} is as defined in claim 1.

15. A polymer of any of claims 1 to 14, wherein n is an integer from 5 to 5'000, preferably from 5 to 1'000, more preferably from 5 to 100, and most preferably from 10 to 100.

16. An electronic device comprising the polymer of any of claims 1 to 15.

17. The electronic device of claim 16, wherein the electronic device is an organic field effect transistor (OFET).

18. The electronic device of claim 16, wherein the electronic device is an organic photovoltaic device (OPV).

19. Use of the polymer of any of claims 1 to 15 as semiconducting material.

## Patentansprüche

1. Polymer, umfassend eine Einheit der Formel 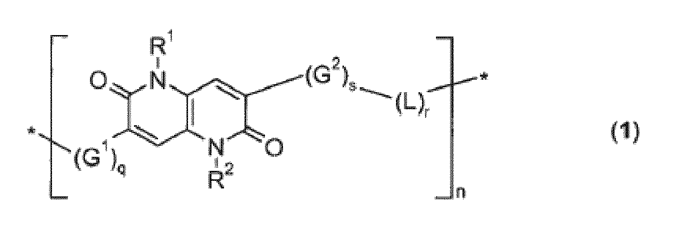 wobei
R¹ und R² unabhängig voneinander für H, C₁₋₃₀-Alkyl, das gegebenenfalls durch 1 bis 6 Substituenten R^{c} substituiert ist, C₂₋₃₀-Alkenyl, das gegebenenfalls durch 1 bis 6 Substituenten R^{c} substituiert ist, C₂₋₃₀-Alkinyl, das gegebenenfalls durch 1 bis 6 Substituenten R^{c} substituiert ist, C₃₋₁₀-Cycloalkyl, das gegebenenfalls durch 1 bis 6 Substituenten R^{d} substituiert ist, C₅₋₁₀-Cycloalkenyl, das gegebenenfalls durch 1 bis 6 Substituenten R^{d} substituiert ist, einen einwertigen 3- bis 14-gliedrigen aliphatischen heterocyclischen Rest, der gegebenenfalls durch 1 bis 6 Substituenten R^{d} substituiert ist, C₆₋₁₄-Aryl, das gegebenenfalls durch 1 bis 6 Substituenten R^{e} substituiert ist, oder einen einwertigen 5- bis 14-gliedrigen aromatischen heterocyclischen Rest, der gegebenenfalls durch 1 bis 6 Substituenten R^{e} substituiert ist, stehen,
wobei
R^{c} bei jedem Auftreten unabhängig voneinander aus der Gruppe bestehend aus =O, =C(CN)₂, -0-C₂₋₆-Alkylen-O-, Halogen, -CN, -NO₂, -OH, C₁₋₁₀-Alkoxy, -O-CH₂CH₂O-C₁₋₁₀-Alkyl, -O-COR³, -S-C₁₋₁₀-Alkyl, -NH₂, -NHR³, -NR³R⁴, -NH-COR³, -COOH, -COOR³, -CONH₂, -CONHR³, -CONR³R⁴, -CO-H, -COR³, C₃₋₁₀-Cycloalkyl, einem einwertigen 3- bis 14-gliedrigen aliphatischen heterocyclischen Rest, C₆₋₁₄-Aryl und einem einwertigen 5- bis 14-gliedrigen aromatischen heterocyclischen Rest ausgewählt ist;
R^{d} bei jedem Auftreten unabhängig voneinander aus der Gruppe bestehend aus =O, =C(CN)₂, -0-C₂₋₆-Alkylen-O-, Halogen, -CN, -NO₂, -OH, C₁₋₁₀-Alkoxy, -O-CH₂CH₂O-C₁₋₁₀-Alkyl, -O-COR³, -S-C₁₋₁₀-Alkyl, -NH₂, -NHR³, -NR³R⁴, -NH-COR³, -COOH, -COOR³, -CONH₂, -CONHR³, -CONR³R⁴, -CO-H, -COR³, C₁₋₁₀-Alkyl, C₂₋₁₀-Alkenyl, C₂₋₁₀-Alkinyl, C₆₋₁₄-Aryl und einem einwertigen 5- bis 14-gliedrigen aromatischen heterocyclischen Rest ausgewählt ist;
R^{e} bei jedem Auftreten unabhängig voneinander aus der Gruppe bestehend aus =O, =C(CN)₂, -0-C₂₋₆-Alkylen-O-, Halogen, -CN, -NO₂, -OH, C₁₋₁₀-Alkoxy, -O-CH₂CH₂O-C₁₋₁₀-Alkyl, -O-COR³, -S-C₁₋₁₀-Alkyl, -NH₂, -NHR³, -NR³R⁴, -NH-COR³, -COOH, -COOR³, -CONH₂, -CONHR³, -CONR³R⁴, -CO-H, -COR³, C₁₋₁₀-Alkyl, C₂₋₁₀-Alkenyl, C₂₋₁₀-Alkinyl, C₃₋₁₀-Cycloalkyl, C₅₋₁₀-Cycloalkenyl und einem einwertigen 3- bis 14-gliedrigen aliphatischen heterocyclischen Rest ausgewählt ist,
wobei R³ und R⁴ bei jedem Auftreten unabhängig voneinander aus der Gruppe bestehend aus C₁₋₁₀-Alkyl, C₂₋₁₀-Alkenyl, C₂₋₁₀-Alkinyl, C₃₋₁₀-Cycloalkyl, C₅₋₁₀-Cycloalkenyl, einem einwertigen 3-bis 14-gliedrigen aliphatischen heterocyclischen Rest, C₆₋₁₄-Aryl und einem einwertigen 5-bis 14-gliedrigen aromatischen heterocyclischen Rest ausgewählt sind,
G¹ und G² unabhängig voneinander für C₆₋₁₄-Arylen, das gegebenenfalls durch 1 bis 6 Substituenten R^{a} substituiert ist, oder einen zweiwertigen 5- bis 14-gliedrigen aromatischen heterocyclischen Rest, der gegebenenfalls durch 1 bis 6 Substituenten R^{a} substituiert ist, stehen,
wobei
R^{a} bei jedem Auftreten unabhängig voneinander aus der Gruppe bestehend aus =O, =C(CN)₂, -0-C₂₋₆-Alkylen-O-, Halogen, -CN, -NO₂, -OH, C₁₋₃₀-Alkoxy, -O-CH₂CH₂O-C₁₋₃₀-Alkyl, -O-COR⁸, -S-C₁₋₃₀-Alkyl, -NH₂, -NHR⁸, -NR⁸R⁹, -NH-COR⁸, -COOH, -COOR⁸, -CONH₂, -CONHR⁸, -CONR⁸R⁹, -CO-H, -COR⁸, C₁₋₃₀-Alkyl, das gegebenenfalls durch 1 bis 6 Substituenten R^{f} substituiert ist, C₂₋₃₀-Alkenyl, das gegebenenfalls durch 1 bis 6 Substituenten R^{f} substituiert ist, C₂₋₃₀-Alkinyl, das gegebenenfalls durch 1 bis 6 Substituenten R^{f} substituiert ist, C₃₋₁₀-Cycloalkyl, das gegebenenfalls durch 1 bis 6 Substituenten R^{g} substituiert ist, C₅₋₁₀-Cycloalkenyl, das gegebenenfalls durch 1 bis 6 Substituenten R^{g} substituiert ist und einem einwertigen 3- bis 14-gliedrigen aliphatischen heterocyclischen Rest, der gegebenenfalls durch 1 bis 6 Substituenten R^{g} substituiert ist, ausgewählt ist,
wobei
R⁸ und R⁹ bei jedem Auftreten unabhängig voneinander aus der Gruppe bestehend aus C₁₋₃₀-Alkyl, C₂₋₃₀-Alkenyl, C₂₋₃₀-Alkinyl, C₃₋₁₀-Cycloalkyl, C₅₋₁₀-Cycloalkenyl, einem einwertigen 3-bis 14-gliedrigen aliphatischen heterocyclischen Rest, C₆₋₁₄-Aryl und einem einwertigen 5-bis 14-gliedrigen aromatischen heterocyclischen Rest ausgewählt sind,
R^{f} bei jedem Auftreten unabhängig voneinander aus der Gruppe bestehend aus =O, =C(CN)₂, -0-C₂₋₆-Alkylen-O-, Halogen, -CN, -NO₂, -OH, C₁₋₁₀-Alkoxy, -O-CH₂CH₂O-C₁₋₁₀-Alkyl, -O-COR¹⁰, -S-C₁₋₁₀-Alkyl, -NH₂, -NHR¹⁰, -NR¹⁰R¹¹, -NH-COR¹⁰, -COOH, -COOR¹⁰, -CONH₂, -CONHR¹⁰, -CONR¹⁰R¹¹, -CO-H, -COR¹⁰, C₃₋₁₀-Cycloalkyl, einem einwertigen 3- bis 14-gliedrigen aliphatischen heterocyclischen Rest, C₆₋₁₄-Aryl und einem einwertigen 5- bis 14-gliedrigen aromatischen heterocyclischen Rest ausgewählt ist;
R^{g} bei jedem Auftreten unabhängig voneinander aus der Gruppe bestehend aus =O, =C(CN)₂, -0-C₂₋₆-Alkylen-O-, Halogen, -CN, -NO₂, -OH, C₁₋₁₀-Alkoxy, -O-CH₂CH₂O-C₁₋₁₀-Alkyl, -O-COR¹⁰, -S-C₁₋₁₀-Alkyl, -NH₂, -NHR¹⁰, -NR¹⁰R¹¹, -NH-COR¹⁰, -COOH, -COOR¹⁰, -CONH₂, -CONHR¹⁰, -CONR¹⁰R¹¹, -CO-H, -COR¹⁰, C₁₋₁₀-Alkyl, C₂₋₁₀-Alkenyl, C₂₋₁₀-Alkinyl, C₆₋₁₄-Aryl und einem einwertigen 5-bis 14-gliedrigen aromatischen heterocyclischen Rest ausgewählt ist;
wobei R¹⁰ und R¹¹ bei jedem Auftreten unabhängig voneinander aus der Gruppe bestehend aus C₁₋₁₀-Alkyl, C₂₋₁₀-Alkenyl, C₂₋₁₀-Alkinyl, C₃₋₁₀-Cycloalkyl, C₅₋₁₀-Cycloalkenyl, einem einwertigen 3- bis 14-gliedrigen aliphatischen heterocyclischen Rest, C₆₋₁₄-Aryl und einem einwertigen 5- bis 14-gliedrigen aromatischen heterocyclischen Rest ausgewählt sind,
oder
G¹ und G² unabhängig voneinander für 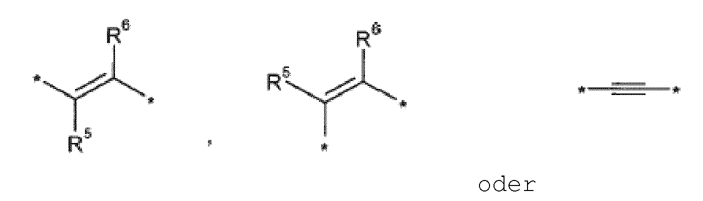 stehen, wobei
R⁵ und R⁶ unabhängig voneinander für H oder C₁₋₃₀-Alkyl stehen,
L für C₆₋₂₄-Arylen, das gegebenenfalls durch 1 bis 6 Substituenten R^{b} substituiert ist, oder einen zweiwertigen 5- bis 24-gliedrigen aromatischen heterocyclischen Rest, der gegebenenfalls durch 1 bis 6 Substituenten R^{b} substituiert ist, steht,
wobei
R^{b} bei jedem Auftreten unabhängig voneinander aus der Gruppe bestehend aus =O, =C(CN)₂, -0-C₂₋₆-Alkylen-O-, Halogen, -CN, -NO₂, -OH, C₁₋₃₀-Alkoxy, -O-CH₂CH₂O-C₁₋₃₀-Alkyl, -O-COR¹², -S-C₁₋₃₀-Alkyl, -NH₂, -NHR¹², -NR¹²R¹³, -NH-COR¹², -COOH, -COOR¹², -CONH₂, -CONHR¹², -CONR¹²R¹³, -CO-H, -COR¹², C₁₋₃₀-Alkyl, das gegebenenfalls durch 1 bis 6 Substituenten R^{h} substituiert ist, C₂₋₃₀-Alkenyl, das gegebenenfalls durch 1 bis 6 Substituenten R^{h} substituiert ist, C₂₋₃₀-Alkinyl, das gegebenenfalls durch 1 bis 6 Substituenten R^{h} substituiert ist, C₃₋₁₀-Cycloalkyl, das gegebenenfalls durch 1 bis 6 Substituenten Rⁱ substituiert ist, C₅₋₁₀-Cycloalkenyl, das gegebenenfalls durch 1 bis 6 Substituenten Rⁱ substituiert ist und einem einwertigen 3- bis 14-gliedrigen aliphatischen heterocyclischen Rest, der gegebenenfalls durch 1 bis 6 Substituenten Rⁱ substituiert ist, ausgewählt ist,
wobei
R¹² und R¹³ bei jedem Auftreten unabhängig voneinander aus der Gruppe bestehend aus C₁₋₃₀-Alkyl, C₂₋₃₀-Alkenyl, C₂₋₃₀-Alkinyl, C₃₋₁₀-Cycloalkyl, C₅₋₁₀-Cycloalkenyl, einem einwertigen 3-bis 14-gliedrigen aliphatischen heterocyclischen Rest, C₆₋₁₄-Aryl und einem einwertigen 5-bis 14-gliedrigen aromatischen heterocyclischen Rest ausgewählt sind,
R^{h} bei jedem Auftreten unabhängig voneinander aus der Gruppe bestehend aus =O, =C(CN)₂, -0-C₂₋₆-Alkylen-O-, Halogen, -CN, -NO₂, -OH, C₁₋₁₀-Alkoxy, -O-CH₂CH₂O-C₁₋₁₀-Alkyl, -O-COR¹⁴, -S-C₁₋₁₀-Alkyl, -NH₂, -NHR¹⁴, -NR¹⁴R¹⁵, -NH-COR¹⁴, -COOH, -COOR¹⁴, -CONH₂, -CONHR¹⁴, -CONR¹⁴R¹⁵, -CO-H, -COR¹⁴, C₃₋₁₀-Cycloalkyl, einem einwertigen 3- bis 14-gliedrigen aliphatischen heterocyclischen Rest, C₆₋₁₄-Aryl und einem einwertigen 5- bis 14-gliedrigen aromatischen heterocyclischen Rest ausgewählt ist;
Rⁱ bei jedem Auftreten unabhängig voneinander aus der Gruppe bestehend aus =O, =C(CN)₂, -0-C₂₋₆-Alkylen-O-, Halogen, -CN, -NO₂, -OH, C₁₋₁₀-Alkoxy, -O-CH₂CH₂O-C₁₋₁₀-Alkyl, -O-COR¹⁴, -S-C₁₋₁₀-Alkyl, -NH₂, -NHR¹⁴, -NR¹⁴R¹⁵, -NH-COR¹⁴, -COOH, -COOR¹⁴, -CONH₂, -CONHR¹⁴, -CONR¹⁴R¹⁵, -CO-H, -COR¹⁴, C₁₋₁₀-Alkyl, C₂₋₁₀-Alkenyl, C₂₋₁₀-Alkinyl, C₆₋₁₄-Aryl und einem einwertigen 5-bis 14-gliedrigen aromatischen heterocyclischen Rest ausgewählt ist;
wobei R¹⁴ und R¹⁵ bei jedem Auftreten unabhängig voneinander aus der Gruppe bestehend aus C₁₋₁₀-Alkyl, C₂₋₁₀-Alkenyl, C₂₋₁₀-Alkinyl, C₃₋₁₀-Cycloalkyl, C₅₋₁₀-Cycloalkenyl, einem einwertigen 3- bis 14-gliedrigen aliphatischen heterocyclischen Rest, C₆₋₁₄-Aryl und einem einwertigen 5- bis 14-gliedrigen aromatischen heterocyclischen Rest ausgewählt sind,
oder L für 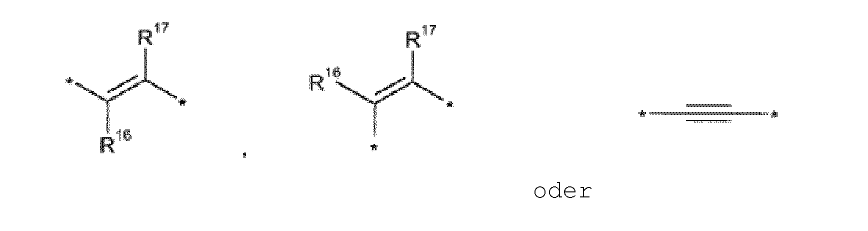 steht, wobei
R¹⁶ und R¹⁷ unabhängig voneinander für H, C₁₋₃₀-Alkyl, -CN oder Halogen stehen,
q und s unabhängig voneinander für 0, 1, 2, 3, 4 oder 5 stehen,
r für 0, 1 oder 2 steht
und
n für eine ganze Zahl von 2 bis 10.000 steht.

2. Polymer nach Anspruch 1, wobei R¹ und R² unabhängig voneinander für H, C₁₋₃₀-Alkyl, das gegebenenfalls durch 1 bis 6 Substituenten R^{c} substituiert ist, C₂₋₃₀-Alkenyl, das gegebenenfalls durch 1 bis 6 Substituenten R^{c} substituiert ist, C₂₋₃₀-Alkinyl, das gegebenenfalls durch 1 bis 6 Substituenten R^{c} substituiert ist, C₃₋₁₀-Cycloalkyl, das gegebenenfalls durch 1 bis 6 Substituenten R^{d} substituiert ist, C₅₋₁₀-Cycloalkenyl oder C₆₋₁₄-Aryl, das gegebenenfalls durch 1 bis 6 Substituenten R^{e} substituiert ist, stehen,
wobei
R^{c} bei jedem Auftreten unabhängig voneinander aus der Gruppe bestehend aus =O, =C(CN)₂, -O-C₂₋₆-Alkylen-O-, Halogen, -CN, -NO₂, -OH, C₁₋₁₀-Alkoxy, -O-CH₂CH₂O-C₁₋₁₀-Alkyl, -O-COR³, -S-C₁₋₁₀-Alkyl, -NH₂, -NHR³, -NR³R⁴, -NH-COR³, -COOH, -COOR³, -CONH₂, -CONHR³, -CONR³R⁴, -CO-H, -COR³, C₃₋₁₀-Cycloalkyl, einem einwertigen 3- bis 14-gliedrigen aliphatischen heterocyclischen Rest, C₆₋₁₄-Aryl und einem einwertigen 5- bis 14-gliedrigen aromatischen heterocyclischen Rest ausgewählt ist;
R^{d} bei jedem Auftreten unabhängig voneinander aus der Gruppe bestehend aus =O, =C(CN)₂, -O-C₂₋₆-Alkylen-O-, Halogen, -CN, -NO₂, -OH, C₁₋₁₀-Alkoxy, -O-CH₂CH₂O-C₁₋₁₀-Alkyl, -O-COR³, -S-C₁₋₁₀-Alkyl, -NH₂, -NHR³, -NR³R⁴, -NH-COR³, -COOH, -COOR³, -CONH₂, -CONHR³, -CONR³R⁴, -CO-H, -COR³, C₁₋₁₀-Alkyl, C₂₋₁₀-Alkenyl, C₂₋₁₀-Alkinyl, C₆₋₁₄-Aryl und einem einwertigen 5- bis 14-gliedrigen aromatischen heterocyclischen Rest ausgewählt ist;
R^{e} bei jedem Auftreten unabhängig voneinander aus der Gruppe bestehend aus =O, =C(CN)₂, -O-C₂₋₆-Alkylen-O-, Halogen, -CN, -NO₂, -OH, C₁₋₁₀-Alkoxy, -O-CH₂CH₂O-C₁₋₁₀-Alkyl, -O-COR³, -S-C₁₋₁₀-Alkyl, -NH₂, -NHR³, -NR³R⁴, -NH-COR³, -COOH, -COOR³, -CONH₂, -CONHR³, -CONR³R⁴, -CO-H, -COR³, C₁₋₁₀-Alkyl, C₂₋₁₀-Alkenyl, C₂₋₁₀-Alkinyl, C₃₋₁₀-Cycloalkyl, C₅₋₁₀-Cycloalkenyl und einem einwertigen 3- bis 14-gliedrigen aliphatischen heterocyclischen Rest ausgewählt ist,
wobei R³ und R⁴ bei jedem Auftreten unabhängig voneinander aus der Gruppe bestehend aus C₁₋₁₀-Alkyl, C₂₋₁₀-Alkenyl, C₂₋₁₀-Alkinyl, C₃₋₁₀-Cycloalkyl, C₅₋₁₀-Cycloalkenyl, einem einwertigen 3-bis 14-gliedrigen aliphatischen heterocyclischen Rest, C₆₋₁₄-Aryl und einem einwertigen 5-bis 14-gliedrigen aromatischen heterocyclischen Rest ausgewählt sind.

3. Polymer nach Anspruch 1, wobei R¹ und R² unabhängig voneinander für C₁₋₃₀-Alkyl, das gegebenenfalls durch 1 bis 6 Substituenten R^{c} substituiert ist, stehen,
wobei
R^{c} bei jedem Auftreten unabhängig voneinander aus der Gruppe bestehend aus =O, =C(CN)₂, -0-C₂₋₆-Alkylen-O-, Halogen, -CN, -NO₂, -OH, C₁₋₁₀-Alkoxy, -O-CH₂CH₂O-C₁₋₁₀-Alkyl, -O-COR³, -S-C₁₋₁₀-Alkyl, -NH₂, -NHR³, -NR³R⁴, -NH-COR³, -COOH, -COOR³, -CONH₂, -CONHR³, -CONR³R⁴, -CO-H, -COR³, C₃₋₁₀-Cycloalkyl, einem einwertigen 3- bis 14-gliedrigen aliphatischen heterocyclischen Rest, C₆₋₁₄-Aryl und einem einwertigen 5- bis 14-gliedrigen aromatischen heterocyclischen Rest ausgewählt ist;
wobei R³ und R⁴ bei jedem Auftreten unabhängig voneinander aus der Gruppe bestehend aus C₁₋₁₀-Alkyl, C₂₋₁₀-Alkenyl, C₂₋₁₀-Alkinyl, C₃₋₁₀-Cycloalkyl, C₅₋₁₀-Cycloalkenyl, einem einwertigen 3-bis 14-gliedrigen aliphatischen heterocyclischen Rest, C₆₋₁₄-Aryl und einem einwertigen 5-bis 14-gliedrigen aromatischen heterocyclischen Rest ausgewählt sind.

4. Polymer nach Anspruch 1, wobei
R¹ und R² unabhängig voneinander für C₁₋₁₆-Alkyl, weiter bevorzugt C₁₋₁₂-Alkyl, stehen.

5. Polymer nach einem der Ansprüche 1 bis 4, wobei
G¹ und G² unabhängig voneinander für einen zweiwertigen 5- bis 14-gliedrigen aromatischen heterocyclischen Rest, der gegebenenfalls durch 1 bis 6 Substituenten R^{a} substituiert ist, stehen, wobei
R^{a} bei jedem Auftreten unabhängig voneinander aus der Gruppe bestehend aus =O, =C(CN)₂, -0-C₂₋₆-Alkylen-O-, Halogen, -CN, -NO₂, -OH, C₁₋₃₀-Alkoxy, -O-CH₂CH₂O-C₁₋₃₀-Alkyl, -O-COR⁸, -S-C₁₋₃₀-Alkyl, -NH₂, -NHR⁸, -NR⁸R⁹, -NH-COR⁸, -COOH, -COOR⁸, -CONH₂, -CONHR⁸, -CONR⁸R⁹, -CO-H, -COR⁸, C₁₋₃₀-Alkyl, das gegebenenfalls durch 1 bis 6 Substituenten R^{f} substituiert ist, C₂₋₃₀-Alkenyl, das gegebenenfalls durch 1 bis 6 Substituenten R^{f} substituiert ist, C₂₋₃₀-Alkinyl, das gegebenenfalls durch 1 bis 6 Substituenten R^{f} substituiert ist, C₃₋₁₀-Cycloalkyl, das gegebenenfalls durch 1 bis 6 Substituenten R^{g} substituiert ist, C₅₋₁₀-Cycloalkenyl, das gegebenenfalls durch 1 bis 6 Substituenten R^{g} substituiert ist und einen einwertigen 3- bis 14-gliedrigen aliphatischen heterocyclischen Rest, der gegebenenfalls durch 1 bis 6 Substituenten R^{g} substituiert ist, steht,
wobei
R⁸ und R⁹ bei jedem Auftreten unabhängig voneinander aus der Gruppe bestehend aus C₁₋₃₀-Alkyl, C₂₋₃₀-Alkenyl, C₂₋₃₀-Alkinyl, C₃₋₁₀-Cycloalkyl, C₅₋₁₀-Cycloalkenyl, einem einwertigen 3-bis 14-gliedrigen aliphatischen heterocyclischen Rest, C₆₋₁₄-Aryl und einem einwertigen 5-bis 14-gliedrigen aromatischen heterocyclischen Rest ausgewählt sind,
R^{f} bei jedem Auftreten unabhängig voneinander aus der Gruppe bestehend aus =O, =C(CN)₂, -0-C₂₋₆-Alkylen-O-, Halogen, -CN, -NO₂, -OH, C₁₋₁₀-Alkoxy, -O-CH₂CH₂O-C₁₋₁₀-Alkyl, -O-COR¹⁰, - S-C₁₋₁₀-Alkyl, -NH₂, -NHR¹⁰, -NR¹⁰R¹¹, -NH-COR¹⁰, -COOH, -COOR¹⁰, -CONH₂, -CONHR¹⁰, -CONR¹⁰R¹¹, -CO-H, -COR¹⁰, C₃₋₁₀-Cycloalkyl, einem einwertigen 3-bis 14-gliedrigen aliphatischen heterocyclischen Rest, C₆₋₁₄-Aryl und einem einwertigen 5-bis 14-gliedrigen aromatischen heterocyclischen Rest ausgewählt ist;
R^{g} bei jedem Auftreten unabhängig voneinander aus der Gruppe bestehend aus =O, =C(CN)₂, -0-C₂₋₆-Alkylen-O-, Halogen, -CN, -NO₂, -OH, C₁₋₁₀-Alkoxy, -O-CH₂CH₂O-C₁₋₁₀-Alkyl, -O-COR¹⁰, - S-C₁₋₁₀-Alkyl, -NH₂, -NHR¹⁰, -NR¹⁰R¹¹, -NH-COR¹⁰, -COOH, -COOR¹⁰, -CONH₂, -CONHR¹⁰, -CONR¹⁰R¹¹, -CO-H, -COR¹⁰, C₁₋₁₀-Alkyl, C₂₋₁₀-Alkenyl, C₂₋₁₀-Alkinyl, C₆₋₁₄-Aryl und einem einwertigen 5- bis 14-gliedrigen aromatischen heterocyclischen Rest ausgewählt ist;
wobei R¹⁰ und R¹¹ bei jedem Auftreten unabhängig voneinander aus der Gruppe bestehend aus C₁₋₁₀-Alkyl, C₂₋₁₀-Alkenyl, C₂₋₁₀-Alkinyl, C₃₋₁₀-Cycloalkyl, C₅₋₁₀-Cycloalkenyl, einem einwertigen 3-bis 14-gliedrigen aliphatischen heterocyclischen Rest, C₆₋₁₄-Aryl und einem einwertigen 5-bis 14-gliedrigen aromatischen heterocyclischen Rest ausgewählt sind,
oder
G¹ und G² unabhängig voneinander für 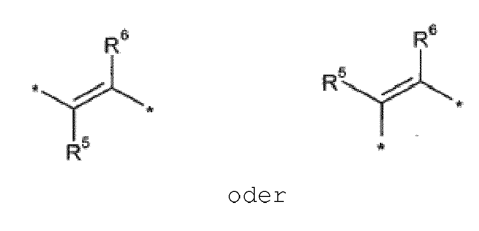 stehen, wobei
R⁵ und R⁶ unabhängig voneinander für H oder C₁₋₃₀-Alkyl stehen.

6. Polymer nach einem der Ansprüche 1 bis 4, wobei G¹ und G² unabhängig voneinander für einen monocyclischen zweiwertigen 5- bis 8-gliedrigen aromatischen heterocyclischen Rest, der gegebenenfalls durch 1 bis 4 Substituenten R^{a} substituiert ist, stehen,
wobei
R^{a} bei jedem Auftreten unabhängig voneinander für C₁₋₃₀-Alkyl, das gegebenenfalls durch 1 bis 4 Substituenten R^{f} substituiert ist, steht, wobei
R^{f} bei jedem Auftreten unabhängig voneinander aus der Gruppe bestehend aus =O, =C(CN)₂, -0-C₂₋₆-Alkylen-O-, Halogen, -CN, -NO₂, -OH, C₁₋₁₀-Alkoxy, -O-CH₂CH₂O-C₁₋₁₀-Alkyl, -O-COR¹⁰, -S-C₁₋₁₀-Alkyl, -NH₂, -NHR¹⁰, -NR¹⁰R¹¹, -NH-COR¹⁰, -COOH, -COOR¹⁰, -CONH₂, -CONHR¹⁰, -CONR¹⁰R¹¹, -CO-H, -COR¹⁰, C₃₋₁₀-Cycloalkyl, einem einwertigen 3-bis 14-gliedrigen aliphatischen heterocyclischen Rest, C₆₋₁₄-Aryl und einem einwertigen 5-bis 14-gliedrigen aromatischen heterocyclischen Rest ausgewählt ist.

7. Polymer nach einem der Ansprüche 1 bis 4, wobei
G¹ und G² unabhängig voneinander für einen monocyclischen zweiwertigen 5- bis 8-gliedrigen aromatischen heterocyclischen Rest stehen, wobei G¹ und G² durch 1 bis 2 Substituenten R^{a} substituiert sind,
wobei
R^{a} bei jedem Auftreten unabhängig voneinander für C₆₋₂₀-Alkyl steht.

8. Polymer nach einem der Ansprüche 1 bis 7, wobei L für einen zweiwertigen 5- bis 24-gliedrigen aromatischen heterocyclischen Rest, der gegebenenfalls durch 1 bis 6 Substituenten R^{b} substituiert ist, steht,
wobei
R^{b} bei jedem Auftreten unabhängig voneinander aus der Gruppe bestehend aus =O, =C(CN)₂, -0-C₂₋₆-Alkylen-O-, Halogen, -CN, -NO₂, -OH, C₁₋₃₀-Alkoxy, -O-CH₂CH₂O-C₁₋₃₀-Alkyl, -O-COR¹², -S-C₁₋₃₀-Alkyl, -NH₂, -NHR¹², -NR¹²R¹³, -NH-COR¹², -COOH, -COOR¹², -CONH₂, -CONHR¹², -CONR¹²R¹³, -CO-H, -COR¹², C₁₋₃₀-Alkyl, das gegebenenfalls durch 1 bis 6 Substituenten R^{h} substituiert ist, C₂₋₃₀-Alkenyl, das gegebenenfalls durch 1 bis 6 Substituenten R^{h} substituiert ist, C₂₋₃₀-Alkinyl, das gegebenenfalls durch 1 bis 6 Substituenten R^{h} substituiert ist, C₃₋₁₀-Cycloalkyl, das gegebenenfalls durch 1 bis 6 Substituenten Rⁱ substituiert ist, C₅₋₁₀-Cycloalkenyl, das gegebenenfalls durch 1 bis 6 Substituenten Rⁱ substituiert ist und einem einwertigen 3- bis 14-gliedrigen aliphatischen heterocyclischen Rest, der gegebenenfalls durch 1 bis 6 Substituenten Rⁱ substituiert ist, ausgewählt ist,
wobei
R¹² und R¹³ bei jedem Auftreten unabhängig voneinander aus der Gruppe bestehend aus C₁₋₃₀-Alkyl, C₂₋₃₀-Alkenyl, C₂₋₃₀-Alkinyl, C₃₋₁₀-Cycloalkyl, C₅₋₁₀-Cycloalkenyl, einem einwertigen 3-bis 14-gliedrigen aliphatischen heterocyclischen Rest, C₆₋₁₄-Aryl und einem einwertigen 5-bis 14-gliedrigen aromatischen heterocyclischen Rest ausgewählt sind,
R^{h} bei jedem Auftreten unabhängig voneinander aus der Gruppe bestehend aus =O, =C(CN)₂, -0-C₂₋₆-Alkylen-O-, Halogen, -CN, -NO₂, -OH, C₁₋₁₀-Alkoxy, -O-CH₂CH₂O-C₁₋₁₀-Alkyl, -O-COR¹⁴, -S-C₁₋₁₀-Alkyl, -NH₂, -NHR¹⁴, -NR¹⁴R¹⁵, -NH-COR¹⁴, -COOH, -COOR¹⁴, -CONH₂, -CONHR¹⁴, -CONR¹⁴R¹⁵, -CO-H, -COR¹⁴, C₃₋₁₀-Cycloalkyl, einem einwertigen 3-bis 14-gliedrigen aliphatischen heterocyclischen Rest, C₆₋₁₄-Aryl und einem einwertigen 5-bis 14-gliedrigen aromatischen heterocyclischen Rest ausgewählt ist;
Rⁱ bei jedem Auftreten unabhängig voneinander aus der Gruppe bestehend aus =O, =C(CN)₂, -0-C₂₋₆-Alkylen-O-, Halogen, -CN, -NO₂, -OH, C₁₋₁₀-Alkoxy, -O-CH₂CH₂O-C₁₋₁₀-Alkyl, -O-COR¹⁴, -S-C₁₋₁₀-Alkyl, -NH₂, -NHR¹⁴, -NR¹⁴R¹⁵, -NH-COR¹⁴, -COOH, -COOR¹⁴, -CONH₂, -CONHR¹⁴, -CONR¹⁴R¹⁵, -CO-H, -COR¹⁴, C₁₋₁₀-Alkyl, C₂₋₁₀-Alkenyl, C₂₋₁₀-Alkinyl, C₆₋₁₄-Aryl und einem einwertigen 5- bis 14-gliedrigen aromatischen heterocyclischen Rest ausgewählt ist;
wobei R¹⁴ und R¹⁵ bei jedem Auftreten unabhängig voneinander aus der Gruppe bestehend aus C₁₋₁₀-Alkyl, C₂₋₁₀-Alkenyl, C₂₋₁₀-Alkinyl, C₃₋₁₀-Cycloalkyl, C₅₋₁₀-Cycloalkenyl, einem einwertigen 3-bis 14-gliedrigen aliphatischen heterocyclischen Rest, C₆₋₁₄-Aryl und einem einwertigen 5-bis 14-gliedrigen aromatischen heterocyclischen Rest ausgewählt sind,
oder L für 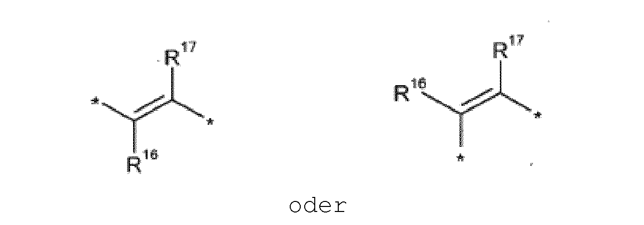 steht, wobei
R¹⁶ und R¹⁷ unabhängig voneinander für H, C₁₋₃₀-Alkyl, -CN oder Halogen stehen.

9. Polymer nach einem der Ansprüche 1 bis 7, wobei L für einen zweiwertigen 5- bis 14-gliedrigen aromatischen heterocyclischen Rest, der gegebenenfalls durch 1 bis 4 Substituenten R^{b} substituiert ist, steht,
wobei
R^{b} bei jedem Auftreten unabhängig voneinander für C₁₋₃₀-Alkyl, das gegebenenfalls durch 1 bis 4 Substituenten R^{h} substituiert ist, steht, wobei
R^{h} bei jedem Auftreten unabhängig voneinander aus der Gruppe bestehend aus =O, =C(CN)₂, -0-C₂₋₆-Alkylen-O-, Halogen, -CN, -NO₂, -OH, C₁₋₁₀-Alkoxy, -O-CH₂CH₂O-C₁₋₁₀-Alkyl, -O-COR¹⁴, -S-C₁₋₁₀-Alkyl, -NH₂, -NHR¹⁴, -NR¹⁴R¹⁵, -NH-COR¹⁴, -COOH, -COOR¹⁴, -CONH₂, -CONHR¹⁴, -CONR¹⁴R¹⁵, -CO-H, -COR¹⁴, C₃₋₁₀-Cycloalkyl, einem einwertigen 3-bis 14-gliedrigen aliphatischen heterocyclischen Rest, C₆₋₁₄-Aryl und einem einwertigen 5-bis 14-gliedrigen aromatischen heterocyclischen Rest ausgewählt ist.

10. Polymer nach einem der Ansprüche 1 bis 7, wobei
L für einen zweiwertigen 5- bis 14-gliedrigen aromatischen heterocyclischen Rest steht, wobei L durch 1 bis 2 Substituenten R^{b} substituiert ist, wobei
R^{b} bei jedem Auftreten unabhängig voneinander für C₆₋₂₀-Alkyl steht.

11. Polymer nach einem der Ansprüche 1 bis 10, wobei
q und s unabhängig voneinander für 1, 2 oder 3 stehen,
r für 1 oder 2 steht
und
n für eine ganze Zahl von 5 bis 10.000 steht.

12. Polymer nach Anspruch 11, wobei
q und s beide für 1 stehen,
r für 1 steht
und
n für eine ganze Zahl von 5 bis 10.000 steht.

13. Polymer nach Anspruch 1, wobei es sich bei der Einheit der Formel (1) um eine Einheit der Formel 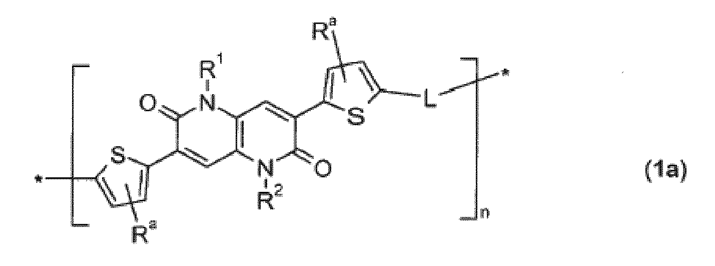 handelt, wobei R¹, R², R^{a}, L und n wie in Anspruch 1 definiert sind.

14. Polymer nach Anspruch 13, wobei L für 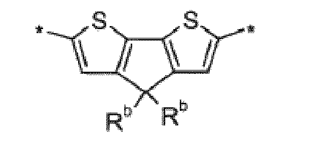 steht, wobei R^{b} wie in Anspruch 1 definiert ist.

15. Polymer nach einem der Ansprüche 1 bis 14, wobei n für eine ganze Zahl von 5 bis 5000, vorzugsweise von 5 bis 1000, weiter bevorzugt von 5 bis 100 und ganz besonders bevorzugt von 10 bis 100 steht.

16. Elektronische Vorrichtung, umfassend das Polymer nach einem der Ansprüche 1 bis 15.

17. Elektronische Vorrichtung nach Anspruch 16, wobei es sich bei der elektronischen Vorrichtung um einen organischen Feldeffekttransistor (OFET) handelt.

18. Elektronische Vorrichtung nach Anspruch 16, wobei es sich bei der elektronischen Vorrichtung um eine organische Photovoltaikvorrichtung (OPV) handelt.

19. Verwendung des Polymers nach einem der Ansprüche 1 bis 15 als halbleitendes Material.

## Revendications

1. Polymère comprenant un motif de formule 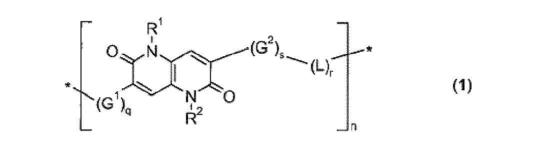 dans laquelle
R¹ et R² représentent indépendamment l'un de l'autre H, un alkyle en C₁₋₃₀ éventuellement substitué par 1 à 6 substituants R^{c}, un alcényle en C₂₋₃₀ éventuellement substitué par 1 à 6 substituants R^{c}, un alcynyle en C₂₋₃₀ éventuellement substitué par 1 à 6 substituants R^{c}, un cycloalkyle en C₃₋₁₀ éventuellement substitué par 1 à 6 substituants R^{d}, un cycloalcényle en C₅₋₁₀ éventuellement substitué par 1 à 6 substituants R^{d}, un résidu hétérocyclique aliphatique à 3 à 14 chaînons monovalent éventuellement substitué par 1 à 6 substituants R^{d}, un aryle en C₆₋₁₄ éventuellement substitué par 1 à 6 substituants R^{e} ou un résidu hétérocyclique aromatique à 5 à 14 chaînons monovalent éventuellement substitué par 1 à 6 substituants R^{e},
dans lesquels
les R^{c} à chaque occurrence sont choisis indépendamment les uns des autres dans le groupe constitué par =0, =C(CN)₂, un radical -O-(alkylène en C₂₋₆) -O-, un halogène, -CN, -NO₂, -OH, un alcoxy en C₁₋₁₀, un radical -O-CH₂CH₂O- (alkyle en C₁₋₁₀), -O-COR³, un radical -S-(alkyle en C₁₋₁₀), -NH₂, -NHR³, -NR³R⁴, -NH-COR³, -COOH, -COOR³, -CONH₂, -CONHR³, -CONR³R⁴, -CO-H, -COR³, un cycloalkyle en C₃₋₁₀, un résidu hétérocyclique aliphatique à 3 à 14 chaînons monovalent, un aryle en C₅₋₁₄ et un résidu hétérocyclique aromatique à 5 à 14 chaînons monovalent ;
les R^{d} à chaque occurrence sont choisis indépendamment les uns des autres dans le groupe constitué par =O, =C(CN)₂, un radical -O-(alkylène en C₂₋₆)-O-, un halogène, -CN, -NO₂, -OH, un alcoxy en C₁₋₁₀, un radical -O-CH₂CH₂O- (alkyle en C₁₋₁₀), -O-COR³, un radical -S-(alkyle en C₁₋₁₀), -NH₂, -NHR³, -NR³R⁴, -NH-COR³, -COOH, -COOR³, -CONH₂, -CONHR³, -CONR³R⁴, -CO-H, -COR³, un alkyle en C₁₋₁₀, un alcényle en C₂₋₁₀, un alcynyle en C₂₋₁₀, un aryle en C₆₋₁₄ et un résidu hétérocyclique aromatique à 5 à 14 chaînons monovalent ;
les R^{e} à chaque occurrence sont choisis indépendamment les uns des autres dans le groupe constitué par =O, =C(CN)₂, un radical -O-(alkylène en C₂₋₆)-O-, un halogène, -CN, -NO₂, -OH, un alcoxy en C₁₋₁₀, un radical -O-CH₂CH₂O- (alkyle en C₁₋₁₀), -O-COR³, un radical -S-(alkyle en C₁₋₁₀), -NH₂, -NHR³, -NR³R⁴, -NH-COR³, -COOH, -COOR³, -CONH₂, -CONHR³, -CONR³R⁴, -CO-H, -COR³, un alkyle en C₁₋₁₀, un alcényle en C₂₋₁₀, un alcynyle en C₂₋₁₀, un cycloalkyle en C₃₋₁₀, un cycloalcényle en C₅₋₁₀ et un résidu hétérocyclique aliphatique à 3 à 14 chaînons monovalent,
dans lesquels R³ et R⁴ à chaque occurrence sont choisis indépendamment l'un de l'autre dans le groupe constitué par un alkyle en C₁₋₁₀, un alcényle en C₂₋₁₀, un alcynyle en C₂₋₁₀, un cycloalkyle en C₃₋₁₀, un cycloalcényle en C₅₋₁₀, un résidu hétérocyclique aliphatique à 3 à 14 chaînons monovalent, un aryle en C₆₋₁₄ et un résidu hétérocyclique aromatique à 5 à 14 chaînons monovalent,
G¹ et G² représentent indépendamment l'un de l'autre un arylène en C₆₋₁₄ éventuellement substitué par 1 à 6 substituants R^{a} ou un résidu hétérocyclique aromatique à 5 à 14 chaînons divalent éventuellement substitué par 1 à 6 substituants R^{a},
dans lesquels
les R^{a} à chaque occurrence sont choisis indépendamment les uns des autres dans le groupe constitué par =O, =C(CN)₂, un radical -O-(alkylène en C₂₋₆)-O-, un halogène, -CN, -NO₂, -OH, un alcoxy en C₁₋₃₀, un radical -O-CH₂CH₂O-(alkyle en C₁₋₃₀), -O-COR⁸, un radical -S-(alkyle en C₁₋₃₀), -NH₂, -NHR⁸, -NR⁸R⁹, -NH-COR⁸, -COOH, -COOR⁸, -CONH₂, -CONHR⁸, -CONR⁸R⁹, -CO-H, -COR⁸, un alkyle en C₁₋₃₀ éventuellement substitué par 1 à 6 substituants R^{f}, un alcényle en C₂₋₃₀ éventuellement substitué par 1 à 6 substituants R^{f}, un alcynyle en C₂₋₃₀ éventuellement substitué par 1 à 6 substituants R^{f}, un cycloalkyle en C₃₋₁₀ éventuellement substitué par 1 à 6 substituants R^{g}, un cycloalcényle en C₅₋₁₀ éventuellement substitué par 1 à 6 substituants R^{g} et un résidu hétérocyclique aliphatique à 3 à 14 chaînons monovalent éventuellement substitué par 1 à 6 substituants R^{g},
dans lesquels
R⁸ et R⁹ à chaque occurrence sont choisis indépendamment l'un de l'autre dans le groupe constitué par un alkyle en C₁₋₃₀, un alcényle en C₂₋₃₀, un alcynyle en C₂₋₃₀,un cycloalkyle en C₃₋₁₀, un cycloalcényle en C₅₋₁₀, un résidu hétérocyclique aliphatique à 3 à 14 chaînons monovalent, un aryle en C₆₋₁₄ et un résidu hétérocyclique aromatique à 5 à 14 chaînons monovalent ;
les R^{f} à chaque occurrence sont choisis indépendamment les uns des autres dans le groupe constitué par =O, =C(CN)₂, un radical -O-(alkylène en C₂₋₆)-O-, un halogène, -CN, -NO₂, -OH, un alcoxy en C₁₋₁₀, un radical -O-CH₂CH₂O-(alkyle en C₁₋₁₀), -O-COR¹⁰, un radical -S-(alkyle en C₁₋₁₀), -NH₂, -NHR¹⁰, -NR¹⁰R¹¹, -NH-COR¹⁰, -COOH, -COOR¹⁰, -CONH₂, -CONHR¹⁰, -CONR¹⁰R¹¹, -CO-H, -COR¹⁰, un cycloalkyle en C₃₋₁₀, un résidu hétérocyclique aliphatique à 3 à 14 chaînons monovalent, un aryle en C₆₋₁₄ et un résidu hétérocyclique aromatique à 5 à 14 chaînons monovalent ;
les R^{g} à chaque occurrence sont choisis indépendamment les uns des autres dans le groupe constitué par =O, =C(CN)₂, un radical -O-(alkylène en C₂₋₆)-O-, un halogène, -CN, -NO₂, -OH, un alcoxy en C₁₋₁₀, un radical -O-CH₂CH₂O-(alkyle en C₁₋₁₀), -O-COR¹⁰, un radical -S-(alkyle en C₁₋₁₀), -NH₂, -NHR¹⁰, -NR¹⁰R¹¹, -NH-COR¹⁰, -COOH, -COOR¹⁰, -CONH₂, -CONHR¹⁰, -CONR¹⁰R¹¹, -CO-H, -COR¹⁰, un alkyle en C₁₋₁₀, un alcényle en C₂₋₁₀, un alcynyle en C₂₋₁₀, un aryle en C₆₋₁₄ et un résidu hétérocyclique aromatique à 5 à 14 chaînons monovalent,
dans lesquels R¹⁰ et R¹¹ à chaque occurrence sont choisis indépendamment l'un de l'autre dans le groupe constitué par un alkyle en C₁₋₁₀, un alcényle en C₂₋₁₀, un alcynyle en C₂₋₁₀, un cycloalkyle en C₃₋₁₀, un cycloalcényle en C₅₋₁₀, un résidu hétérocyclique aliphatique à 3 à 14 chaînons monovalent, un aryle en C₆₋₁₄ et un résidu hétérocyclique aromatique à 5 à 14 chaînons monovalent,
ou bien
G¹ et G² représentent indépendamment l'un de l'autre 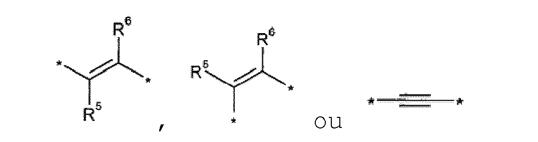 dans lesquels
R⁵ et R⁶ représentent indépendamment l'un de l'autre H ou un alkyle en C₁₋₃₀,
L représente un arylène en C₆₋₂₄ éventuellement substitué par 1 à 6 substituants R^{b} ou un résidu hétérocyclique aromatique à 5 à 24 chaînons divalent éventuellement substitué par 1 à 6 substituants R^{b},
dans lesquels
les R^{b} à chaque occurrence sont choisis indépendamment les uns des autres dans le groupe constitué par =O, =C(CN)₂, un radical -O-(alkylène en C₂₋₆)-O-, un halogène, -CN, -NO₂, -OH, un alcoxy en C₁₋₃₀, un radical -O-CH₂CH₂O-(alkyle en C₁₋₃₀), -O-COR¹², un radical -S-(alkyle en C₁₋₃₀), -NH₂, -NHR¹², -NR¹²R¹³, -NH-COR¹², -COOH, -COOR¹², -CONH₂, -CONHR¹², -CONR¹²R¹³, -CO-H, -COR¹², un alkyle en C₁₋₃₀ éventuellement substitué par 1 à 6 substituants R^{h}, un alcényle en C₂₋₃₀ éventuellement substitué par 1 à 6 substituants R^{h}, un alcynyle en C₂₋₃₀ éventuellement substitué par 1 à 6 substituants R^{h}, un cycloalkyle en C₃₋₁₀ éventuellement substitué par 1 à 6 substituants Rⁱ, un cycloalcényle en C₅₋₁₀ éventuellement substitué par 1 à 6 substituants Rⁱ et un résidu hétérocyclique aliphatique à 3 à 14 chaînons monovalent éventuellement substitué par 1 à 6 substituants Rⁱ,
dans lesquels
R¹² et R¹³ à chaque occurrence sont choisis indépendamment l'un de l'autre dans le groupe constitué par un alkyle en C₁₋₃₀, un alcényle en C₂₋₃₀, un alcynyle en C₂₋₃₀,un cycloalkyle en C₃₋₁₀, un cycloalcényle en C₅₋₁₀, un résidu hétérocyclique aliphatique à 3 à 14 chaînons monovalent, un aryle en C₆₋₁₄ et un résidu hétérocyclique aromatique à 5 à 14 chaînons monovalent ;
les R^{h} à chaque occurrence sont choisis indépendamment les uns des autres dans le groupe constitué par =O, =C(CN)₂, un radical -O-(alkylène en C₂₋₆)-O-, un halogène, -CN, -NO₂, -OH, un alcoxy en C₁₋₁₀, un radical -O-CH₂CH₂O-(alkyle en C₁₋₁₀), -O-COR¹⁴, un radical -S-(alkyle en C₁₋₁₀), -NH₂, -NHR¹⁴, -NR¹⁴R¹⁵, -NH-COR¹⁴, -COOH, -COOR¹⁴, -CONH₂, -CONHR¹⁴, -CONR¹⁴R¹⁵, -CO-H, -COR¹⁴, un cycloalkyle en C₃₋₁₀, un résidu hétérocyclique aliphatique à 3 à 14 chaînons monovalent, un aryle en C₆₋₁₄ et un résidu hétérocyclique aromatique à 5 à 14 chaînons monovalent ;
les Rⁱ à chaque occurrence sont choisis indépendamment les uns des autres dans le groupe constitué par =O, =C(CN)₂, un radical -O-(alkylène en C₂₋₆)-O-, un halogène, -CN, -NO₂, -OH, un alcoxy en C₁₋₁₀, un radical -O-CH₂CH₂O-(alkyle en C₁₋₁₀), -O-COR¹⁴, un radical -S-(alkyle en C₁₋₁₀), -NH₂, -NHR¹⁴, -NR¹⁴R¹⁵, -NH-COR¹⁴, -COOH, -COOR¹⁴, -CONH₂, -CONHR¹⁴, -CONR¹⁴R¹⁵, -CO-H, -COR¹⁴, un alkyle en C₁₋₁₀, un alcényle en C₂₋₁₀, un alcynyle en C₂₋₁₀, un aryle en C₆₋₁₄ et un résidu hétérocyclique aromatique à 5 à 14 chaînons monovalent,
dans lesquels R¹⁴ et R¹⁵ à chaque occurrence sont choisis indépendamment l'un de l'autre dans le groupe constitué par un alkyle en C₁₋₁₀, un alcényle en C₂₋₁₀, un alcynyle en C₂₋₁₀, un cycloalkyle en C₃₋₁₀, un cycloalcényle en C₅₋₁₀, un résidu hétérocyclique aliphatique à 3 à 14 chaînons monovalent, un aryle en C₆₋₁₄ et un résidu hétérocyclique aromatique à 5 à 14 chaînons monovalent,
ou bien
L représente 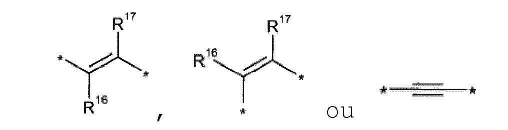 dans lesquels
R¹⁶ et R¹⁷ représentent indépendamment l'un de l'autre H, un alkyle en C₁₋₃₀, -CN ou un halogène,
q et s valent indépendamment l'un de l'autre 0, 1, 2, 3, 4 ou 5,
r vaut 0, 1 ou 2,
et
n est un entier de 2 à 10 000.

2. Polymère selon la revendication 1, dans lequel R¹ et R² représentent indépendamment l'un de l'autre H, un alkyle en C₁₋₃₀ éventuellement substitué par 1 à 6 substituants R^{c}, un alcényle en C₂₋₃₀ éventuellement substitué par 1 à 6 substituants R^{c}, un alcynyle en C₂₋₃₀ éventuellement substitué par 1 à 6 substituants R^{c}, un cycloalkyle en C₃₋₁₀ éventuellement substitué par 1 à 6 substituants R^{d}, un cycloalcényle en C₅₋₁₀ ou un aryle en C₆₋₁₄ éventuellement substitué par 1 à 6 substituants R^{e},
dans lesquels
les R^{c} à chaque occurrence sont choisis indépendamment les uns des autres dans le groupe constitué par =O, =C(CN)₂, un radical -O-(alkylène en C₂₋₆)-O-, un halogène, -CN, -NO₂, -OH, un alcoxy en C₁₋₁₀, un radical -O-CH₂CH₂O-(alkyle en C₁₋₁₀), -O-COR³, un radical -S-(alkyle en C₁₋₁₀), -NH₂, -NHR³, -NR³R⁴, -NH-COR³, -COOH, -COOR³, -CONH₂, -CONHR³, -CONR³R⁴, -CO-H, -COR³, un cycloalkyle en C₃₋₁₀, un résidu hétérocyclique aliphatique à 3 à 14 chaînons monovalent, un aryle en C₆₋₁₄ et un résidu hétérocyclique aromatique à 5 à 14 chaînons monovalent ;
les R^{d} à chaque occurrence sont choisis indépendamment les uns des autres dans le groupe constitué par =O, =C(CN)₂, un radical -O-(alkylène en C₂₋₆)-O-, un halogène, -CN, -NO₂, -OH, un alcoxy en C₁₋₁₀, un radical -O-CH₂CH₂O-(alkyle en C₁₋₁₀), -O-COR³, un radical -S-(alkyle en C₁₋₁₀), -NH₂, -NHR³, -NR³R⁴, -NH-COR³, -COOH, -COOR³, -CONH₂, -CONHR³, -CONR³R⁴, -CO-H, -COR³, un alkyle en C₁₋₁₀, un alcényle en C₂₋₁₀, un alcynyle en C₂₋₁₀, un aryle en C₆₋₁₄ et un résidu hétérocyclique aromatique à 5 à 14 chaînons monovalent ;
les R^{e} à chaque occurrence sont choisis indépendamment les uns des autres dans le groupe constitué par =O, =C(CN)₂, un radical -O-(alkylène en C₂₋₆)-O-, un halogène, -CN, -NO₂, -OH, un alcoxy en C₁₋₁₀, un radical -O-CH₂CH₂O-(alkyle en C₁₋₁₀), -O-COR³, un radical -S-(alkyle en C₁₋₁₀), -NH₂, -NHR³, -NR³R⁴, -NH-COR³, -COOH, -COOR³, -CONH₂, -CONHR³, -CONR³R⁴, -CO-H, -COR³, un alkyle en C₁₋₁₀, un alcényle en C₂₋₁₀, un alcynyle en C₂₋₁₀, un cycloalkyle en C₃₋₁₀, un cycloalcényle en C₅₋₁₀ et un résidu hétérocyclique aliphatique à 3 à 14 chaînons monovalent,
dans lesquels R³ et R⁴ à chaque occurrence sont choisis indépendamment l'un de l'autre dans le groupe constitué par un alkyle en C₁₋₁₀, un alcényle en C₂₋₁₀, un alcynyle en C₂₋₁₀, un cycloalkyle en C₃₋₁₀, un cycloalcényle en C₅₋₁₀, un résidu hétérocyclique aliphatique à 3 à 14 chaînons monovalent, un aryle en C₆₋₁₄ et un résidu hétérocyclique aromatique à 5 à 14 chaînons monovalent.

3. Polymère selon la revendication 1, dans lequel R¹ et R² représentent indépendamment l'un de l'autre un alkyle en C₁₋₃₀ éventuellement substitué par 1 à 6 substituants R^{c},
dans lesquels
les R^{c} à chaque occurrence sont choisis indépendamment les uns des autres dans le groupe constitué par =O, =C(CN)₂, un radical -O-(alkylène en C₂₋₆)-O-, un halogène, -CN, -NO₂, -OH, un alcoxy en C₁₋₁₀, un radical -O-CH₂CH₂O-(alkyle en C₁₋₁₀), -O-COR³, un radical -S-(alkyle en C₁₋₁₀), -NH₂, -NHR³, -NR³R⁴, -NH-COR³, -COOH, -COOR³, -CONH₂, -CONHR³, -CONR³R⁴, -CO-H, -COR³, un cycloalkyle en C₃₋₁₀, un résidu hétérocyclique aliphatique à 3 à 14 chaînons monovalent, un aryle en C₆₋₁₄ et un résidu hétérocyclique aromatique à 5 à 14 chaînons monovalent,
dans lesquels R³ et R⁴ à chaque occurrence sont choisis indépendamment l'un de l'autre dans le groupe constitué par un alkyle en C₁₋₁₀, un alcényle en C₂₋₁₀, un alcynyle en C₂₋₁₀, un cycloalkyle en C₃₋₁₀, un cycloalcényle en C₅₋₁₀, un résidu hétérocyclique aliphatique à 3 à 14 chaînons monovalent, un aryle en C₆₋₁₄ et un résidu hétérocyclique aromatique à 5 à 14 chaînons monovalent.

4. Polymère selon la revendication 1, dans lequel
R¹ et R² représentent indépendamment l'un de l'autre un alkyle en C₁₋₁₆, mieux un alkyle en C₁₋₁₂.

5. Polymère selon l'une quelconque des revendications 1 à 4, dans lequel
G¹ et G² représentent indépendamment l'un de l'autre un résidu hétérocyclique aromatique à 5 à 14 chaînons divalent éventuellement substitué par 1 à 6 substituants R^{a},
dans lequel
les R^{a} à chaque occurrence sont choisis indépendamment les uns des autres dans le groupe constitué par =O, =C(CN)₂, un radical -O-(alkylène en C₂₋₆)-O-, un halogène, -CN, -NO₂, -OH, un alcoxy en C₁₋₃₀, un radical -O-CH₂CH₂O-(alkyle en C₁₋₃₀), -O-COR⁸, un radical -S-(alkyle en C₁₋₃₀), -NH₂, -NHR⁸, -NR⁸R⁹, -NH-COR⁸, -COOH, -COOR⁸, -CONH₂, -CONHR⁸, -CONR⁸R⁹, -CO-H, -COR⁸, un alkyle en C₁₋₃₀ éventuellement substitué par 1 à 6 substituants R^{f}, un alcényle en C₂₋₃₀ éventuellement substitué par 1 à 6 substituants R^{f}, un alcynyle en C₂₋₃₀ éventuellement substitué par 1 à 6 substituants R^{f}, un cycloalkyle en C₃₋₁₀ éventuellement substitué par 1 à 6 substituants R^{g}, un cycloalcényle en C₅₋₁₀ éventuellement substitué par 1 à 6 substituants R^{g} et un résidu hétérocyclique aliphatique à 3 à 14 chaînons monovalent éventuellement substitué par 1 à 6 substituants R^{g},
dans lesquels
R⁸ et R⁹ à chaque occurrence sont choisis indépendamment l'un de l'autre dans le groupe constitué par un alkyle en C₁₋₃₀, un alcényle en C₂₋₃₀, un alcynyle en C₂₋₃₀,un cycloalkyle en C₃₋₁₀, un cycloalcényle en C₅₋₁₀, un résidu hétérocyclique aliphatique à 3 à 14 chaînons monovalent, un aryle en C₆₋₁₄ et un résidu hétérocyclique aromatique à 5 à 14 chaînons monovalent ;
les R^{f} à chaque occurrence sont choisis indépendamment les uns des autres dans le groupe constitué par =O, =C(CN)₂, un radical -O-(alkylène en C₂₋₆)-O-, un halogène, -CN, -NO₂, -OH, un alcoxy en C₁₋₁₀, un radical -O-CH₂CH₂O-(alkyle en C₁₋₁₀), -O-COR¹⁰, un radical -S-(alkyle en C₁₋₁₀), -NH₂, -NHR¹⁰, -NR¹⁰R¹¹, -NH-COR¹⁰, -COOH, -COOR¹⁰, -CONH₂, -CONHR¹⁰, -CONR¹⁰R¹¹, -CO-H, -COR¹⁰, un cycloalkyle en C₃₋₁₀, un résidu hétérocyclique aliphatique à 3 à 14 chaînons monovalent, un aryle en C₆₋₁₄ et un résidu hétérocyclique aromatique à 5 à 14 chaînons monovalent ;
les R^{g} à chaque occurrence sont choisis indépendamment les uns des autres dans le groupe constitué par =O, =C(CN)₂, un radical -O-(alkylène en C₂₋₆)-O-, un halogène, -CN, -NO₂, -OH, un alcoxy en C₁₋₁₀, un radical -O-CH₂CH₂O-(alkyle en C₁₋₁₀), -O-COR¹⁰, un radical -S-(alkyle en C₁₋₁₀), -NH₂, -NHR¹⁰, -NR¹⁰R¹¹, -NH-COR¹⁰, -COOH, -COOR¹⁰, -CONH₂, -CONHR¹⁰, -CONR¹⁰R¹¹, -CO-H, -COR¹⁰, un alkyle en C₁₋₁₀, un alcényle en C₂₋₁₀, un alcynyle en C₂₋₁₀, un aryle en C₆₋₁₄ et un résidu hétérocyclique aromatique à 5 à 14 chaînons monovalent,
dans lesquels R¹⁰ et R¹¹ à chaque occurrence sont choisis indépendamment l'un de l'autre dans le groupe constitué par un alkyle en C₁₋₁₀, un alcényle en C₂₋₁₀, un alcynyle en C₂₋₁₀, un cycloalkyle en C₃₋₁₀, un cycloalcényle en C₅₋₁₀, un résidu hétérocyclique aliphatique à 3 à 14 chaînons monovalent, un aryle en C₆₋₁₄ et un résidu hétérocyclique aromatique à 5 à 14 chaînons monovalent,
ou bien
G¹ et G² représentent indépendamment l'un de l'autre 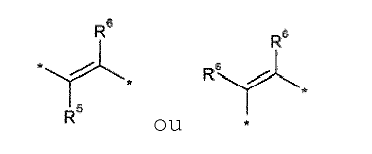 dans lesquels
R⁵ et R⁶ représentent indépendamment l'un de l'autre H ou un alkyle en C₁₋₃₀.

6. Polymère selon l'une quelconque des revendications 1 à 4, dans lequel
G¹ et G² représentent indépendamment l'un de l'autre un résidu hétérocyclique aromatique à 5 à 8 chaînons divalent monocyclique éventuellement substitué par 1 à 4 substituants R^{a},
dans lequel
les R^{a} à chaque occurrence représentent indépendamment les uns des autres un alkyle en C₁₋₃₀ éventuellement substitué par 1 à 4 substituants R^{f},
dans lequel
les R^{f} à chaque occurrence sont choisis indépendamment les uns des autres dans le groupe constitué par =O, =C(CN)₂, un radical -O-(alkylène en C₂₋₆)-O-, un halogène, -CN, -NO₂, -OH, un alcoxy en C₁₋₁₀, un radical -O-CH₂CH₂O-(alkyle en C₁₋₁₀), -O-COR¹⁰, un radical -S-(alkyle en C₁₋₁₀), -NH₂, -NHR¹⁰, -NR¹⁰R¹¹, -NH-COR¹⁰, -COOH, -COOR¹⁰, -CONH₂, -CONHR¹⁰, -CONR¹⁰R¹¹, -CO-H, -COR¹⁰, un cycloalkyle en C₃₋₁₀, un résidu hétérocyclique aliphatique à 3 à 14 chaînons monovalent, un aryle en C₆₋₁₄ et un résidu hétérocyclique aromatique à 5 à 14 chaînons monovalent.

7. Polymère selon l'une quelconque des revendications 1 à 4, dans lequel
G¹ et G² représentent indépendamment l'un de l'autre un résidu hétérocyclique aromatique à 5 à 8 chaînons divalent monocyclique, G¹ et G² étant substitués par 1 à 2 substituants R^{a},
dans lequel
les R^{a} à chaque occurrence représentent indépendamment l'un des l'autre un alkyle en C₆₋₂₀.

8. Polymère selon l'une quelconque des revendications 1 à 7, dans lequel
L représente un résidu hétérocyclique aromatique à 5 à 24 chaînons divalent éventuellement substitué par 1 à 6 substituants R^{b},
dans lequel
les R^{b} à chaque occurrence sont choisis indépendamment les uns des autres dans le groupe constitué par =O, =C(CN)₂, un radical -O-(alkylène en C₂₋₆)-O-, un halogène, -CN, -NO₂, -OH, un alcoxy en C₁₋₃₀, un radical -O-CH₂CH₂O-(alkyle en C₁₋₃₀), -O-COR¹², un radical -S-(alkyle en C₁₋₃₀), -NH₂, -NHR¹², -NR¹²R¹³, -NH-COR¹², -COOH, -COOR¹², -CONH₂, -CONHR¹², -CONR¹²R¹³, -CO-H, -COR¹², un alkyle en C₁₋₃₀ éventuellement substitué par 1 à 6 substituants R^{h}, un alcényle en C₂₋₃₀ éventuellement substitué par 1 à 6 substituants R^{h}, un alcynyle en C₂₋₃₀ éventuellement substitué par 1 à 6 substituants R^{h}, un cycloalkyle en C₃₋₁₀ éventuellement substitué par 1 à 6 substituants Rⁱ, un cycloalcényle en C₅₋₁₀ éventuellement substitué par 1 à 6 substituants Rⁱ et un résidu hétérocyclique aliphatique à 3 à 14 chaînons monovalent éventuellement substitué par 1 à 6 substituants Rⁱ,
dans lesquels
R¹² et R¹³ à chaque occurrence sont choisis indépendamment l'un de l'autre dans le groupe constitué par un alkyle en C₁₋₃₀, un alcényle en C₂₋₃₀, un alcynyle en C₂₋₃₀,un cycloalkyle en C₃₋₁₀, un cycloalcényle en C₅₋₁₀, un résidu hétérocyclique aliphatique à 3 à 14 chaînons monovalent, un aryle en C₆₋₁₄ et un résidu hétérocyclique aromatique à 5 à 14 chaînons monovalent ;
les R^{h} à chaque occurrence sont choisis indépendamment les uns des autres dans le groupe constitué par =O, =C(CN)₂, un radical -O-(alkylène en C₂₋₆)-O-, un halogène, -CN, -NO₂, -OH, un alcoxy en C₁₋₁₀, un radical -O-CH₂CH₂O-(alkyle en C₁₋₁₀), -O-COR¹⁴, un radical -S-(alkyle en C₁₋₁₀), -NH₂, -NHR¹⁴, -NR¹⁴R¹⁵, -NH-COR¹⁴, -COOH, -COOR¹⁴, -CONH₂, -CONHR¹⁴, -CONR¹⁴R¹⁵, -CO-H, -COR¹⁴, un cycloalkyle en C₃₋₁₀, un résidu hétérocyclique aliphatique à 3 à 14 chaînons monovalent, un aryle en C₆₋₁₄ et un résidu hétérocyclique aromatique à 5 à 14 chaînons monovalent ;
les Rⁱ à chaque occurrence sont choisis indépendamment les uns des autres dans le groupe constitué par =O, =C(CN)₂, un radical -O-(alkylène en C₂₋₆)-O-, un halogène, -CN, -NO₂, -OH, un alcoxy en C₁₋₁₀, un radical -O-CH₂CH₂O-(alkyle en C₁₋₁₀), -O-COR¹⁴, un radical -S-(alkyle en C₁₋₁₀), -NH₂, -NHR¹⁴, -NR¹⁴R¹⁵, -NH-COR¹⁴, -COOH, -COOR¹⁴, -CONH₂, -CONHR¹⁴, -CONR¹⁴R¹⁵, -CO-H, -COR¹⁴, un alkyle en C₁₋₁₀, un alcényle en C₂₋₁₀, un alcynyle en C₂₋₁₀, un aryle en C₆₋₁₄ et un résidu hétérocyclique aromatique à 5 à 14 chaînons monovalent,
dans lesquels R¹⁴ et R¹⁵ à chaque occurrence sont choisis indépendamment l'un de l'autre dans le groupe constitué par un alkyle en C₁₋₁₀, un alcényle en C₂₋₁₀, un alcynyle en C₂₋₁₀, un cycloalkyle en C₃₋₁₀, un cycloalcényle en C₅₋₁₀, un résidu hétérocyclique aliphatique à 3 à 14 chaînons monovalent, un aryle en C₆₋₁₄ et un résidu hétérocyclique aromatique à 5 à 14 chaînons monovalent,
ou bien
L représente 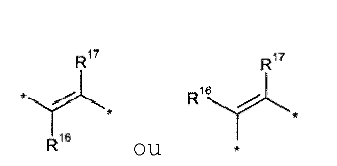 dans lesquels
R¹⁶ et R¹⁷ représentent indépendamment l'un de l'autre H, un alkyle en C₁₋₃₀, -CN ou un halogène.

9. Polymère selon l'une quelconque des revendications 1 à 7, dans lequel
L représente un résidu hétérocyclique aromatique à 5 à 14 chaînons divalent éventuellement substitué par 1 à 4 substituants R^{b},
dans lequel
les R^{b} à chaque occurrence représentent indépendamment les uns des autres un alkyle en C₁₋₃₀ éventuellement substitué par 1 à 4 substituants R^{h},
dans lequel
les R^{h} à chaque occurrence sont choisis indépendamment les uns des autres dans le groupe constitué par =O, =C(CN)₂, un radical -O-(alkylène en C₂₋₆)-O-, un halogène, -CN, -NO₂, -OH, un alcoxy en C₁₋₁₀, un radical -O-CH₂CH₂O-(alkyle en C₁₋₁₀), -O-COR¹⁴, un radical -S-(alkyle en C₁₋₁₀), -NH₂, -NHR¹⁴, -NR¹⁴R¹⁵, -NH-COR¹⁴, -COOH, -COOR¹⁴, -CONH₂, -CONHR¹⁴, -CONR¹⁴R¹⁵, -CO-H, -COR¹⁴, un cycloalkyle en C₃₋₁₀, un résidu hétérocyclique aliphatique à 3 à 14 chaînons monovalent, un aryle en C₆₋₁₄ et un résidu hétérocyclique aromatique à 5 à 14 chaînons monovalent.

10. Polymère selon l'une quelconque des revendications 1 à 7, dans lequel
L représente un résidu hétérocyclique aromatique à 5 à 14 chaînons divalent, L étant substitué par 1 à 2 substituants R^{b},
dans lequel
les R^{b} à chaque occurrence représentent indépendamment l'un de l'autre un alkyle en C₆₋₂₀.

11. Polymère selon l'une quelconque des revendications 1 à 10, dans lequel
q et s valent indépendamment l'un de l'autre 1, 2 ou 3,
r vaut 1 ou 2,
et
n est un entier de 5 à 10 000.

12. Polymère selon la revendication 11, dans lequel q et s valent tous deux 1,
r vaut 1,
et
n est un entier de 5 à 10 000.

13. Polymère selon la revendication 1, dans lequel le motif de formule (1) est un motif de formule 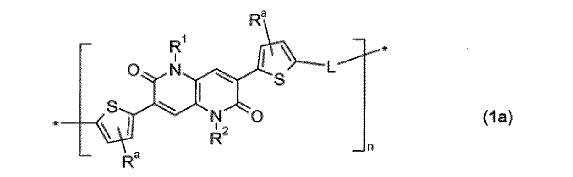 dans laquelle R¹, R², R^{a}, L et n sont tels que définis dans la revendication 1.

14. Polymère selon la revendication 13, dans lequel L représente 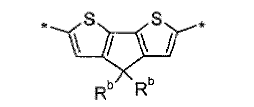 dans lequel R^{b} est tel que défini dans la revendication 1.

15. Polymère selon l'une quelconque des revendications 1 à 14, dans lequel n est un entier de 5 à 5000, de préférence de 5 à 1000, mieux de 5 à 100, et idéalement de 10 à 100.

16. Dispositif électronique comprenant le polymère de l'une quelconque des revendications 1 à 15.

17. Dispositif électronique selon la revendication 16, le dispositif électronique étant un transistor à effet de champ organique (OFET).

18. Dispositif électronique selon la revendication 16, le dispositif électronique étant un dispositif photovoltaïque organique (OPV).

19. Utilisation du polymère de l'une quelconque des revendications 1 à 15 comme matériau semi-conducteur.
